# EUROPEAN PATENT APPLICATION

(11) **EP 4 742 302 A1**
(43) Date of publication of application: **13.05.2026**
(21) Application number: 24835840.0
(22) Date of filing: 06.06.2024
(51) Int. Cl.: H01L 25/07, H01L 25/18, H01L 21/60

(54) **SEMICONDUCTOR DEVICE**

(30) Priority: 05.07.2023 JP 2023110768; 23.04.2024 JP 2024070077
(71) Applicant: DENSO CORPORATION, Kariya-city, Aichi 448-8661 (JP)
(72) Inventor: HIRANO, Takahiro, Kariya- city, Aichi 448-8661 (JP); KAMIYA, Masayuki, Kariya- city, Aichi 448-8661 (JP)
(74) Representative: Kuhnen & Wacker Patent- und Rechtsanwaltsbüro PartG mbB
(86) International application number: PCT/JP2024/020605
(87) International publication number: WO 2025/009321

(57) **Abstract**

A semiconductor device includes a semiconductor element (30L), a clip (50L) which is a metal plate, and a solder (81). The semiconductor element (30L) has a source electrode (32), a gate wiring (36) which is a signal line, and an insulating film (35). The gate wiring (36) is disposed at a position overlapping with an element region on one surface of a semiconductor substrate (34) and different from the source electrode (32). An upper element portion (354) of the insulating film (35) covers the gate wiring (36) and is interposed by the source electrode (32) in a plan view. The clip (50L) has a joint portion (51) to the source electrode (32). The solder (81) is interposed between the source electrode (32) and the joint portion (51). The joint portion (51) is disposed to avoid the gate wiring (36).

## Description

### CROSS-REFERENCE TO RELATED APPLICATIONS

This application is based on and claims the benefit of priority from Japanese Patent Application No. 2023-110768 filed on July 5, 2023 and Japanese Patent Application No. 2024-070077 filed on April 23, 2024, the entire contents of which are incorporated herein by reference.

### TECHNICAL FIELD

The present disclosure herein relates to a semiconductor device.

### BACKGROUND ART

Patent Literature 1 discloses a semiconductor device including a semiconductor element and a metal plate which is soldered and joined to a main electrode of the semiconductor element. Contents of the description of the prior art literature are incorporated herein by reference as a description of technical elements in this description.

### PRIOR ART LITERATURE

### PATENT LITERATURE

Patent Literature 1: JP 2022-130702 A

### SUMMARY OF INVENTION

As disclosed in Patent Literature 1, a signal line such as a gate liner can be disposed on an element region of a semiconductor substrate. The signal line is covered with an insulating film, and is insulated and separated from the main electrode. In the configuration of Patent Literature 1, there is a risk that solder may flow into a scratch or the like in the insulating film, causing leakage in the signal line, for example, gate leakage. In the above viewpoint and in other viewpoints not mentioned, further improvements are required for the semiconductor device.

An object of the disclosure is to provide a semiconductor device capable of suppressing leakage in a signal line.

According to an aspect of the disclosure, there is provided a semiconductor device including: at least one semiconductor element that includes a semiconductor substrate having an element region, a main electrode disposed at a position overlapping with the element region on one surface of the semiconductor substrate, a signal line disposed at a position overlapping with the element region on the one surface and being different from the position of the main electrode, and an insulating film covering the signal line and interposed by the main electrode in a plan view in a thickness direction of the semiconductor substrate; a metal plate having a joint portion to the main electrode; and a solder interposed between the main electrode and the joint portion and joining the main electrode and the metal plate, in which the joint portion is disposed to avoid the signal line.

With the disclosed semiconductor device, the joint portion of the metal plate is disposed to avoid the signal line. Therefore, it is possible to suppress the solder from flowing into a scratch in the insulating film covering the signal line. Therefore, leakage in the signal line can be suppressed.

A plurality of aspects disclosed in the description adopt different technical means to achieve respective objects. Reference numerals in parentheses in the claims and items exemplify the correspondence with portions of embodiments described later, and are not intended to limit the technical scope. Objects, features, and advantageous effects disclosed in this description will become more apparent with reference to the following detailed description and accompanying drawings.

### BRIEF DESCRIPTION OF DRAWINGS

FIG. 1 is a diagram illustrating a circuit configuration of a power conversion device to which a semiconductor device according to a first embodiment is applied.
FIG. 2 is a perspective view illustrating an example of a semiconductor module.
FIG. 3 is a plan view of the semiconductor module.
FIG. 4 is a cross-sectional view taken along a line IV-IV in FIG. 3.
FIG. 5 is a plan view illustrating an example of the semiconductor device.
FIG. 6 is a plan view illustrating a wiring pattern of a substrate.
FIG. 7 is a cross-sectional view taken along a line VII-VII in FIG. 5.
FIG. 8 is a cross-sectional view illustrating another example of the connection structure between a capacitor and the substrate.
FIG. 9 is a cross-sectional view illustrating still another example of the connection structure between the capacitor and the substrate.
FIG. 10 is a cross-sectional view illustrating still another example of the connection structure between the capacitor and the substrate.
FIG. 11 is a circuit diagram illustrating a verification model.
FIG. 12 is a diagram illustrating a verification result.
FIG. 13 is a diagram illustrating a temperature distribution.
FIG. 14 is a diagram illustrating disposition of a current path formed by a snubber circuit.
FIG. 15 is a plan view illustrating a modification example.
FIG. 16 is a plan view illustrating another modification example.
FIG. 17 is a plan view illustrating still another modification example.
FIG. 18 is a plan view illustrating a semiconductor element in a semiconductor device according to a second embodiment.
FIG. 19 is a cross-sectional view taken along a line XIX-XIX in FIG. 18.
FIG. 20 is a partial cross-sectional view of the semiconductor device and a semiconductor module.
FIG. 21 is a plan view illustrating an example of a connection structure between a clip and the semiconductor element.
FIG. 22 is a cross-sectional view taken along a line XXII-XXII in FIG. 21.
FIG. 23 is a plan view illustrating another example of the connection structure between the clip and the semiconductor element.
FIG. 24 is a perspective view illustrating the clip.
FIG. 25 is a plan view illustrating another example of the clip.
FIG. 26 is a plan view illustrating still another example of the clip.
FIG. 27 is a cross-sectional view illustrating still another example of the clip.
FIG. 28 is a plan view illustrating still another example of the clip.
FIG. 29 is a plan view illustrating still another example of the connection structure between the clip and the semiconductor element.
FIG. 30 is a cross-sectional view taken along a line XXX-XXX in FIG. 29.
FIG. 31 is a plan view illustrating still another example of the clip.
FIG. 32 is a plan view illustrating still another example of the clip.
FIG. 33 is a plan view illustrating still another example of the clip.
FIG. 34 is a plan view illustrating still another example of the clip.
FIG. 35 is a plan view illustrating still another example of the clip.
FIG. 36 is a plan view illustrating still another example of the clip.
FIG. 37 is a plan view illustrating still another example of the clip.
FIG. 38 is a plan view illustrating still another example of the clip.
FIG. 39 is a plan view illustrating still another example of the clip.
FIG. 40 is a plan view illustrating still another example of the clip.
FIG. 41 is a plan view illustrating an example of a semiconductor device according to a third embodiment.
FIG. 42 is a perspective view illustrating a periphery of an output terminal.
FIG. 43 is a diagram illustrating a positional relationship between the output terminal and a branch terminal.
FIG. 44 is a diagram illustrating the positional relationship between the output terminal and the branch terminal.
FIG. 45 is a diagram illustrating the positional relationship between the output terminal and the branch terminal.
FIG. 46 is a diagram illustrating the positional relationship between the output terminal and the branch terminal.
FIG. 47 is a diagram illustrating another example of the semiconductor device.
FIG. 48 is a diagram illustrating still another example of the semiconductor device.
FIG. 49 is a plan view illustrating an example of a semiconductor device according to a fourth embodiment.
FIG. 50 is a diagram illustrating a current path on an upper arm side.
FIG. 51 is a plan view illustrating an example of the substrate.
FIG. 52 is a diagram illustrating another example of the substrate.
FIG. 53 is a plan view illustrating an example of a semiconductor module according to a fifth embodiment.
FIG. 54 is a plan view illustrating a state in which a housing is removed from the semiconductor module.
FIG. 55 is a cross-sectional view taken along a line LV-LV in FIG. 53.
FIG. 56 is a cross-sectional view illustrating a periphery of a collar.
FIG. 57 is a diagram illustrating a relationship between a thickness of a sealing material and a thermal resistance.
FIG. 58 is a cross-sectional view illustrating a reference example of the semiconductor module.
FIG. 59 is a cross-sectional view taken along a line LIX-LIX in FIG. 53.
FIG. 60 is a cross-sectional view illustrating another example of the semiconductor module.
FIG. 61 is a cross-sectional view illustrating an example of a semiconductor module according to a sixth embodiment.
FIG. 62 is a plan view illustrating an example of the semiconductor device.
FIG. 63 is a cross-sectional view taken along a line LXIII-LXIII in FIG. 62.
FIG. 64 is a cross-sectional view illustrating warpage of a substrate in the semiconductor module.
FIG. 65 is a plan view illustrating still another example of the semiconductor module.
FIG. 66 is a diagram illustrating oscillation in a parallel circuit.
FIG. 67 is a plan view illustrating an example of a semiconductor device according to a seventh embodiment.
FIG. 68 is a diagram illustrating an equivalent circuit diagram of an upper and lower arm circuit provided by the semiconductor device.
FIG. 69 is a plan view illustrating another example of the semiconductor device.
FIG. 70 is a plan view illustrating still another example of the semiconductor device.
FIG. 71 is a plan view illustrating still another example of the semiconductor device.
FIG. 72 is a cross-sectional view taken along a line LXXII-LXXII in FIG. 71.
FIG. 73 is an enlarged view of a region LXXIII illustrated in FIG. 72.
FIG. 74 is a plan view illustrating still another example of the semiconductor device.
FIG. 75 is a plan view illustrating still another example of the semiconductor device.
FIG. 76 is a plan view illustrating still another example of the semiconductor device.
FIG. 77 is a plan view illustrating still another example of the semiconductor device.
FIG. 78 is a plan view illustrating still another example of the semiconductor device.
FIG. 79 is a plan view illustrating an example of a semiconductor device according to an eighth embodiment.
FIG. 80 is a plan view illustrating another example of the clip.
FIG. 81 is a plan view illustrating still another example of the clip.
FIG. 82 is a plan view illustrating an example of a semiconductor device according to a ninth embodiment.
FIG. 83 is a plan view illustrating another example of the clip.

### DESCRIPTION OF EMBODIMENTS

Hereinafter, a plurality of embodiments will be described with reference to the drawings. Duplicate descriptions may be omitted by designating corresponding elements by the same reference numerals in each embodiment. When only a part of a configuration is described in each embodiment, the configurations of the other embodiments described above can be applied to the other parts of the configuration. Not only the combinations of the configurations explicitly illustrated in the description of each embodiment, but also the configurations of a plurality of embodiments can be partially combined even when they are not explicitly illustrated when there is no problem in the combination in particular. The description of A and/or B means at least one of A or B. That is, it can include only A, only B, and both A and B.

A semiconductor device of a present embodiment and a semiconductor module including the semiconductor device are applied to, for example, a power conversion device of a mobile object that uses a rotating electric machine as a drive source. For example, the mobile object is an electric vehicle such as a battery electric vehicle (BEV), a hybrid electric vehicle (HEV), and a plug-in hybrid electric vehicle (PHEV), a flying object such as electric vertical take-off and landing aircraft and drones, ships, construction machinery, agricultural machinery, or the like. An example in which the present embodiment is applied to a vehicle will be described below.

### (First Embodiment)

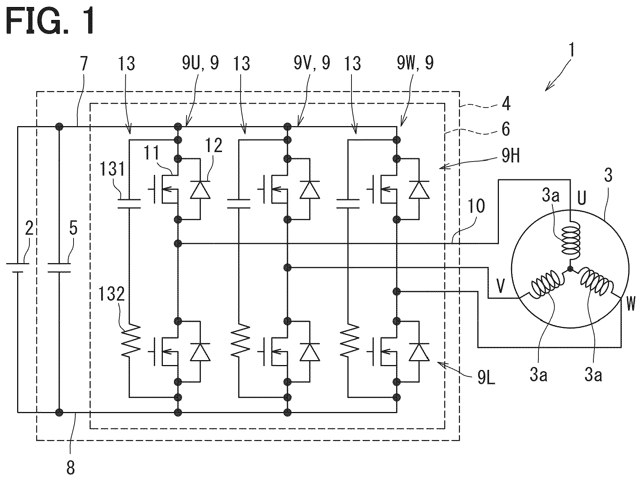

First, a schematic configuration of a vehicle drive system will be described with reference to FIG. 1.

### <Vehicle Drive System>

As illustrated in FIG. 1, a vehicle drive system 1 includes a DC power supply 2, a motor generator 3, and a power conversion device 4.

The DC power supply 2 is a DC voltage source configured with a chargeable and dischargeable secondary battery. The secondary battery is, for example, a lithium ion battery and a nickel-hydrogen battery. The motor generator 3 is a three-phase AC rotating electric machine. The motor generator 3 functions as a drive source for a vehicle, that is, as an electric motor. The motor generator 3 functions as a generator during regeneration. The power conversion device 4 performs power conversion between the DC power supply 2 and the motor generator 3.

### <Power Conversion Device>

Next, a circuit configuration of the power conversion device 4 will be described with reference to FIG. 1. The power conversion device 4 includes a power conversion circuit. The power conversion device 4 of the present embodiment includes a smoothing capacitor 5 and an inverter 6 which is the power conversion circuit.

The smoothing capacitor 5 mainly smooths a DC voltage supplied from the DC power supply 2. The smoothing capacitor 5 is connected to a P line 7, which is a power supply line on a high potential side, and an N line 8, which is a power supply line on a low potential side. The P line 7 is connected to a positive electrode of the DC power supply 2, and the N line 8 is connected to a negative electrode of the DC power supply 2. A positive electrode of the smoothing capacitor 5 is connected to the P line 7 between the DC power supply 2 and the inverter 6. A negative electrode of the smoothing capacitor 5 is connected to the N line 8 between the DC power supply 2 and the inverter 6. The smoothing capacitor 5 is connected in parallel to the DC power supply 2.

The inverter 6 is a DC-AC conversion circuit. The inverter 6 converts a DC voltage into a three-phase AC voltage under switching control by a control circuit (not illustrated), and outputs the three-phase AC voltage to the motor generator 3. Therefore, the motor generator 3 is driven to generate a predetermined torque. During regenerative braking of the vehicle, the inverter 6 converts the three-phase AC voltage generated by the motor generator 3 in response to a rotational force from wheels into a DC voltage under switching control by a control circuit, and outputs the DC voltage to the P line 7. In this manner, the inverter 6 performs bidirectional power conversion between the DC power supply 2 and the motor generator 3.

The inverter 6 is configured with upper and lower arm circuits 9 for three phases. The upper and lower arm circuit 9 may be referred to as a leg. The upper and lower arm circuit 9 has each of an upper arm 9H and a lower arm 9L. The upper arm 9H and the lower arm 9L are connected in series between the P line 7 and the N line 8, with the upper arm 9H on the P line 7 side.

A connection point between the upper arm 9H and the lower arm 9L is connected to a winding 3a of the corresponding phase in the motor generator 3 via an output line 10. Among the upper and lower arm circuits 9, a U-phase upper and lower arm circuit 9U is connected to a winding 3a of a U-phase via the corresponding output line 10. A V-phase upper and lower arm circuit 9V is connected to a winding 3a of a V-phase via the corresponding output line 10. A W-phase upper and lower arm circuit 9W is connected to a winding 3a of a W-phase via the corresponding output line 10. At least a portion of each of the P line 7, the N line 8, and the output line 10 is made of a conductive member, for example, a bus bar or the like.

The inverter 6 has six arms. Each arm is configured with a switching element. The number of switching elements forming each arm is not particularly limited. The number may be one or plural. When the plurality of switching elements are provided, driving of the plurality of switching elements connected in parallel to one another is turned on and off at the same timing by a common gate drive signal (drive voltage).

In the present embodiment, an n-channel MOSFET 11 is adopted as the switching element that forms each arm. The MOSFET is an abbreviation for a metal oxide semiconductor field effect transistor. In the upper arm 9H, a drain of the MOSFET 11 is connected to the P line 7. In the lower arm 9L, a source of the MOSFET 11 is connected to the N line 8. The source of the MOSFET 11 in the upper arm 9H and the drain of the MOSFET 11 in the lower arm 9L are connected to each other.

A freewheeling diode 12 is connected in anti-parallel to each of the MOSFETs 11. The diode 12 may be a parasitic diode (body diode) of the MOSFET 11, or may be provided separately from the parasitic diode. An anode of the diode 12 is connected to the source of the corresponding MOSFET 11, and a cathode is connected to the drain.

The switching element is not limited to the MOSFET 11. For example, an IGBT may be adopted. The IGBT is an abbreviation for an insulated gate bipolar transistor. When the IGBT is used, a freewheeling diode is also connected in anti-parallel.

The inverter 6 includes snubber circuits 13, in addition to the upper and lower arm circuits 9 described above. The snubber circuit 13 absorbs a transient high voltage that occurs during switching, that is, a switching surge. This allows for high-speed switching. The snubber circuits 13 may be provided individually for the upper and lower arm circuits 9, and connected in parallel to the corresponding upper and lower arm circuits 9. The snubber circuits 13 may be individually provided for the arms 9H and 9L, and connected in parallel to the corresponding arms 9H and 9L. As an example, the snubber circuit 13 in the present embodiment is connected in parallel to the upper and lower arm circuit 9.

The snubber circuit 13 includes at least a capacitor 131. The snubber circuit 13 may be, for example, a C snubber circuit having the capacitor 131, or an RC snubber circuit having the capacitor 131 and a resistor 132 as illustrated in FIG. 1. The snubber circuit 13 may also be an RCD snubber circuit having the capacitor 131, the resistor 132 and a diode.

The power conversion device 4 may further include a converter as a power conversion circuit. The converter is a DC-DC conversion circuit that converts a DC voltage into a DC voltage of a different value, for example. The converter is provided between the DC power supply 2 and the smoothing capacitor 5. The converter is configured with, for example, a reactor and an upper and lower arm circuits 9 as described above. This configuration allows the voltage to be increased or decreased. The power conversion device 4 may include a filter capacitor that removes a power supply noise from the DC power supply 2. The filter capacitor is provided between the DC power supply 2 and the converter.

The power conversion device 4 may include a drive circuit for a switching element that forms the inverter 6 and the like. The drive circuit supplies a drive voltage to a gate of the MOSFET 11 of the corresponding arm, based on a drive command from a control circuit. The drive circuit applies a drive voltage to the corresponding MOSFET 11 to drive the MOSFET 11, that is, to turn driving on or turn driving off. The drive circuit may be referred to as a driver.

The power conversion device 4 may include a control circuit for the switching element. The control circuit generates a drive command for operating the MOSFET 11, and outputs the drive command to the drive circuit. The control circuit generates a drive command based on, for example, a torque request input from a host ECU (not illustrated) and signals detected by various sensors. The ECU is an abbreviation for an electronic control unit.

The various sensors include, for example, a current sensor, a rotation angle sensor, and a voltage sensor. The current sensor detects a phase current flowing through the winding 3a of each phase. The rotation angle sensor detects a rotation angle of a rotor of the motor generator 3. The voltage sensor detects a voltage between both ends of the smoothing capacitor 5. The control circuit outputs, for example, a PWM signal as a drive command. The control circuit is configured with, for example, a processor and a memory. The PWM is an abbreviation for pulse width modulation.

### <Semiconductor Module>

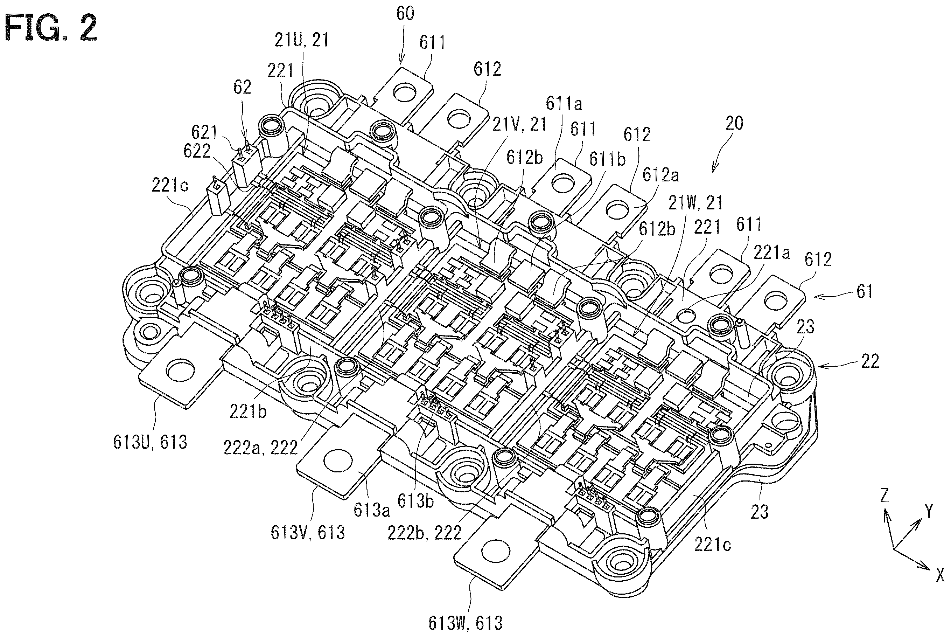

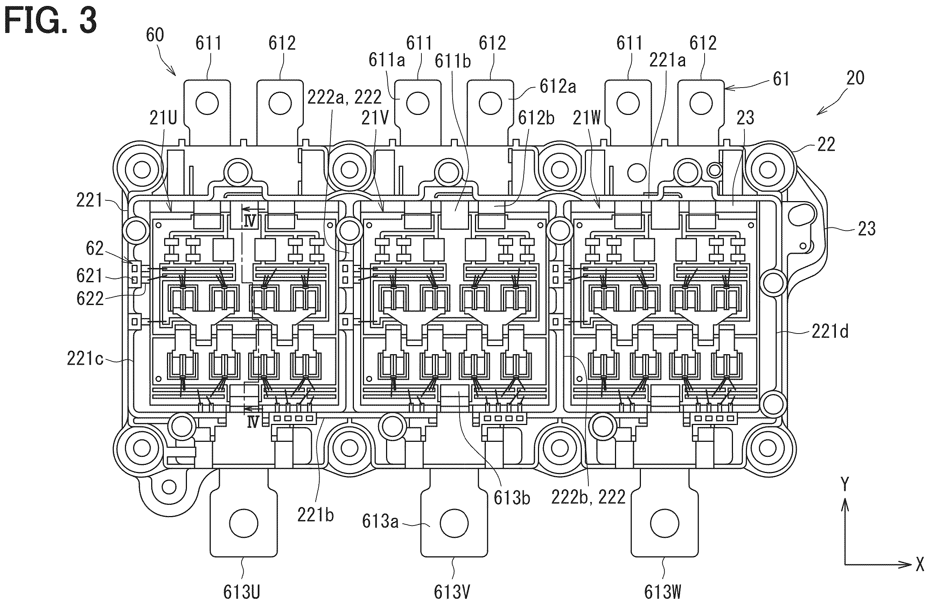

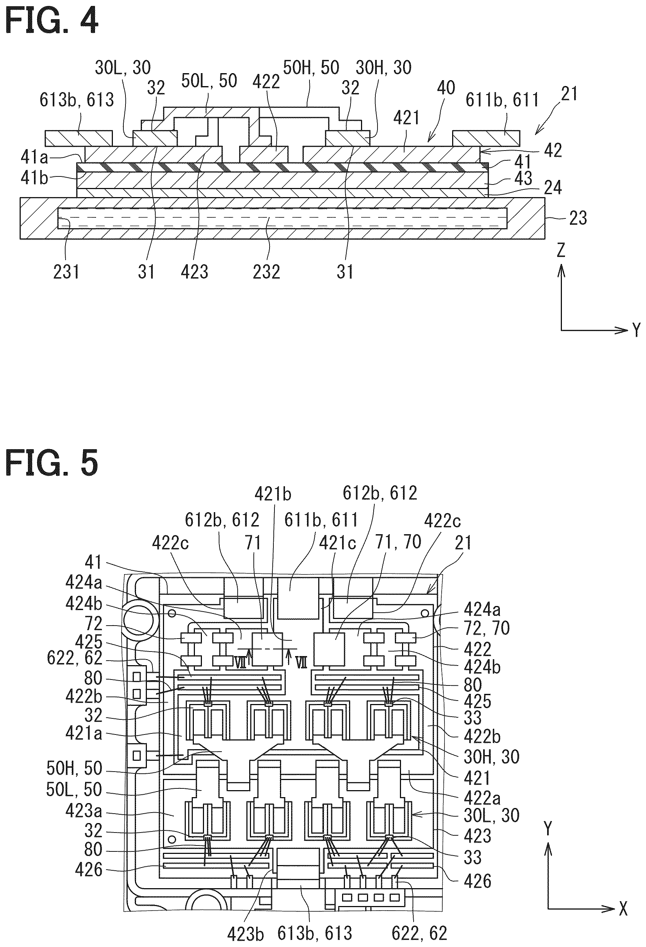

FIG. 2 is a perspective view illustrating an example of a semiconductor module. FIG. 3 is a top plan view of the semiconductor module illustrated in FIG. 2. FIG. 4 is a cross-sectional view taken along a line IV-IV in FIG. 3. FIG. 4 illustrates a simplified structure of the semiconductor module. In FIG. 4, a housing is omitted.

In the following description, a thickness direction of a substrate is defined as a Z direction, and a direction perpendicular to the Z direction is defined as a Y direction. A direction perpendicular to both the Z direction and the Y direction is defined as an X direction. Unless otherwise specified, a planar shape refers to a shape in a plan view from the Z direction, in other words, a shape along an XY plane defined by the X direction and the Y direction. The plan view from the Z direction may be simply referred to as a plan view.

As illustrated in FIG. 2, FIG. 3, and FIG. 4, a semiconductor module 20 may include semiconductor devices 21, a housing 22, and a cooler 23. The semiconductor module 20 forms the power conversion device 4, together with a capacitor device that provides the smoothing capacitor 5, an input terminal block, an output terminal block, and the like. The semiconductor module 20 may be housed in a case of the power conversion device 4, together with other elements such as a capacitor device.

The semiconductor device 21 is disposed on one surface of the cooler 23 in the Z direction. The semiconductor device 21 provides at least one arm of the inverter 6, which is a power conversion circuit. Each of the semiconductor devices 21 illustrated in FIG. 2 provides the upper and lower arm circuit 9 for one phase. The semiconductor module 20 includes three semiconductor devices 21 to provide the inverter 6. The three semiconductor devices 21 are disposed on the same surface of the cooler 23, and are aligned in the X direction. Each of the semiconductor devices 21 is fixed to the cooler 23.

A semiconductor device 21U, which is one of the semiconductor devices 21, provides a U-phase upper and lower arm circuit 9U. A semiconductor device 21V, which is another one of the semiconductor devices 21, provides a V-phase upper and lower arm circuit 9V. A semiconductor device 21W, which is still another one of the semiconductor devices 21, provides a W-phase upper and lower arm circuit 9W. That is, the semiconductor module 20 provides the inverter 6. The semiconductor device 21 will be described in detail later.

The housing 22 is formed of an electrically insulating material such as resin. The housing 22 may be, for example, a resin molded body. The housing 22 may hold a part of an element of the semiconductor device 21. The part of the element of the semiconductor device 21 may be integrally molded with the housing 22 as an insert component. The housing 22 may be fixed to the cooler 23. The housing 22 may be fixed to the case of the power conversion device 4, together with the cooler 23. The housing 22 may be disposed on one surface of the cooler 23 to provide a housing space for the semiconductor device 21 together with the cooler 23. A sealing body for sealing a semiconductor element 30 and the like may be disposed in the housing space formed by the housing 22 and the cooler 23. The sealing body is, for example, made of a gel or a potting resin.

As illustrated in FIGS. 2 and 3, the housing 22 may include a frame body 221 and a partition wall 222. The frame body 221 has a predetermined height in the Z direction and has a loop shape to surround the semiconductor device 21 in a plan view in the Z direction. The frame body 221 may be referred to as a loop-shaped wall portion. The frame body 221 may have a substantially rectangular loop shape. The rectangular loop-shaped frame body 221 has four wall portions 221a, 221b, 221c, and 221d.

The wall portions 221a and 221b extend in the X direction. The wall portion 221a and the wall portion 221b are disposed to face each other with a predetermined interval between the wall portion 221a and the wall portion 221b in the Y direction. The wall portion 221a is disposed on one end side of the semiconductor device 21 in the Y direction, and the wall portion 221b is disposed on the other end side of the semiconductor device 21 in the Y direction. The wall portions 221a and 221b each include a wall that defines a region and an extension portion that extends outward in the Y direction from the wall. The wall portions 221c and 221d extend in the Y direction. The wall portion 221c is continuous with the wall portions 221a and 221b on one end side in the X direction. The wall portion 221d is continuous with the wall portions 221a and 221b on the other end side in the X direction.

The partition wall 222 has a predetermined height in the Z direction and is continuous with the frame body 221. The partition wall 222 partitions a region defined by the frame body 221 into a plurality of regions. The partition wall 222 may partition the region into regions according to the number of semiconductor devices 21, for example. The partition wall 222 may be referred to as a compartment wall. The partition wall 222 may extend in a predetermined direction, and both ends thereof may be continuous with the frame body 221. As illustrated in FIGS. 2 and 3, the housing 22 may have two partition walls 222a and 222b as the partition walls 222. The partition walls 222a and 222b extend in the Y direction, in the same manner as the wall portions 221c and 221d. One end portion of each of the partition walls 222a and 222b is continuous with the wall portion 221a, and the other end portion is continuous with the wall portion 221b. The partition walls 222a and 222b and the wall portions 221c and 221d are aligned in the X direction at predetermined intervals therebetween. The partition walls 222 partition a facing region of the frame body 221 into three regions. The semiconductor device 21 is housed in each of the three partitioned regions.

The cooler 23 cools the semiconductor device 21. The cooler 23 is formed of a metal material such as aluminum or copper. As illustrated in FIG. 4, the cooler 23 having a flow path 231 therein may be adopted. The flow path 231 is provided to overlap with at least a part of the semiconductor device 21 in a plan view to effectively cool the semiconductor device 21. The flow path 231 may be provided to enclose most of each of the semiconductor devices 21 in a plan view.

A coolant 232 is supplied to the flow path 231 via an introduction pipe (not illustrated). The coolant 232 flowing through the flow path 231 is discharged to an outside of the cooler 23 via a discharge pipe (not illustrated). The coolant 232 may be a coolant that changes a phase, such as water or ammonia, or a coolant that does not change the phase, such as an ethylene glycol-based coolant.

The cooler 23 is not limited to the configuration having the flow path 231 described above. The cooler 23 may be a heat dissipation member, for example, a heat sink or the like. The heat sink may be referred to as a cooling plate. The heat dissipation member may include a heat dissipation fin. When insulation is not required, a bonding material may be disposed between the semiconductor device 21 and the cooler 23. In the example illustrated in FIG. 4, a bonding material 24 is interposed between the semiconductor device 21 and the cooler 23. As the bonding material 24, solder, sintered Ag, or the like can be adopted. The semiconductor module 20 includes the bonding material 24 disposed between the semiconductor device 21 and the cooler 23. The semiconductor device 21 is fixed to the cooler 23 by bonding. When insulation is required, an electrically insulating member may be disposed between the semiconductor device 21 and the cooler 23. As an insulating member, for example, a ceramic plate or a resin sheet can be adopted. In order to enhance thermal conductivity, a TIM such as silicone gel may be adopted. The TIM is an abbreviation for a thermal interface material.

The semiconductor module 20 may include a circuit substrate (not illustrated). The drive circuit described above is formed on the circuit substrate. The circuit substrate is disposed above the semiconductor device 21 in the Z direction. The semiconductor module 20 may include a cover that provides a housing, together with the housing 22 and the cooler 23. The cover is disposed on an opposite side of the semiconductor device 21 from the cooler 23. The cover may be disposed to cover the three semiconductor devices 21 integrally.

### <Semiconductor Device>

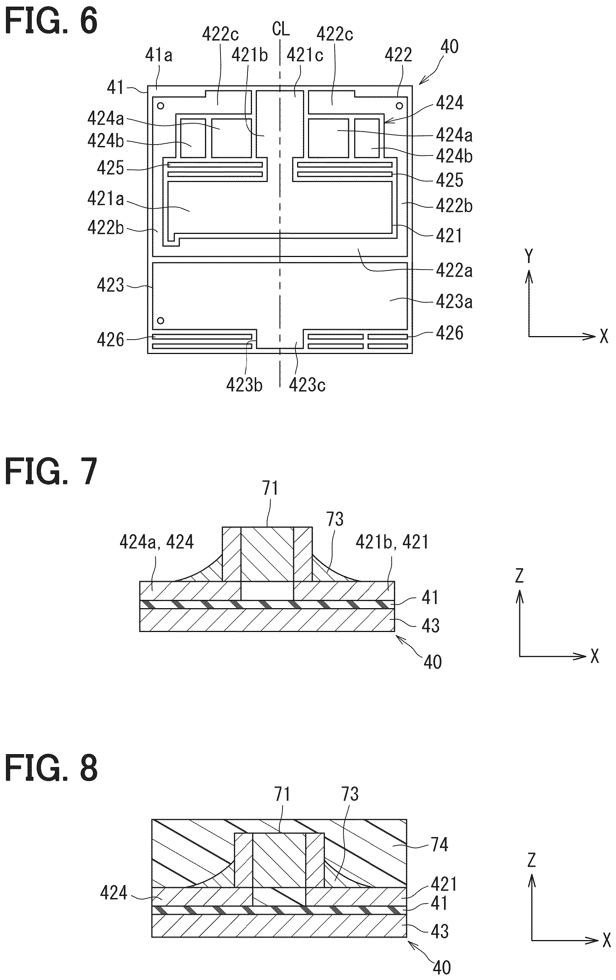

FIG. 5 is a top plan view illustrating an example of a semiconductor device. FIG. 5 is an enlarged view of one semiconductor device in FIG. 3. FIG. 5 also illustrates a portion of the housing. FIG. 6 is a plan view illustrating a wiring pattern of the substrate in the semiconductor device illustrated in FIG. 5.

As described above, the semiconductor device 21 may provide the upper and lower arm circuit 9 for one phase. As illustrated in FIG. 5, the semiconductor device 21 may include the semiconductor element 30, a substrate 40, a clip 50, an external connection terminal 60, and a snubber circuit 70.

The semiconductor element 30 is configured by forming a vertical element on a semiconductor substrate made of silicon (Si), a wide band-gap semiconductor having a wider bandgap than silicon, or the like. The wide band-gap semiconductor includes, for example, silicon carbide (SiC), gallium nitride (GaN), gallium oxide (Ga₂O₃), and diamond. The semiconductor element 30 may be referred to as a power element, a semiconductor chip, or the like.

The vertical element is configured such that a main current flows in a thickness direction of the semiconductor element 30 (semiconductor substrate). The semiconductor element 30 is disposed such that its thickness direction is substantially parallel to the Z direction. The semiconductor element 30 has main electrodes on both sides in the thickness direction. The semiconductor element 30 of the present embodiment is configured by forming the n-channel MOSFET 11 as the vertical element on a semiconductor substrate made of SiC. As illustrated in FIGS. 4 and 5, the semiconductor element 30 has, as main electrodes, a drain electrode 31 on a lower surface facing the substrate 40, and a source electrode 32 on an upper surface opposite the lower surface.

When the MOSFET 11 is turned on, a current (main current) flows between the main electrodes, that is, between the drain electrode 31 and the source electrode 32. When the diode 12 is a parasitic diode, the source electrode 32 also serves as an anode electrode, and the drain electrode 31 also serves as a cathode electrode. The diode 12 may be formed on a chip separate from the MOSFET 11. The drain electrode 31 is a main electrode on a high potential side, and the source electrode 32 is a main electrode on a low potential side. The drain electrode 31 is formed on almost the entire lower surface. The source electrode 32 is formed on a part of the upper surface.

The semiconductor element 30 has a substantially rectangular planar shape. The semiconductor element 30 has, on its upper surface, a pad 33 which is an electrode for a signal. The pad 33 is formed at a position on the upper surface different from a position of the source electrode 32. The pad 33 includes at least a gate pad.

A plurality of semiconductor elements 30 include a semiconductor element 30H that forms the upper arm 9H and a semiconductor element 30L that forms the lower arm 9L. The semiconductor element 30H may be referred to as an upper arm element. The semiconductor element 30L may be referred to as a lower arm element. For example, the semiconductor elements 30H and 30L may have a common configuration. In the present embodiment, the semiconductor element 30H corresponds to a first element, and the semiconductor element 30L corresponds to a second element.

The semiconductor elements 30H and 30L are aligned in the Y direction. The pad 33 of the semiconductor element 30H is provided in the vicinity of an end portion on a side of a P terminal 611 and an N terminal 612 in the Y direction. The pad 33 of the semiconductor element 30L is provided in the vicinity of an end portion on a side of an O terminal 613 in the Y direction. The pads 33 are located in the vicinity of outer end portions, rather than at inner end portions facing each other. The semiconductor elements 30H and 30L are disposed at substantially the same position in the Z direction. The semiconductor elements 30H and 30L are disposed in the same direction such that the drain electrodes 31 face the substrate 40 side.

The number of each of the semiconductor elements 30H and 30L is not particularly limited. The number of each of the semiconductor elements 30H and 30L may be one or plural. In the example illustrated in FIGS. 2, 3, and 5, the semiconductor element 30 includes the four semiconductor elements 30H and the four semiconductor elements 30L, respectively. The four semiconductor elements 30H are connected in parallel to provide the MOSFET 11 of the upper arm 9H for one phase. The four semiconductor elements 30L are connected in parallel to provide the MOSFET 11 of the lower arm 9L for one phase. The four semiconductor elements 30H are aligned in the X direction. The four semiconductor elements 30L are aligned in the X direction.

The substrate 40 encloses all of the plurality of semiconductor elements 30 (30H and 30L) in a plan view. The substrate 40 is disposed on the drain electrode 31 side of the semiconductor element 30. The substrate 40 is electrically connected to the drain electrode 31 as described later, and provides a wiring function. The substrate 40 may be referred to as a wiring substrate, a printed circuit board, or the like.

The substrate 40 has an insulating base material 41 and a conductor disposed at the insulating base material 41. The insulating base material 41 is formed of an electrically insulating material such as ceramic or resin. As illustrated in FIG. 4, the insulating base material 41 has one surface 41a that faces the semiconductor element 30 and a rear surface 41b that is an opposite surface to the one surface 41a in the Z direction. The substrate 40 may be provided separately for each of the semiconductor devices 21 or may be provided collectively for the semiconductor module 20.

The conductor is formed of a metal material with good electrical conductivity and good thermal conductivity, such as Cu or Al. The conductor may have a plating film of Ni, Au, or the like on its surface. The conductor may be disposed on only the one surface 41a of the insulating base material 41, or may be disposed on both the one surface 41a and the rear surface 41b. The conductor may be disposed inside the insulating base material 41. That is, the substrate 40 may be a single-sided substrate, a double-sided substrate, or a multilayer substrate having three or more layers of conductors. The conductor may include a via conductor. The via conductor is formed by disposing a conductor such as plating in a through hole (via) formed in an insulating layer that forms the insulating base material 41. The via conductor electrically connects conductors disposed on different layers.

The substrate 40 has a conductor 42 disposed on the one surface 41a. The conductor 42 is patterned. The patterned conductor 42 provides a wiring, that is, a circuit. The conductor 42 includes a P wiring 421, an N wiring 422, an O wiring 423, an interconnection wiring 424, and signal wirings 425 and 426. Each wiring is electrically separated at a predetermined interval (gap). The substrate 40 has a conductor 43 disposed on the rear surface 41b.

The P wiring 421 is connected to the drain electrode 31 of the semiconductor element 30H. The P wiring 421 is connected to the P terminal 611, which will be described later. The P wiring 421 electrically connects the drain electrode 31 of the semiconductor element 30H and the P terminal 611. The P wiring 421 may be referred to as a positive electrode wiring, a high-potential power supply wiring, or the like. In the present embodiment, the P wiring 421 corresponds to a first wiring.

The P wiring 421 has a base portion 421a and an extension portion 421b. The base portion 421a extends in an alignment direction of the semiconductor elements 30H, that is, in the X direction. The semiconductor elements 30H are disposed on the base portion 421a. The base portion 421a and the drain electrode 31 of the semiconductor element 30H are connected via a bonding material.

The extension portion 421b is continuous with the base portion 421a, and extends in the Y direction from the base portion 421a. The extension portion 421b is continuous with the vicinity of a center of the base portion 421a in a longitudinal direction. The extension portion 421b extends in a direction away from the semiconductor elements 30H. The P wiring 421 has a substantially T shape as a planar shape. The P wiring 421 is disposed substantially line-symmetrically with respect to a center line CL of the substrate 40 indicated by a two-dot chain line in FIG. 6. The center line CL is an imaginary straight line that bisects the substrate 40 in the X direction. The extension portion 421b of the substrate 40 has a terminal connection portion 421c at an end portion opposite to a coupling end with the base portion 421a. The P terminal 611 is connected to the terminal connection portion 421c. A capacitor 71 of the snubber circuit 70 is connected to a portion of the extension portion 421b between the coupling end with the base portion 421a and the terminal connection portion 421c.

The N wiring 422 is connected to the N terminal 612. The N wiring 422 is electrically connected to the source electrode 32 of the semiconductor element 30L via a clip 50L. The N wiring 422 electrically connects the source electrode 32 of the semiconductor element 30L and the N terminal 612. The N wiring 422 may be referred to as a negative electrode wiring, a low potential power supply wiring, or the like. The N wiring 422 corresponds to a second wiring.

The N wiring 422 has a base portion 422a and an extension portion 422b. The base portion 422a extends in the X direction. The base portion 422a is disposed adjacent to the base portion 421a of the P wiring 421 in the Y direction. The base portion 422a is disposed between the base portion 421a of the P wiring 421 and a base portion 423a of the O wiring 423. The base portion 422a extends from the vicinity of one end of the substrate 40 to the vicinity of the other end in the X direction. The clip 50L is connected to the base portion 422a.

The extension portion 422b is continuous with the base portion 422a, and extends from the base portion 422a substantially in the Y direction. The extension portion 422b extends in a direction away from the semiconductor elements 30L. The N wiring 422 has the two extension portions 422b. The extension portions 422b are continuous with both ends of the base portion 422a in the X direction. The vicinity of the tip of each extension portion 422b extends toward the terminal connection portion 421c of the P wiring 421. The N wiring 422 has a substantially C shape as a planar shape. The N wiring 422 is disposed substantially line-symmetrically with respect to the center line CL of the substrate 40.

Each of the extension portions 422b has a terminal connection portion 422c at an end portion opposite to a coupling end with the base portion 422a. The two terminal connection portions 422c are disposed adjacent to the terminal connection portion 421c. The two terminal connection portions 422c and one terminal connection portion 421c are aligned in the X direction. The two terminal connection portions 422c interpose the terminal connection portion 421c therebetween. The N terminal 612 is connected to the terminal connection portion 422c. A resistor 72 of the snubber circuit 70 is connected to a portion of the extension portion 422b between the coupling end with the base portion 422a and the terminal connection portion 422c. The resistor 72 is connected to the portion of the extension portion 422b, which extends in the Y direction.

The O wiring 423 is connected to the drain electrode 31 of the semiconductor element 30L. The O wiring 423 is connected to the O terminal 613, which will be described later. The O wiring 423 is electrically connected to the source electrode 32 of the semiconductor element 30H via a clip 50H. The O wiring 423 electrically connects the source electrode 32 of the semiconductor element 30H, the drain electrode 31 of the semiconductor element 30L, and the O terminal 613. The O wiring 423 may be referred to as an output wiring or the like.

The O wiring 423 has the base portion 423a and an extension portion 423b. The base portion 423a extends in the X direction. The base portion 423a is disposed adjacent to the base portion 422a of the N wiring 422 in the Y direction. The base portion 423a extends from the vicinity of one end of the substrate 40 to the vicinity of the other end in the X direction. The semiconductor element 30L is disposed at the base portion 423a. The base portion 423a and the drain electrode 31 of the semiconductor element 30L are connected via a bonding material. The clip 50H is connected to the base portion 423a.

The extension portion 423b is continuous with the base portion 423a, and extends in the Y direction from the base portion 423a. The extension portion 423b is continuous with the vicinity of a center of the base portion 423a in the longitudinal direction. The extension portion 423b extends in a direction away from the semiconductor elements 30H and 30L. The O wiring 423 has a substantially T shape as a planar shape. The O wiring 423 is disposed line-symmetrically with respect to the center line CL of the substrate 40. The extension portion 423b has a terminal connection portion 423c. The O terminal 613 is connected to the terminal connection portion 423c. In the Y direction, a length of the extension portion 423b is less than a length of the extension portion 421b. For example, an entire region of the extension portion 423b forms the terminal connection portion 423c.

The interconnection wiring 424 provides the snubber circuit 70, together with an electronic component, which will be described later. The interconnection wiring 424 electrically bridges the P wiring 421 and the N wiring 422, together with the electronic components of the snubber circuit 70. One interconnection wiring 424 may be provided in one current path of the snubber circuit 70 or a plurality of interconnection wirings 424 may be provided in one current path of the snubber circuit 70. The interconnection wiring 424 illustrated in FIGS. 5 and 6 has two interconnection wirings 424a and 424b in one current path. The interconnection wirings 424a and 424b are disposed between each of the two extension portions 422b and the extension portion 421b. The substrate 40 has two sets of the interconnection wiring 424a and 424b.

The interconnection wirings 424a and 424b are aligned in the X direction between the extension portion 421b of the P wiring 421 and the extension portion 422b of the N wiring 422. Both the interconnection wirings 424a and 424b have a substantially rectangular shape as a planar shape. The interconnection wiring 424a is disposed adjacent to the extension portion 421b, and the interconnection wiring 424b is disposed adjacent to the extension portion 422b. The interconnection wirings 424 are disposed line-symmetrically with respect to the center line CL of the substrate 40. The interconnection wirings 424a and 424b have substantially the same length in the Y direction. In the X direction, the length of the interconnection wiring 424a is more than the length of the interconnection wiring 424b. The capacitor 71 and the resistor 72 are connected to the interconnection wiring 424a. The resistor 72 is connected to the interconnection wiring 424b.

The signal wiring 425 electrically relays the pad 33 of the semiconductor element 30H to a corresponding signal terminal 62. The signal wiring 425 is connected to the pad 33 via a bonding wire 80. The signal wiring 425 is connected to the signal terminal 62 via a bonding wire 80. The signal wiring 425 extends in the X direction. The signal wiring 425 is disposed between the base portion 421a of the P wiring 421 and the interconnection wiring 424 in the Y direction. That is, the signal wiring 425 is disposed between the semiconductor element 30H and the snubber circuit 70. The signal wiring 425 is disposed between the extension portion 421b of the P wiring 421 and the extension portion 422b of the N wiring 422 in the X direction.

The signal wirings 425 are disposed between each of the two extension portions 422b and the extension portion 421b. The signal wirings 425 are disposed on both sides of the extension portion 421b in the X direction. The signal wirings 425 disposed on one side of the extension portion 421b are connected to the pads 33 of the two semiconductor elements 30H. The signal wirings 425 disposed on the other side of the extension portion 421b are connected to the pads 33 of the remaining two semiconductor elements 30H. The signal wirings 425 separated by the extension portion 421b may be electrically connected via a bonding wire. When the substrate 40 is a printed circuit board, among the signal wirings 425 separated by the extension portion 421b, the corresponding wirings may be electrically connected by a wiring inside the substrate (not illustrated). The number of signal wirings 425 is not particularly limited. The substrate 40 has the signal wirings 425 in a number corresponding to a type of signal and a division structure. The signal wirings 425 are disposed line-symmetrically with respect to the center line CL of the substrate 40.

The signal wiring 426 electrically relays the pad 33 of the semiconductor element 30L to the corresponding signal terminal 62. The signal wiring 426 is connected to the pad 33 via a bonding wire 80. The signal wiring 426 is connected to the signal terminal 62 via a bonding wire 80. The signal wiring 426 extends in the X direction. The signal wiring 426 is disposed between an end portion of the substrate 40 in the Y direction and the base portion 423a of the O wiring 423. The signal wiring 426 is disposed between each of the end portions of the substrate 40 in the X direction and the extension portion 423b of the O wiring 423. The signal wirings 426 are disposed on both sides of the extension portion 423b in the X direction.

The signal wirings 426 disposed on one side of the extension portion 423b are connected to the pads 33 of the two semiconductor elements 30L. The signal wirings 426 disposed on the other side of the extension portion 423b are connected to the pads 33 of the remaining two semiconductor elements 30L. The signal wirings 426 separated by the extension portion 423b may be electrically connected via a bonding wire. Among the signal wirings 426 separated by the extension portion 423b, the corresponding wirings may be electrically connected by a wiring inside the substrate (not illustrated). The signal terminals 62 corresponding to the separated signal wirings 426 may be integrally continuous with each other. The number of signal wirings 426 is not particularly limited. The substrate 40 has the signal wirings 426 in a number corresponding to the type of signal and the division structure.

The clip 50 may also be referred to as a bridge member, a relay member, a metal bridge, or the like. The clip 50 is a metal plate of which base material is a metal with good electrical conductivity, such as Cu or a Cu alloy, for example. The clip 50 may be formed by punching out a metal plate of a predetermined thickness and then pressing the metal plate. The clip 50 may be formed by using a profiled material with varying thicknesses in parts. The clip 50 may be made of a base material having a film applied to its surface by surface treatment. The surface of the clip 50 may be provided with a plating film of Ni, Au, or the like. The clip 50 may include a P-containing Ni plating film formed on a base material. The NiP film is formed by a non-electrolytic plating method. Instead of Cu, Ag, Au, Al, Mg, and the like may be used as the base material. As the film to be added to the base material, Sn, Ag, and the like may be used instead of Ni or Au.

The clip 50 includes the clip 50H connected to the semiconductor element 30H and the clip 50L connected to the semiconductor element 30L. The clip 50H electrically connects the source electrode 32 of the semiconductor element 30H and the base portion 423a of the O wiring 423. The clip 50H extends in the Y direction. The clip 50H may be provided individually for each semiconductor element 30H, or may be provided collectively for a plurality of semiconductor elements 30H. As illustrated in FIG. 5 and the like, one clip 50H may be provided for the two semiconductor elements 30H. The semiconductor device 21 includes the two clips 50H. Each of the clips 50H has a substantially Y shape as a planar shape.

The clip 50L electrically connects the source electrode 32 of the semiconductor element 30L and the base portion 422a of the N wiring 422. The clip 50L extends in the Y direction. The clip 50L may be provided individually for each semiconductor element 30L, or may be provided collectively for a plurality of semiconductor elements 30L. In the example illustrated in FIG. 5 and the like, the clips 50L are individually provided for the semiconductor elements 30L. The semiconductor device 21 includes the four clips 50L.

The external connection terminal 60 is a terminal for electrically connecting the semiconductor device 21 to an external device. The external connection terminal 60 is formed by using a metal material with good electrical conductivity, such as copper. The external connection terminal 60 is, for example, a plate material. The external connection terminal 60 includes a main terminal 61 and the signal terminal 62. The main terminal 61 is a terminal that is electrically connected to a main electrode of the semiconductor element 30. The signal terminal 62 is a terminal that is electrically connected to the pad 33 of the semiconductor element 30. The main terminal 61 includes the P terminal 611 and the N terminal 612 which are power supply terminals, and the O terminal 613.

The P terminal 611 is the external connection terminal 60 electrically connected to the P line 7 described above. The P terminal 611 is electrically connected to a positive electrode terminal of the smoothing capacitor 5. The P terminal 611 may be referred to as a positive electrode terminal, a high potential power supply terminal, or the like. The P terminal 611 is connected to the terminal connection portion 421c of the P wiring 421. The P terminal 611 is electrically connected to the drain electrode 31 of the semiconductor element 30H that forms the upper arm 9H, via the P wiring 421.

As illustrated in FIG. 2 and the like, the P terminal 611 has a connection portion 611a for connecting to an external device and a connection portion 611b for connecting to the substrate 40. The P terminal 611 extends generally in the Y direction. One end portion of the P terminal 611 in the Y direction forms the connection portion 611a, and the other end portion forms the connection portion 611b. In the example illustrated in FIG. 2 and the like, a portion of the P terminal 611 is held by the frame body 221 of the housing 22. The connection portion 611a of the P terminal 611 protrudes outward from the wall portion 221a of the frame body 221, and the connection portion 611b protrudes inward from the wall portion 221a, that is, toward a partition region side. The P terminal 611 has one connection portion 611a and one connection portion 611b. The connection portion 611b is connected to the terminal connection portion 421c of the P wiring 421. A capacitor device that provides the smoothing capacitor 5 is connected to the connection portion 611a via, for example, a bus bar or the like.

The N terminal 612 is the external connection terminal 60 electrically connected to the N line 8 described above. The N terminal 612 is electrically connected to a negative electrode terminal of the smoothing capacitor 5. The N terminal 612 may be referred to as a negative electrode terminal, a low potential power supply terminal, or the like. The N terminal 612 is connected to the terminal connection portion 422c of the N wiring 422. The N terminal 612 is electrically connected to the source electrode 32 of the semiconductor element 30L that forms the lower arm 9L, via the N wiring 422 and the clip 50L.

The N terminal 612 has a connection portion 612a for connecting to an external device and a connection portion 612b for connecting to the substrate 40. The N terminal 612 extends generally in the Y direction. One end portion of the N terminal 612 in the Y direction forms the connection portion 612a, and the other end portion forms the connection portion 612b. In the present embodiment, as an example, a portion of the N terminal 612 is held by the frame body 221 of the housing 22. The connection portion 612a of the N terminal 612 protrudes outward from the wall portion 221a of the frame body 221, and the connection portion 612b protrudes inward from the wall portion 221a. The N terminal 612 has one connection portion 612a and two connection portions 612b. One of the connection portions 612b is connected to one of the terminal connection portions 421c of the N wiring 422, and the other of the connection portions 612b is connected to the other of the terminal connection portions 421c. The smoothing capacitor 5 is connected to the connection portion 612a via, for example, a bus bar or the like.

The O terminal 613 is the external connection terminal 60 electrically connected to the output line 10 described above. The O terminal 613 is electrically connected to the winding 3a of the opposite phase of the motor generator 3. The O terminal 613 may be referred to as an output terminal, an AC terminal, or the like. The semiconductor module 20 includes, as the O terminals 613, a U-phase O terminal 613U, a V-phase O terminal 613V, and a W-phase O terminal 613W.

The O terminal 613 is connected to the terminal connection portion 423c of the O wiring 423. The O terminal 613 is electrically connected to the drain electrode 31 of the semiconductor element 30L that forms the lower arm 9L, via the O wiring 423. The O terminal 613 is electrically connected to the source electrode 32 of the semiconductor element 30H that forms the upper arm 9H, via the O wiring 423 and the clip 50H.

The O terminal 613 has a connection portion 613a for connecting to an external device and a connection portion 613b for connecting to the substrate 40. The O terminal 613 extends generally in the Y direction. One end portion of the O terminal 613 in the Y direction forms the connection portion 613a, and the other end portion forms the connection portion 613b. In the present embodiment, as an example, a portion of the O terminal 613 is held by the frame body 221 of the housing 22. The connection portion 613a of the O terminal 613 protrudes outward from the wall portion 221b of the frame body 221, and the connection portion 613b protrudes inward from the wall portion 221b. The O terminal 613 has one connection portion 613a and one connection portion 613b. The connection portion 613b is connected to the terminal connection portion 423c of the O wiring 423. The motor generator 3 is connected to the connection portion 613a via, for example, a bus bar or the like.

The signal terminal 62 electrically connects the semiconductor element 30 to a circuit substrate (not illustrated). The signal terminal 62 is electrically connected to the pad 33 of the semiconductor element 30, via a connection member such as the bonding wire 80. The number of signal terminals 62 is not particularly limited. The signal terminal 62 may include at least a terminal for applying a drive voltage to a gate electrode of the semiconductor element 30. The signal terminal 62 may include a terminal for detecting a source potential of the semiconductor element 30. The signal terminal 62 may include a terminal for detecting a drain potential of the semiconductor element 30. The signal terminal 62 may include terminals for detecting a temperature of the semiconductor element 30.

The signal terminal 62 has a connection portion 621 for connecting to the circuit substrate and a connection portion 622 for connecting to the signal wirings 425 and 426. One end portion of the signal terminal 62 in the extension direction forms the connection portion 621, and the other end portion forms the connection portion 622. In the example illustrated in FIG. 2 or the like, a portion of the signal terminal 62 is held by the wall portions 221b and 221c of the frame body 221 and the partition walls 222a and 222b. The signal terminal 62 on the upper arm 9H side is held by the frame body 221 and the partition wall 222. For example, the signal terminal 62 of the U-phase is held by the wall portion 221c of the frame body 221. The signal terminal 62 of the V-phase is held by the partition wall 222a, and the signal terminal 62 of the W-phase is held by the partition wall 222b. The signal terminal 62 of the lower arm 9L is held by the wall portion 221b of the frame body 221.

The connection portion 621 of the signal terminal 62 protrudes upward from an upper end of the housing 22. The connection portion 622 protrudes inward from the housing 22. Each signal terminal 62 has a bent portion. The signal terminal 62 has a substantially L shape, for example. The connection portion 622 of the upper arm 9H is connected to the corresponding signal wiring 425 via the bonding wire 80. The connection portion 622 of the lower arm 9L is connected to the corresponding signal wiring 426 via the bonding wire 80. The circuit substrate described above is connected to the connection portion 621 of the signal terminal 62.

The snubber circuit 70 includes at least the capacitor 71 as an electronic component. The snubber circuit 70 illustrated in FIG. 5 and the like is an RC snubber circuit. The snubber circuit 70 includes the capacitor 71 and a plurality of resistors 72. The snubber circuit 70 provides the snubber circuit 13 illustrated in FIG. 1. The capacitor 71 provides the capacitor 131, and the resistor 72 provides the resistor 132. As described above, the snubber circuit 70 is connected in parallel to the upper and lower arm circuit 9. The snubber circuit 70 electrically bridges the P wiring 421 and the N wiring 422. The snubber circuit 70 is configured with the interconnection wiring 424 (424a, 424b) described above, in addition to the capacitor 71 and the resistor 72.

The capacitor 71 is connected to the extension portion 421b of the P wiring 421 and the interconnection wiring 424a. The capacitor 71 electrically bridges the extension portion 421b and the interconnection wiring 424a. A part of the plurality of resistors 72 is connected to the interconnection wiring 424a and the interconnection wiring 424b. A part of the resistors 72 electrically bridges the interconnection wirings 424a and 424b. Another part of the resistors 72 is connected to the interconnection wiring 424b and the extension portion 422b of the N wiring 422. Another part of the resistors 72 electrically bridges the interconnection wiring 424b and the extension portion 422b.

### <Connection Structure between Capacitor and Substrate>

FIG. 7 is a cross-sectional view taken along a line VII-VII in FIG. 5. FIG. 7 illustrates an example of a connection structure between a capacitor that forms a snubber circuit and a substrate. Each of FIGS. 8, 9, and 10 illustrates another example of the connection structure between the capacitor and the substrate.

As illustrated in FIG. 7, the capacitor 71 may be mounted on the substrate 40 via a bonding material such as solder 73. Terminals of the capacitor 71 are joined to the P wiring 421 and the interconnection wiring 424.

As illustrated in FIG. 8, the capacitor 71 may be sealed by a sealing body 74. The sealing body 74 may seal only the capacitor 71 among the components mounted on the substrate 40, or may seal the capacitor 71 and other components integrally. The sealing body 74 is formed by using an electrically insulating material such as resin or gel, for example. The sealing body 74 has a higher thermal conductivity than an air. The sealing body 74 may contain a filler to increase thermal conductivity. The sealing body 74 is a thermal-conductive member that thermally connects the capacitor 71 to a portion of the substrate 40 other than a joint portion with the capacitor 71.

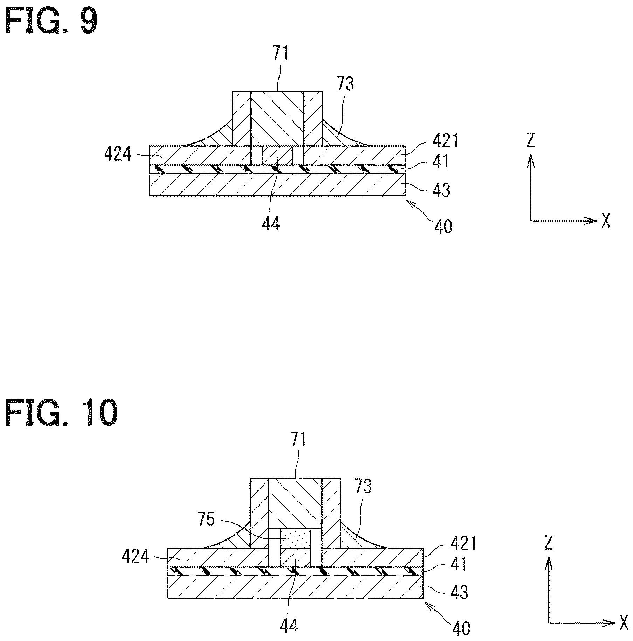

As illustrated in FIG. 9, a dummy wiring 44 may be provided at the substrate 40 such that heat from the capacitor 71 is released to the substrate 40 side through the dummy wiring 44. The dummy wiring 44 is disposed on the substrate 40 between the extension portion 421b of the P wiring 421 and the interconnection wiring 424 (424a). The dummy wiring 44 is electrically isolated from the other conductor 42 disposed on the one surface 41a of the insulating base material 41 and does not provide a wiring function. A bottom surface of a main body of the capacitor 71 is in contact with the dummy wiring 44. The dummy wiring 44 is a thermal-conductive member that thermally connects the capacitor 71 to a portion of the substrate 40 other than the joint portion with the capacitor 71.

As illustrated in FIG. 10, an adhesive 75 may be disposed between the capacitor 71 and the dummy wiring 44. The adhesive 75 may be made of a material with excellent thermal conductivity, for example, TIM. The adhesive 75 is a thermal-conductive member that is interposed between the capacitor 71 and the dummy wiring 44, and thermally connects the capacitor 71 to a portion of the substrate 40 other than the joint portion with the capacitor 71.

### <Capacitance of Capacitor>

A required capacitance C of the capacitor that forms the snubber circuit depends on a parasitic inductance Ldc of the main circuit outside the capacitor. Therefore, whether the required capacitance C can be defined by using C/Ldc as a parameter is investigated.

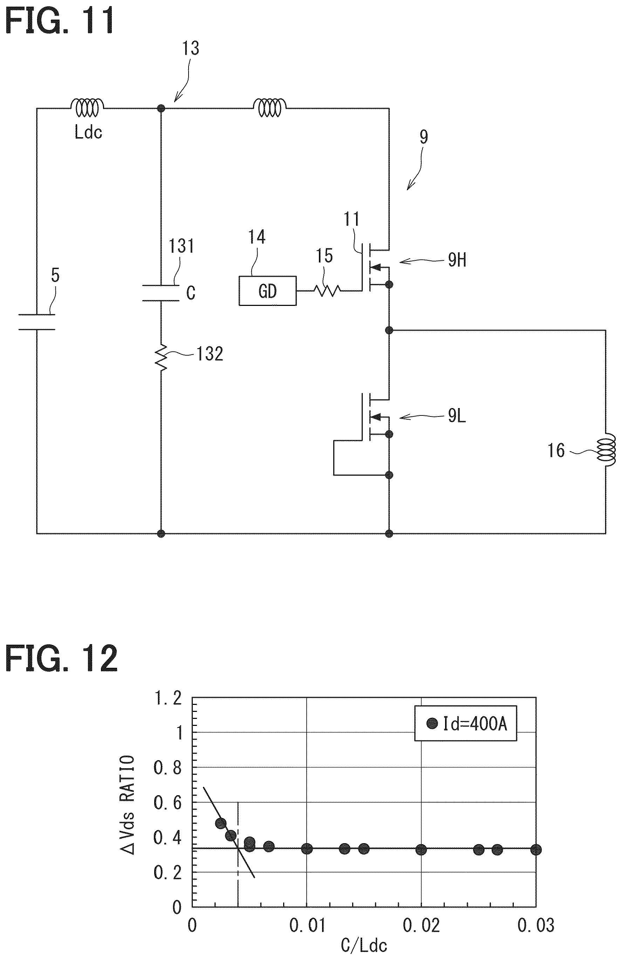

FIG. 11 is a circuit diagram illustrating a verification model. In FIG. 11, a capacitance of the capacitor 131 of the snubber circuit 13 is indicated as C. In the main circuit connecting the smoothing capacitor 5 and the upper and lower arm circuit 9 (MOSFET 11), a parasitic inductance of a portion connecting the smoothing capacitor 5 and the snubber circuit 13 is indicated as Ldc. The parasitic inductance Ldc is the parasitic inductance of the portion of the main circuit from the connection point of the snubber circuit 13 to the smoothing capacitor 5. An inductive load 16 is connected to a midpoint of the upper and lower arm circuit 9. The inductive load 16 may be referred to as an L load.

In the verification, a circuit constant is set as follows. In the main circuit, the parasitic inductance from the connection point of the snubber circuit 13 to the MOSFET 11 is set to 5 nH. A resistance value of the resistor 132 of the snubber circuit 13 is set to 0.1 Ω. A resistance value of a gate resistor 15 provided at the wiring connecting a gate driver (GD) 14 and the gate of the MOSFET 11 is set to 1 Ω. Vdd is set to 800 V, and a drain current Id flowing through the MOSFET 11 of the upper arm 9H is set to 400 A.

FIG. 12 is a diagram illustrating a verification result. In FIG. 12, a horizontal axis represents C/Ldc and a vertical axis represents a ΔVds ratio. The ΔVds ratio is a ratio of a voltage Vds at each value of C/Ldc to the voltage Vds when C/Ldc is 0 (zero). The voltage Vds is a drain-source voltage. As illustrated in FIG. 12, the ΔVds ratio is decreased as C/Ldc is increased. An intersection point of two imaginary lines illustrated in FIG. 12 corresponds to an inflection point. The intersection point is C/Ldc = 0.004. In a range in which C/Ldc exceeds 0.004, the ΔVds ratio converges (is saturated).

### <Summary of First Embodiment>

According to the semiconductor device 21 and the semiconductor module 20 of the present embodiment, the signal wiring 425 that electrically relays the signal terminal 62 and the semiconductor element 30 (30H) is provided by intentional wiring patterning of the substrate 40. The signal wiring 425 is disposed between the semiconductor element 30 and the snubber circuit 70 as illustrated in FIGS. 5 and 6. The capacitor 71 forming the snubber circuit 70 is spaced apart from the semiconductor element 30, by a size of the signal wiring 425. Therefore, it is possible to provide the snubber circuit 70 to enable high-speed switching while reducing the influence of heat from the semiconductor element 30 on the capacitor 71. The disposition of the signal wiring 425, which is the conductor 42, can suppress the heat received by the capacitor 71.

Since the heat received by the capacitor 71 can be suppressed, a margin up to the upper limit temperature of the heat resistance of the capacitor 71 is increased. Therefore, the size of the capacitor 71 can be reduced. In a configuration in which a plurality of capacitors 71 are provided and connected in parallel for heat resistance purposes, the number of capacitors 71 can be reduced by suppressing heat reception. As a result, the size of the semiconductor device 21 can be reduced. The manufacturing costs can be reduced.

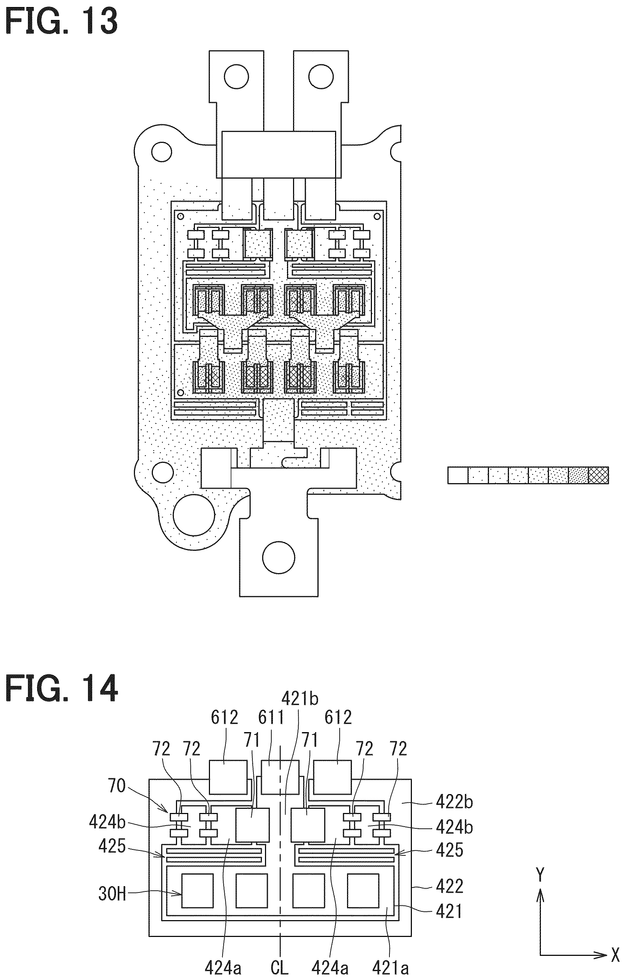

FIG. 13 illustrates simulation results illustrating a temperature distribution caused by heat generation from the semiconductor element 30. In FIG. 13, the temperature distribution is indicated by a density of dots. The higher the density is, the higher the temperature is, and the lower the density is, the lower the temperature is. It is clear from the simulation results illustrated in FIG. 13 that the temperature of the capacitor 71 that forms the snubber circuit 70 can be reduced by providing the signal wiring 425 as described above.

The semiconductor device 21 may provide the upper and lower arm circuit 9 for one phase. The semiconductor device 21 includes the semiconductor element 30H as a first element and the semiconductor element 30L as a second element. The first main terminal is the P terminal 611 and the second main terminal is the N terminal 612. The first wiring is the P wiring 421 and the second wiring is the N wiring 422. The drain electrode 31 of the semiconductor element 30H is electrically connected to the P wiring 421, and the source electrode 32 of the semiconductor element 30L is electrically connected to the N wiring 422. In such a configuration, the signal wiring 425 may be disposed between the semiconductor element 30H and the snubber circuit 70. In a configuration in which the snubber circuit 70 (13) is connected in parallel to the upper and lower arm circuit 9, the influence of heat from the semiconductor element 30 on the capacitor 71 can be reduced.

The number of capacitors 71 is not particularly limited. The number may be one or plural. In order to achieve high-speed switching, it is effective to dispose the plurality of capacitors 71 near the semiconductor element 30 to increase the capacitance. Increasing the capacitance by using the plurality of capacitors 71 is also effective in suppressing a voltage increase due to LC resonance between the inductance (L) of the wiring connecting the snubber circuit 70 and the smoothing capacitor 5 and the capacitor 71 (C).

In this manner, in a configuration in which the snubber circuit 70 includes the plurality of capacitors 71, a plurality of current paths including the capacitors 71 may be disposed such that the impedances of the plurality of current paths including the capacitors 71 are equal to each other. Therefore, it is possible to suppress current imbalance in the plurality of current paths, that is, the plurality of capacitors 71. This can suppress the temperature of some of the capacitors 71 from being increased due to uneven current flow. By suppressing the current imbalance, the margin up to the upper limit temperature of the heat resistance of the capacitor 71 becomes larger. Therefore, the size of the capacitor 71 can be reduced. The number of capacitors 71 connected in parallel can be reduced. As a result, the size of the semiconductor device 21 can be reduced. The manufacturing costs can be reduced.

The plurality of current paths may be disposed line-symmetrically to have the same impedance. The line-symmetric disposition is not limited to the line-symmetric disposition in which the left and right sides of the symmetry axis (for example, center line CL) are perfectly aligned. The relationship may be substantially line-symmetric. For example, a mounting position of the capacitor 71 may be slightly shifted between the left side and the right side. The wiring patterns may be perfectly line-symmetric, and the arrangement of the capacitors 71 and resistors 72 may be the same between the left side and the right side. For example, in the example illustrated in FIG. 5, the resistor 72 of one current path may be located adjacent to the capacitor 71 of the other current path. The substantially line-symmetric relationship allows the impedances of the plurality of current paths to be substantially equal to each other, thereby suppressing power imbalance. Although not line-symmetric, the plurality of current paths may be provided such that the impedances are equal.

The semiconductor device 21 may have the configuration illustrated in FIG. 5. The semiconductor device 21 illustrated in FIG. 5 has one P terminal 611 as the first main terminal and two N terminals 612 as the second main terminals. The P terminal 611 and the N terminal 612 are disposed to be aligned in the X direction, and the P terminal 611 is disposed between the N terminals 612. The semiconductor element 30H, which is the first element, and the semiconductor element 30L, which is the second element, are disposed to be aligned in the Y direction. The N wiring 422, which is the second wiring, is disposed to interpose the P wiring 421, which is the first wiring, in the X direction. That is, the P wiring 421 is disposed between the two extension portions 422b of the N wiring 422.

As illustrated in FIG. 14, the semiconductor device 21 configured in this manner has two current paths each including the P terminal 611 (first main terminal), the P wiring 421 (first wiring), the capacitor 71, the N wiring 422 (second wiring), and the N terminal 612 (second main terminal). The two current paths are disposed line-symmetrically with respect to the center line CL of the substrate 40. Therefore, the effects described above can be achieved.

When a capacitance of the capacitor 131 (71) that forms the snubber circuit 13 (70) is defined as C and a parasitic inductance of the main circuit portion connecting the snubber circuit 13 and the smoothing capacitor 5 is defined as Ldc, the capacitance C may be set to satisfy C/Ldc > 0.004. By setting the C value to satisfy the above relationship, the ΔVds ratio, that is, a surge voltage, can be effectively suppressed as illustrated in FIG. 12.

The capacitor 71 that forms the snubber circuit 70 may be joined to at least one of the P wiring 421 and the N wiring 422. That is, the capacitor 71 may be mounted on the substrate 40. As compared to a configuration in which a separate substrate for the snubber circuit is used, a thermal resistance between the capacitor 71 and the substrate 40 can be reduced. Therefore, it is possible to effectively dissipate the heat from the capacitor 71 through the substrate 40. The heat of the capacitor 71 can be effectively released to the conductor 43 on the rear surface 41b side and further to the cooler 23. Therefore, the size of the capacitor 71 can be reduced. In the parallel connection configuration, the number of capacitors 71 can be reduced.

The semiconductor device 21 may include a thermal-conductive member that thermally connects the capacitor 71 to a portion of the substrate 40 other than a joint portion with the capacitor 71. As the thermal-conductive member, for example, the sealing body 74 or dummy wiring 44 may be provided. The adhesive 75 may be interposed between the capacitor 71 and the dummy wiring 44. By providing the thermal-conductive member, the heat from the capacitor 71 can be dissipated more effectively through the substrate 40. That is, the heat dissipation of the capacitor 71 can be improved. Therefore, the size of the capacitor 71 can be reduced. In the parallel connection configuration, the number of capacitors 71 can be reduced. By improving the heat dissipation of the capacitor 71, it is possible to further increase a switching speed. The sealing body 74 and the dummy wiring 44 may be combined. The sealing body 74, the dummy wiring 44, and the adhesive 75 may be combined.

### <Modification Examples>

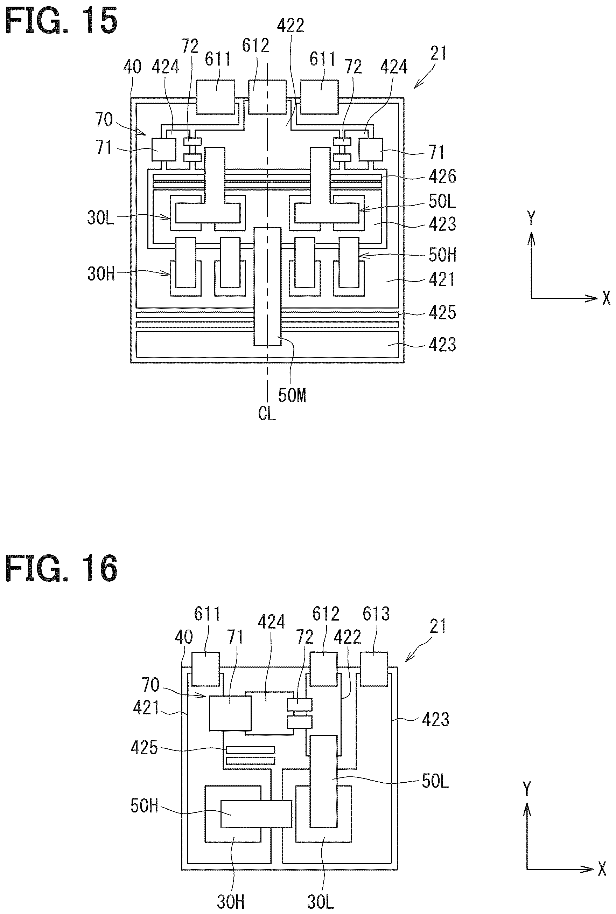

In the configuration having one P terminal 611 and two N terminals 612, the current paths including the capacitors 71 of the snubber circuit 70 are disposed line-symmetrically, but the present disclosure is not limited to this example. As illustrated in FIG. 15, in a configuration having two P terminals 611 and one N terminal 612, the current paths may be disposed line-symmetrically. For convenience, the source electrode 32, the pad 33, the O terminal 613, the signal terminal 62, and the bonding wire 80 are omitted from FIG. 15.

The P terminal 611 and the N terminal 612 are disposed to be aligned in the X direction, and the N terminal 612 is disposed between the P terminals 611. The semiconductor element 30H and the semiconductor element 30L are disposed to be aligned in the Y direction, with the semiconductor element 30L on the P terminal 611 and N terminal 612 side. The P wiring 421 is disposed to interpose the N wiring 422 in the X direction.

The P wiring 421 has a substantially C shape as a planar shape. The P terminals 611 are connected to both ends of the C shape. The four semiconductor elements 30H are mounted on a base portion of the P wiring 421. The N wiring 422 has a substantially T shape as a planar shape. The N terminal 612 is connected to a tip of an extension portion of the N wiring 422. In the X direction, the interconnection wiring 424 is disposed between both ends of the base portion of the N wiring 422 and the two extension portions of the P wiring 421. The capacitor 71 forming the snubber circuit 70 bridges the P wiring 421 and the interconnection wiring 424, and the resistor 72 bridges the interconnection wiring 424 and the N wiring 422. The O wiring 423 is divided into two. One of the O wirings 423 is disposed between a base portion of the P wiring 421 and a base portion of the N wiring 422 in the Y direction. The O wiring 423 has the semiconductor element 30L mounted thereon. The other of the O wirings 423 is disposed at an end portion of the substrate 40 opposite to the P terminal 611 and the N terminal 612.

The source electrode 32 of the semiconductor element 30H is connected to the O wiring 423 disposed between the P wiring 421 and the N wiring 422 via the clip 50H. The source electrode 32 of the semiconductor element 30L is connected to the base portion of the N wiring 422 via the clip 50L. The two O wirings 423 are connected to each other via a clip 50M. The signal wiring 425 is disposed between the base portion of the P wiring 421 and the O wiring 423 disposed at the end portion of the substrate in the Y direction. The signal wiring 426 is disposed between the O wiring 423 surrounded by the P wiring 421 and the base portion of the N wiring 422. The signal wiring 426 extends in the X direction to a position facing the snubber circuit 70.

In this manner, in the configuration illustrated in FIG. 15, the signal wiring 426 is disposed between the semiconductor element 30L and the snubber circuit 70. Therefore, the influence of heat from the semiconductor element 30L on the capacitor 71 can be reduced. The semiconductor device 21 has two current paths each including the N terminal 612 (first main terminal), the N wiring 422 (first wiring), the capacitor 71, the P wiring 421 (second wiring), and the P terminal 611 (second main terminal). The two current paths are disposed line-symmetrically with respect to the center line CL of the substrate 40 as illustrated in FIG. 15. Therefore, as described above, it is possible to suppress current imbalance in the plurality of current paths, that is, in the plurality of capacitors 71.

Although an example is illustrated in which the semiconductor element 30H on the upper arm 9H side and the semiconductor element 30L on the lower arm 9L side are aligned in the Y direction, the present disclosure is not limited to this. As illustrated in FIG. 16, the semiconductor element 30H and the semiconductor element 30L may be disposed side by side in the X direction. For convenience, the source electrode 32, the pad 33, the signal terminal 62, and the bonding wire 80 are omitted from FIG. 16. The semiconductor device 21 has one P terminal 611 and one N terminal 612. The P terminal 611 and the N terminal 612 are disposed to be aligned in the X direction. The semiconductor element 30H and the semiconductor element 30L are disposed to be aligned in the X direction.

The P wiring 421 has a substantially L shape as a planar shape. The semiconductor element 30H is mounted on a base portion of the P wiring 421. An extension portion of the P wiring 421 extends in the Y direction from the base portion. The P terminal 611 is connected to the vicinity of a tip of the extension portion of the P wiring 421. The O wiring 423 has a substantially L shape as a planar shape. The semiconductor element 30L is mounted on a base portion of the O wiring 423. An extension portion of the O wiring 423 extends from the base portion in the Y direction, which is the same direction as the extension portion of the P wiring 421. The O terminal 613 is connected to the vicinity of a tip of the extension portion of the O wiring 423. The N wiring 422 extends in the Y direction. The N wiring 422 is aligned with the base portion of the O wiring 423 in the Y direction. The N wiring 422 is disposed between the extension portion of the P wiring 421 and the extension portion of the O wiring 423 in the X direction. The N terminal 612 is connected to the vicinity of an end portion of the N wiring 422.

The source electrode 32 of the semiconductor element 30H is connected to the base portion of the O wiring 423 via the clip 50H. The source electrode 32 of the semiconductor element 30L is connected to the N wiring 422 via the clip 50L. The interconnection wiring 424 is disposed between the extension portion of the P wiring 421 and the N wiring 422 in the X direction. The capacitor 71 forming the snubber circuit 70 bridges the extension portion of the P wiring 421 and the interconnection wiring 424. The resistor 72 bridges the interconnection wiring 424 and the N wiring 422. The signal wiring 425 is disposed between the base portion of the P wiring 421 and the snubber circuit 70 in the Y direction. That is, the signal wiring 425 is disposed between the semiconductor element 30H and the snubber circuit 70. Therefore, the influence of heat from the semiconductor element 30H on the capacitor 71 can be reduced.

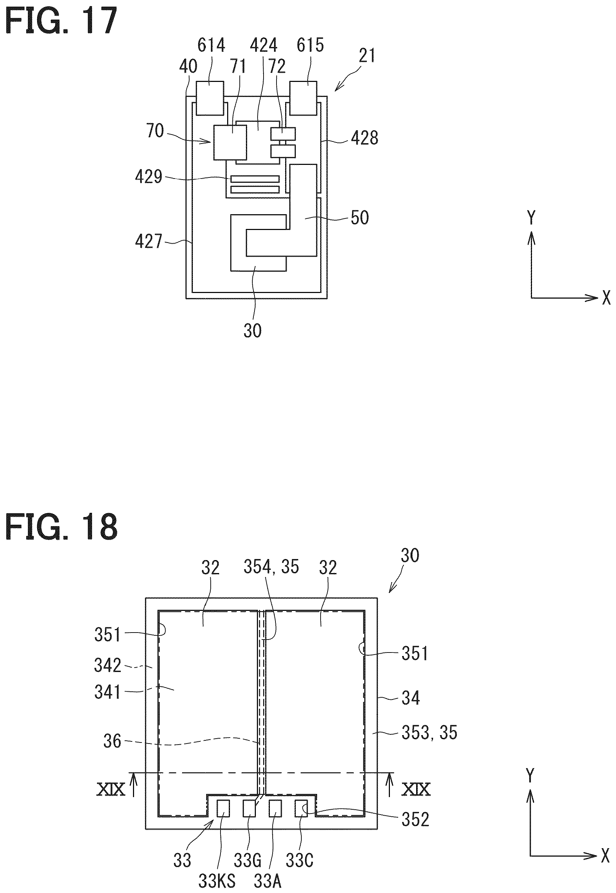

Although an example in which the snubber circuit 70 (13) is disposed in parallel with the upper and lower arm circuit 9 is illustrated, the present disclosure is not limited to this. As illustrated in FIG. 17, the snubber circuit 70 may be disposed in parallel with the arm. For convenience, the source electrode 32, the pad 33, the signal terminal 62, and the bonding wire 80 are omitted from FIG. 17. The semiconductor device 21 illustrated in FIG. 17 has one drain terminal 614 and one source terminal 615 as main terminals 61. The drain terminal 614 and the source terminal 615 are disposed to be aligned in the X direction.

The substrate 40 includes a drain wiring 427, a source wiring 428, and a signal wiring 429, as the conductors 42. The drain wiring 427 has a substantially L shape as a planar shape. The semiconductor element 30 is mounted on a base portion of the drain wiring 427. An extension portion of the drain wiring 427 extends in the Y direction from the base portion. The drain terminal 614 is connected to the vicinity of a tip of the extension portion of the drain wiring 427. The source wiring 428 extends in the Y direction. The source wiring 428 is aligned with the base portion of the drain wiring 427 in the Y direction. The source wiring 428 is aligned with the extension portion of the drain wiring 427 in the X direction. The source terminal 615 is connected to the vicinity of an end portion of the source wiring 428.

The source electrode 32 of the semiconductor element 30 is connected to the source wiring 428 via the clip 50. The interconnection wiring 424 is disposed between the extension portion of the drain wiring 427 and the source wiring 428 in the X direction. The capacitor 71 forming the snubber circuit 70 bridges the extension portion of the drain wiring 427 and the interconnection wiring 424. The resistor 72 bridges the interconnection wiring 424 and the source wiring 428. The signal wiring 429 is disposed between the base portion of the drain wiring 427 and the snubber circuit 70 in the Y direction. That is, the signal wiring 429 is disposed between the semiconductor element 30 and the snubber circuit 70. Therefore, the influence of heat from the semiconductor element 30 on the capacitor 71 can be reduced.

### (Second Embodiment)

This embodiment is a modification example of a basic aspect of the preceding embodiment, and the description of the preceding embodiment can be incorporated.

### <Semiconductor Element>

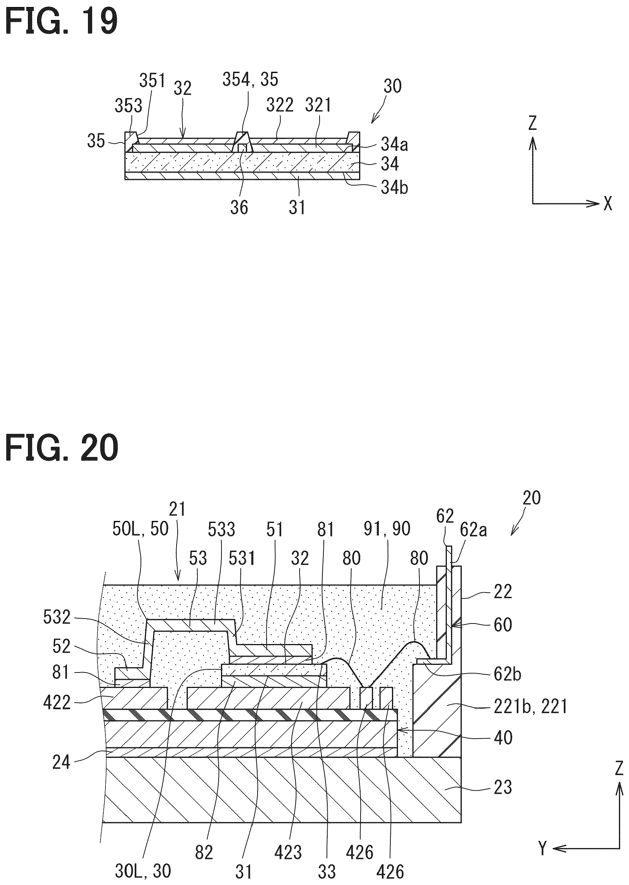

FIG. 18 is a plan view illustrating an example of the semiconductor element 30 in the semiconductor device 21 according to the present embodiment. FIG. 19 is a cross-sectional view taken along a line XIX-XIX in FIG. 18. The semiconductor element 30 includes the drain electrode 31, the source electrode 32, and the pad 33, in the same manner as the configuration illustrated in the preceding embodiment. As illustrated in FIG. 18, the pad 33 includes at least a gate pad 33G. The pads 33 may include an anode pad 33A and a cathode pad 33C. The anode pad 33A and the cathode pad 33C are pads for detecting a temperature, which is connected to a temperature-sensitive diode. The pad 33 may include a Kelvin source pad 33KS. The Kelvin source pad 33KS is a pad for detecting a potential of the source electrode 32. The semiconductor element 30 illustrated in FIG. 18 has four pads 33. All of the pads 33 may be electrically connected to the signal terminals 62, or some of the pads 33 including the gate pad 33G may be electrically connected to the signal terminals 62.

The semiconductor element 30 includes a semiconductor substrate 34. The semiconductor substrate 34 has, for example, a substantially rectangular shape as a planar shape. The semiconductor substrate 34 has an element region 341 and an outer peripheral region 342. An inside region of a two-dot chain line illustrated in FIG. 18 is the element region 341, and an outside region is the outer peripheral region 342. The element region 341 is a region in which a vertical element is formed. The MOSFET 11 is formed in the element region 341. The element region 341 may be referred to as an active region, a main region, a cell region, or the like. The outer peripheral region 342 surrounds the element region 341 in a plan view. In the outer peripheral region 342, a breakdown voltage structure (not illustrated) such as a guard ring is formed.

The semiconductor substrate 34 has one surface 34a and a rear surface 34b. The rear surface 34b is a surface opposite to the one surface 34a in a thickness direction of the semiconductor substrate 34 (semiconductor element 30). The semiconductor element 30 includes an insulating film 35 disposed on the one surface 34a of the semiconductor substrate 34. The insulating film 35 is disposed on the outer peripheral region 342. The insulating film 35 is also disposed on a part of the element region 341. The insulating film 35 may include, for example, polyimide or the like. The insulating film 35 may be referred to as a protective film.

The drain electrode 31 is disposed over almost an entire region of the rear surface 34b. The source electrode 32 is disposed mainly on the element region 341 on the one surface 34a. The pad 33 is disposed on the outer peripheral region 342 of the one surface 34a. The source electrode 32 has a multilayer structure. The source electrode 32 has a lower layer 321 and an upper layer 322. The lower layer 321 may be formed by using a material containing Al (aluminum) as a main component, for example. The lower layer 321 may be formed by using an Al alloy such as AlSi or AlSiCu. The lower layer 321 may be referred to as a base electrode, a wiring electrode, a base layer, or the like. The lower layer 321 is connected to the one surface 34a of the semiconductor substrate 34. The lower layer 321 is connected to a source and an anode of the vertical element. The lower layer 321 extends from above the element region 341 to above the outer peripheral region 342, and an outer peripheral edge of the lower layer 321 is covered with the insulating film 35.

The upper layer 322 is disposed to be laminated on the lower layer 321 for the purposes of improving a joining strength with a solder and improving a wettability or the like with the solder. The upper layer 322 may be formed by using a material containing Ni (nickel) as a main component, for example. The upper layer 322 may be a P-containing Ni plating film. The NiP film is formed by a non-electrolytic plating method. The upper layer 322 may be referred to as an upper electrode, a connection electrode, an upper layer, a plating layer, or the like. An Au layer may be provided at the upper layer 322 during the manufacturing process. Au suppresses, for example, oxidation of Ni and improves the wettability with the solder. Au diffuses into the solder during soldering, so it exists in the state before joining and does not exist in the joined state. The pad 33 has the same configuration as the source electrode 32.

The semiconductor element 30 includes a signal wiring. At least a part of the signal wiring is disposed on the element region 341 on the one surface 34a. The signal wiring is disposed to be aligned with the source electrode 32 in a plan view. The signal wiring may be disposed on the same surface as the lower layer 321 of the source electrode 32. The signal wiring may include, for example, a gate wiring 36 illustrated by the dashed chain line in FIG. 18. The gate wiring 36 electrically connects the gate of the MOSFET 11 formed in the element region 341 to the gate pad 33G. The signal wiring may include, for example, an anode wiring and a cathode wiring. The anode wiring electrically connects an anode of the temperature-sensitive diode and the anode pad 33A. The cathode wiring electrically connects a cathode of the temperature-sensitive diode and the cathode pad 33C. The signal wiring may include the gate wiring 36, the anode wiring, and the cathode wiring. For convenience, only the gate wiring 36 is illustrated in FIG. 18.

The insulating film 35 has openings 351 and 352. The opening 351 defines a joint region of the source electrode 32. The upper layer 322 is laminated on a portion of the lower layer 321, which faces the opening 351. The upper layer 322 is disposed to be laminated on the upper layer 322 within the opening 351. An outer contour of the opening 351, that is, the joint region (exposed portion) of the source electrode 32, substantially coincides with an outer contour of the element region 341 in a plan view in a thickness direction. The opening 352 defines a joint region of the pad 33.

The insulating film 35 has an outer peripheral portion 353 disposed on the outer peripheral region 342 and an upper element portion 354 disposed on the element region 341. The upper element portion 354 is continuous with the outer peripheral portion 353. The upper element portion 354 is disposed on the one surface 34a, and covers the signal wiring disposed on the element region 341. The upper element portion 354 electrically separates the signal wiring from the source electrode 32. The upper element portion 354 extends along the signal wiring. In a plan view, the upper element portion 354 is interposed by the source electrode 32. The upper element portion 354 and the outer peripheral portion 353 provide wall surfaces of the opening 351. The source electrode 32 is in contact with a side surface of the upper element portion 354. An upper end of the upper element portion 354 is located above an upper surface of the source electrode 32, that is, above a surface exposed from the opening 351.

In the example illustrated in FIG. 18, the upper element portion 354 covers the signal wiring including the gate wiring 36. The gate wiring 36 is disposed substantially at a center of the element region 341 in the X direction, and extends in the Y direction to divide the element region 341 into substantially two equal parts. The upper element portion 354 extends along the gate wiring 36 and divides the source electrode 32 into substantially two equal parts. The source electrode 32 is divided (partitioned) by the upper element portion 354. The upper element portion 354 is continuous with the outer peripheral portion 353 at both ends in the Y direction.

The pattern of the signal wiring including the gate wiring 36, that is, the pattern of the upper element portion 354, is not limited to the example illustrated in FIG. 18. In a plan view, the pattern may have, for example, a cross-shape. The upper element portion 354 may be continuous with the outer peripheral portion 353 only on the pad 33 side.

### <Semiconductor Device and Semiconductor Module>

The semiconductor device 21 of the present embodiment includes at least the semiconductor element 30, a metal plate, and solder illustrated in FIGS. 18 and 19. The metal plate is soldered and joined to a main electrode. The metal plate may be the clip 50 described in the preceding embodiment, or may be a member other than the clip 50, for example, a lead. The semiconductor device 21 may include a substrate having a wiring. The semiconductor element 30 is mounted on the substrate. The clip 50, which is a metal plate, is joined to the main electrode as well as the wiring. The semiconductor device 21 may include a sintered member. The semiconductor element 30 is connected to the metal member via the sintered member. The metal member may be a wiring on the substrate or a metal plate such as a heat sink. The semiconductor device 21 may include a sealing body that seals the semiconductor element 30 or the metal plate. A gel may be used as the sealing body.

FIG. 20 illustrates an example of the semiconductor device 21 and the semiconductor module 20. FIG. 20 is a partial cross-sectional view illustrating a periphery of the semiconductor element 30L and the clip 50L in the semiconductor device 21 and the semiconductor module 20. A basic configuration of the semiconductor device 21 and the semiconductor module 20 has the same manner as the configuration described in the preceding embodiment. The semiconductor module 20 includes the semiconductor device 21, the housing 22, and the cooler 23. The semiconductor device 21 includes the semiconductor element 30, the substrate 40, the clip 50, and the external connection terminal 60. The semiconductor device 21 may include the snubber circuit 70, in the same manner as the preceding embodiment. The semiconductor device 21 includes a solder 81 and a sintered member 82 as bonding materials. The semiconductor device 21 includes a sealing body 90.

The clip 50L (50) corresponds to a metal plate. The clip 50L has a joint portion 51 to the source electrode 32 of the semiconductor element 30L and a joint portion 52 to the N wiring 422. In the present embodiment, the joint portion 51 corresponds to a first joint portion, and the joint portion 52 corresponds to a second joint portion. The solder 81 is interposed between the source electrode 32 and the joint portion 51. The solder 81 joins the source electrode 32 and the clip 50L. The solder 81 is interposed between the N wiring 422 and the joint portion 52. The solder 81 joins the N wiring 422 and the clip 50L. The clip 50L has a coupling portion 53. The coupling portion 53 is continuous with the joint portions 51 and 52. The coupling portion 53 connects the joint portions 51 and 52 to form a continuous integral piece. The coupling portion 53 may connect the joint portions 51 that are connected to different semiconductor elements 30.

The coupling portion 53 has inclined portions 531 and 532 and an intermediate portion 533. The inclined portion 531 rises obliquely upward from the joint portion 51. The inclined portion 531 has an inclination such that the distance from the joint portion 51 (semiconductor element 30L) in the Z direction increases with the distance from the joint portion 51 in the Y direction. The inclined portion 532 rises obliquely upward from the joint portion 52. The inclined portion 532 has an inclination such that the distance from the joint portion 52 (substrate 40) in the Z direction increases with the distance from the joint portion 52 in the Y direction. The inclined portions 531 and 532 are inclined with respect to the Y direction, which is a direction in which the joint portions 51 and 52 are aligned. The intermediate portion 533 connects the inclined portions 531 and 532. The intermediate portion 533 may be substantially parallel to the joint portions 51 and 52 in a mounted state.

Although not illustrated in FIG. 20, the clip 50H has the same configuration as the clip 50L. The clip 50H has the joint portion 51 to the source electrode 32 of the semiconductor element 30H, the joint portion 52 to the O wiring 423, and the coupling portion 53. The solder 81 is interposed between the source electrode 32 and the joint portion 51. The solder 81 joins the source electrode 32 and the clip 50H. The solder 81 is interposed between the O423 and the joint portion 52. The solder 81 joins the O wiring 423 and the clip 50H.

The sintered member 82 is interposed between the drain electrode 31 of the semiconductor element 30L and the O wiring 423. The sintered member 82 joins the drain electrode 31 and the O wiring 423. Although not illustrated, the sintered member 82 is interposed between the drain electrode 31 of the semiconductor element 30H and the P wiring 421. The sintered member 82 joins the drain electrode 31 and the P wiring 421. The sintered member 82 is disposed below the semiconductor element 30, and the solder 81 is disposed above the semiconductor element 30.

The sintered member 82 is made of Ag or Cu. The sintered member 82 is a sintered body made of Ag particles or Cu particles. The sintered member 82 can be joined at a lower temperature than solder. Ideally, the sintered member 82 is disposed to substantially coincide with a joint surface of the drain electrode 31 in a plan view. The sintered member 82 is provided as, for example, a sintering sheet. The sintering sheet may be referred to as a sintering film. The sintering sheet is smaller than the drain electrode 31 in a plan view before being pressed. The sintering sheet is disposed between the drain electrode 31 and a target wiring to form a laminate, and the laminate is pressed from the semiconductor element 30 side while being heated. Therefore, the sintering sheet is expanded between the opposing surfaces of the drain electrode 31 and the wiring, reducing its thickness, and is sintered to form the sintered member 82.

The sealing body 90 seals the elements of the semiconductor device 21. The sealing body 90 integrally seals the semiconductor element 30, the substrate 40, the clip 50, and a part of each external connection terminal 60. The sealing body 90 also seals the bonding wire 80 that electrically connects the pad 33 of the semiconductor element 30 to the signal terminal 62. In the example illustrated in FIG. 20, a gel 91 is used as the sealing body 90. Instead of the gel 91, a potting resin may be used. A space formed by the housing 22 and the cooler 23 is filled with the sealing body 90. The sealing body 90 may be a resin molded body. The sealing body 90 may be provided in the semiconductor device 21 or in the semiconductor module 20.

### <Clip>

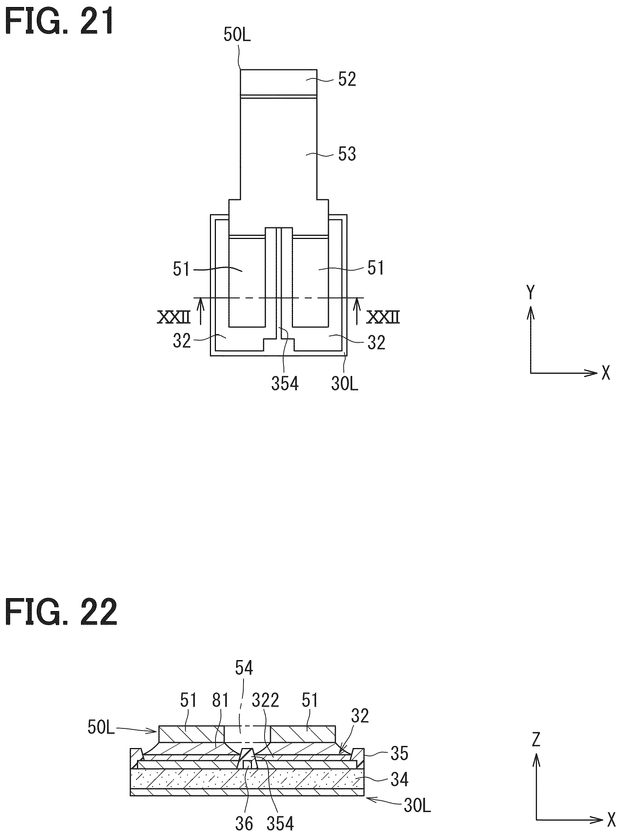

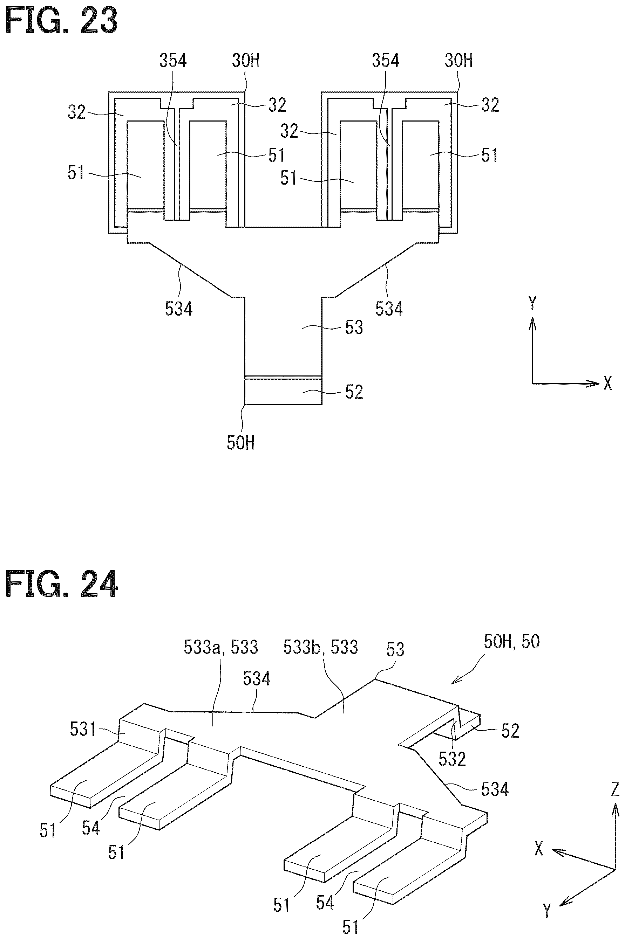

FIGS. 21, 22, 23, and 24 illustrate an example of the clip 50 that is applied to the semiconductor element 30 illustrated in FIGS. 18 and 19. FIGS. 21 and 22 illustrate an example of the clip 50L. FIG. 22 is a cross-sectional view taken along a line XXII-XXII in FIG. 21. FIGS. 23 and 24 illustrate an example of the clip 50H. FIGS. 21, 22, and 23 illustrate a connection structure between the clip 50 and the semiconductor element 30. The clip 50 illustrated in FIGS. 21 to 24 has the same configuration as the configuration described in the preceding embodiment.

As illustrated in FIGS. 21 and 22, the clip 50L is connected to the single semiconductor element 30L. The joint portion 51 to the source electrode 32 is disposed to avoid the signal line including the gate wiring 36 disposed on the element region 341. In a plan view, the joint portion 51 is disposed not to overlap with the signal line over an entire length of the signal line. As illustrated in FIGS. 21 and 22, the joint portion 51 may be disposed to avoid the upper element portion 354 that covers the signal line. By avoiding overlapping with the upper element portion 354, overlapping with the signal line covered by the upper element portion 354 is also avoided. The joint portion 51 may be disposed to overlap with the upper element portion 354 in a plan view, but not overlap with the signal line.

The clip 50L has two joint portions 51 corresponding to the two source electrodes 32, which are divided. The joint portion 51 branches into the same number of branches as the source electrodes 32. Between facing side surfaces of the adjacent joint portions 51, a facing space 54 indicated by the dashed chain line in FIG. 22 is formed. The facing space 54 may be referred to as a facing region. In a plan view, one of the joint portions 51 overlaps with one of the source electrodes 32, and the other of the joint portions 51 overlaps with the other of the source electrodes 32. One of the joint portions 51 is soldered and joined to one of the source electrodes 32, and the other of the joint portions 51 is soldered and joined to the other of the source electrodes 32. Above the signal line and the upper element portion 354, the facing space 54 is located. In a plan view, each of the joint portions 51 does not overlap with the signal line and the upper element portion 354.

The clip 50L extends in the Y direction. The joint portion 51 and the joint portion 52 are aligned in the Y direction. The two joint portions 51 are aligned in the X direction. Each joint portion 51 has a substantially rectangular shape as a planar shape, with the Y direction as a longitudinal direction and the X direction as a lateral direction. In a plan view, an area of each joint portion 51 is smaller than an area of the corresponding source electrode 32. The clip 50L has the coupling portion 53. As illustrated in FIG. 20, the coupling portion 53 has the inclined portions 531 and 532 and the intermediate portion 533.

As illustrated in FIG. 23, the clip 50H is connected to two semiconductor elements 30H. The joint portion 51 to the source electrode 32 is disposed to avoid the signal line including the gate wiring 36 disposed on the element region 341. In a plan view, the joint portion 51 is disposed not to overlap with the signal line over an entire length of the signal line. As illustrated in FIG. 23, the joint portion 51 may be disposed to avoid the upper element portion 354 that covers the signal line.

The clip 50H has four joint portions 51 corresponding to the two divided source electrodes 32 of the two semiconductor elements 30H. Among the joint portions 51, two of the joint portions 51 are connected to one of the semiconductor elements 30H, and the other two joint portions 51 are connected to the other of the semiconductor elements 30H. The facing space 54 is formed between the side surfaces of the joint portions 51 that are joined to the common semiconductor element 30. A distance between the joint portions 51 connected to different semiconductor elements 30H, that is, a distance between the second and third joint portions 51 in the X direction, is more than the facing space 54 in the X direction. In a plan view, each joint portion 51 overlaps with the corresponding source electrode 32. The joint portion 51 is soldered and joined to the corresponding source electrode 32. Above the signal line and the upper element portion 354, the facing space 54 is located. In a plan view, each of the joint portions 51 does not overlap with the signal line and the upper element portion 354.

The clip 50H extends in the Y direction. The joint portion 51 and the joint portion 52 are aligned in the Y direction. The four joint portions 51 are aligned in the X direction. Each joint portion 51 has a substantially rectangular shape as a planar shape, with the Y direction as a longitudinal direction and the X direction as a lateral direction. Each joint portion 51 has an area smaller than an area of the corresponding source electrode 32 in a plan view. The clip 50H has the coupling portion 53. The coupling portion 53 couples the joint portion 51 and the joint portion 52. The coupling portion 53 couples the joint portions 51 that are connected to different semiconductor elements 30H. The coupling portion 53 has the inclined portions 531 and 532 and the intermediate portion 533, in the same manner as the clip 50L.

The intermediate portion 533 includes a first intermediate portion 533a and a second intermediate portion 533b. The first intermediate portion 533a extends in a direction in which the joint portions 51 are aligned, that is, in the X direction. The first intermediate portion 533a couples the four joint portions 51 via the inclined portions 531. In FIG. 24, the inclined portion 531 is provided for each joint portion 51, but a configuration in which a plurality of joint portions 51 are connected to the common inclined portion 531 may also be used. The second intermediate portion 533b extends in a direction in which the joint portions 51 and 52 are aligned, that is, in the Y direction. The second intermediate portion 533b connects the joint portion 52 and the first intermediate portion 533a. The clip 50H has a tapered portion 534 at an end portion of the first intermediate portion 533a on the joint portion 52 side. The tapered portion 534 has an inclination such that the length of the first intermediate portion 533a in the X direction increases with the distance from the joint portion 52 in the Y direction. The tapered portion 534 is inclined with respect to the Y direction, which is a direction in which the joint portions 51 and 52 are aligned.

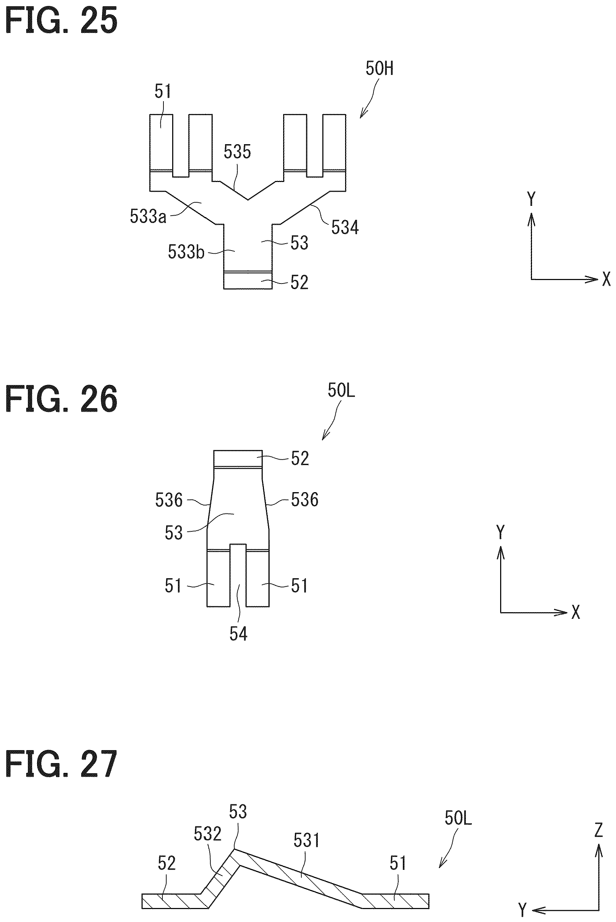

The clip 50 is not limited to the shape described above. A variety of shapes can be adopted. For example, as illustrated in FIG. 25, a tapered portion 535 may be added to the configuration illustrated in FIG. 24. The tapered portion 535 is provided at an end portion of the first intermediate portion 533a on the joint portion 51 side. The clip 50H has a shape in which the end portion of the first intermediate portion 533a on the joint portion 51 side is cut out at a position between the second joint portion 51 and the third joint portion 51. The cut-out space has a substantially triangular shape in a plan view, and a length of the cut-out space in the X direction is increased as a distance from the joint portion 52 in the Y direction is increased. The tapered portion 535 is an end surface that defines the cut-out space. The tapered portion 535 is inclined with respect to the Y direction, which is a direction in which the joint portions 51 and 52 are aligned.

As illustrated in FIG. 26, the clip 50L may have a tapered portion 536. The tapered portion 536 has an inclination such that the length of the coupling portion 53 in the X direction increases with the distance from the joint portion 52 in the Y direction. The tapered portion 536 is inclined with respect to the Y direction, which is a direction in which the joint portions 51 and 52 are aligned.

As illustrated in FIG. 27, the clip 50L may have the inclined portions 531 and 532 and no intermediate portion 533. The inclined portion 531 is continuous with the inclined portion 532 without the intermediate portion 533 therebetween. Since there is no intermediate portion 533, the inclination of the inclined portions 531 and 532 is gentle. The clip 50H may have a structure in the same manner. The inclined portions 531 and 532 are inclined with respect to the Y direction, which is a direction in which the joint portions 51 and 52 are aligned.

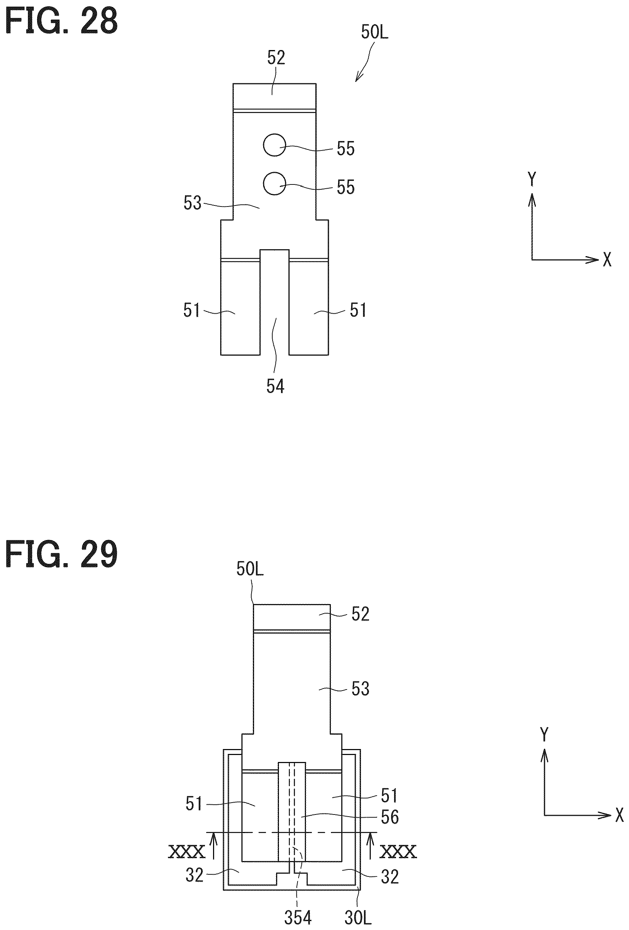

As illustrated in FIG. 28, the clip 50L may have a through hole 55. The through hole 55 penetrates the coupling portion 53 in the thickness direction. A planar shape of the through hole 55 is not particularly limited. The planar shape may be a circle as illustrated in FIG. 28, or a polygonal shape such as a triangle or a square. The planar shape may also be a cross-shape or an L shape. The planar shape may also be a long hole that is long in one direction. The number of through holes 55 is not particularly limited. The number may be one or plural. A position of the through hole 55 is not particularly limited. The clip 50H may have a structure in the same manner.

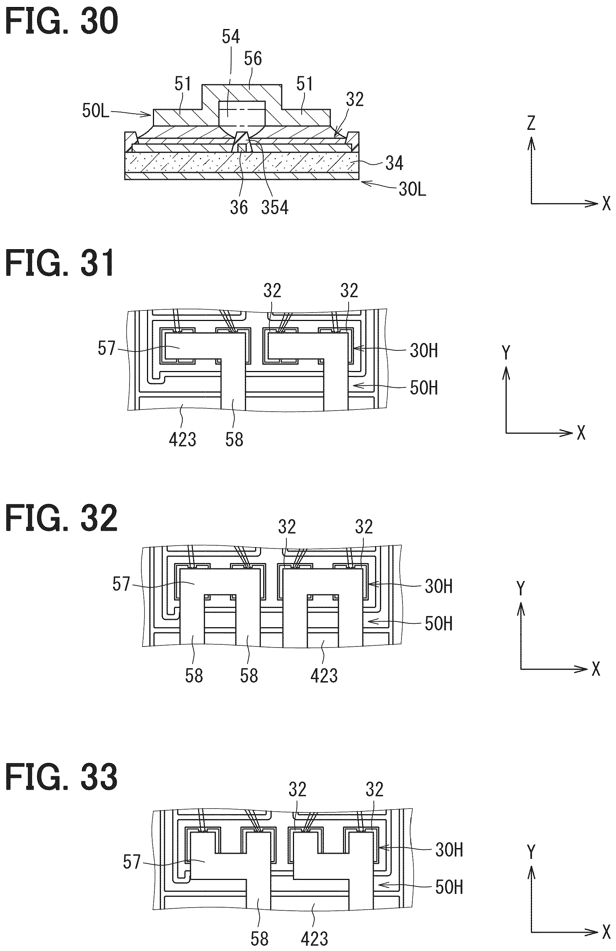

As illustrated in FIGS. 29 and 30, the clip 50L may have a bridge portion 56. FIG. 30 is a cross-sectional view taken along a line XXX-XXX in FIG. 29. The bridge portion 56 is continuous with a plurality of joint portions 51 that are connected to the common semiconductor element 30L. The bridge portions 56 bridge adjacent joint portions 51 at positions farther away from the semiconductor element 30L than the joint portions 51. The facing space 54 is formed directly below the bridge portion 56. The bridge portion 56 is provided to overlap with the facing space 54 in a plan view. The clip 50H may have a structure in the same manner.

As illustrated in FIG. 31, the clip 50H may have a substantially L shape as a planar shape. The clip 50H has a coupling portion 57 and an extension portion 58. The coupling portion 57 is connected to the source electrodes 32 of the two semiconductor elements 30H, and electrically connects the source electrodes 32. The extension portion 58 is continuous with the coupling portion 57, and electrically connects the source electrodes 32 to the O wiring 423. In FIG. 31, the coupling portion 57 extends in the X direction in a plan view, and is disposed to overlap with the source electrodes 32. The extension portion 58 extends in the Y direction.

For convenience, the clip 50H is illustrated in a simplified form in FIG. 31. Although not illustrated in FIG. 31, the coupling portion 57 includes the joint portion 51. The joint portion 51 branches in accordance with a division structure of the source electrode 32. The extension portion 58 includes the joint portion 52. Each of the coupling portion 57 and the extension portion 58 includes the coupling portion 53. The coupling portion 57 may include the bridge portion 56. The coupling portion 53 may have the through hole 55. The same is applied to following FIGS. 32 to 37.

As illustrated in FIG. 32, the clip 50H may have a substantially U shape as a planar shape. In the same manner as FIG. 31, the coupling portion 57 extends in the X direction, and electrically connects the source electrodes 32 of the two semiconductor elements 30H. The clip 50H has two extension portions 58. The two extension portions 58 are connected to the O wiring 423. One of the extension portions 58 is continuous with one end portion of the coupling portion 57, and the other of the extension portions 58 is continuous with the other end portion of the coupling portion 57.

As illustrated in FIG. 33, the clip 50H may have a substantially Y shape as a planar shape. The coupling portion 57 of the clip 50H has a substantially U shape as a planar shape. One end portion of the coupling portion 57 is connected to one of the semiconductor elements 30H, and the other end portion is connected to the other one of the semiconductor elements 30H. The extension portion 58 is continuous with the coupling portion 57 at a position offset toward one semiconductor element 30H in the X direction. The extension portion 58 extends in the Y direction, and is connected to the O wiring 423.

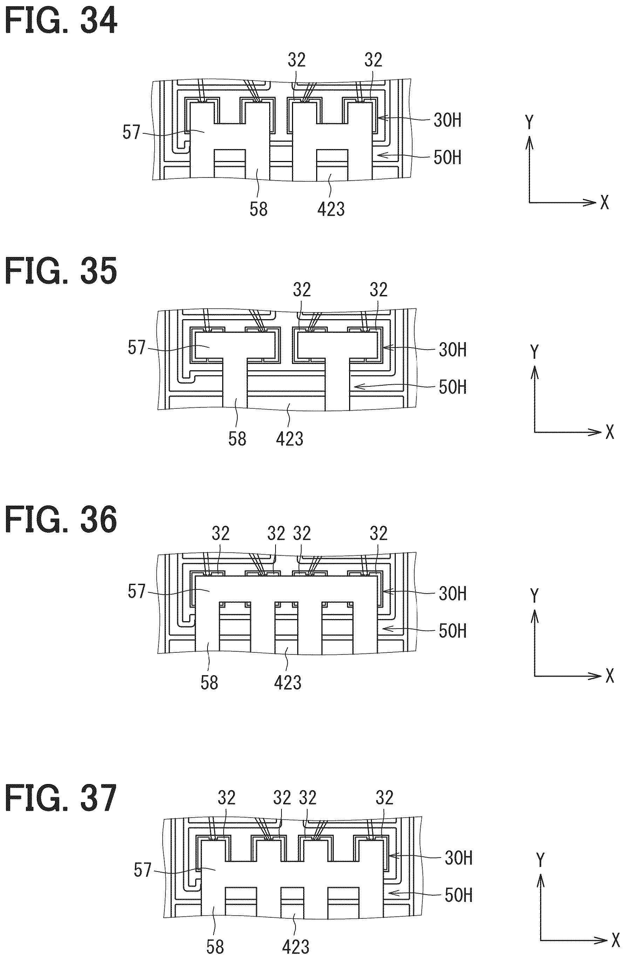

As illustrated in FIG. 34, the clip 50H may have a substantially H shape as a planar shape. In the same manner as FIG. 34, the coupling portion 57 has a substantially U shape as a planar shape. The clip 50H has two extension portions 58. One of the extension portions 58 is continuous with the coupling portion 57 at a position offset to one of the semiconductor elements 30H. The other extension portion 58 is continuous with the coupling portion 57 at a position offset toward the other of the semiconductor elements 30H. The extension portions 58 all extend in the Y direction and are connected to the O wiring 423.

As illustrated in FIG. 35, the clip 50H may have a substantially T shape as a planar shape. In the same manner as FIG. 31, the coupling portion 57 extends in the X direction, and electrically connects the source electrodes 32 of the two semiconductor elements 30H. The extension portion 58 is continuous with the coupling portion 57 in the vicinity of a center in the X direction. The extension portion 58 extends in the Y direction, and is connected to the O wiring 423.

In FIGS. 31 to 35, two clips 50H are used for four semiconductor elements 30H. Alternatively, as illustrated in FIG. 36, one clip 50H may be used for the four semiconductor elements 30H. In the same manner as FIG. 31, the coupling portion 57 extends in the X direction, and electrically connects the source electrodes 32 of the four semiconductor elements 30H. The clip 50H has four extension portions 58. The extension portions 58 are arranged side by side in the X direction at intervals corresponding to the semiconductor elements 30H. The extension portions 58 all extend in the Y direction and are connected to the O wiring 423.

The clip 50H illustrated in FIG. 37 may also be used. The coupling portion 57 has a structure in which two substantially planar U shapes are connected together. The coupling portion 57 electrically connects the source electrodes 32 of the four semiconductor elements 30H. The clip 50H has four extension portions 58. The extension portions 58 are arranged side by side in the X direction at intervals corresponding to the semiconductor elements 30H. The extension portions 58 all extend in the Y direction and are connected to the O wiring 423.

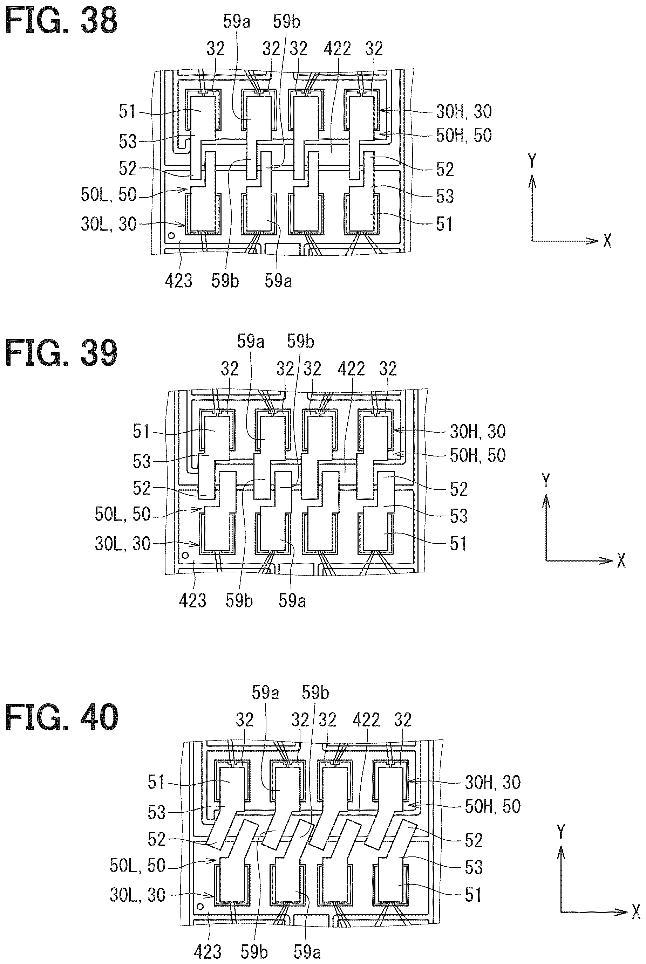

As illustrated in FIG. 38, the clip 50 may be provided for each semiconductor element 30. That is, one clip 50 may be used for each semiconductor element 30. The clips 50H and 50L have a common structure. The clip 50 has a substantially L shape as a planar shape. The clip 50 has an expanded-width portion 59a, which is a wide portion having a length in the X direction in a plan view, and a reduced-width portion 59b, which is a narrow-width portion. The expanded-width portion 59a includes the joint portion 51 and a part of the coupling portion 53. The reduced-width portion 59b includes the joint portion 52 and a part of the coupling portion 53.

In this manner, as the clips 50H and 50L, a common and substantially L shape structure is adopted, and the clip 50L is disposed to be rotated by 180 degrees relative to the clip 50H. Therefore, even when the numbers of semiconductor elements 30H and 30L are the same, the clips 50H and 50L can be disposed to interlock with each other. Therefore, the size in the X direction can be reduced. Interlocking with each other means a positional relationship in which at least a portion of the reduced-width portion 59b of the clip 50H faces the expanded-width portion 59a of the clip 50L in the Y direction, and at least a portion of the reduced-width portion 59b of the clip 50L faces the expanded-width portion 59a of the clip 50H in the Y direction.

For convenience, the clip 50 is also illustrated in a simplified form in FIG. 38. Although not illustrated in FIG. 38, the joint portion 51 branches in accordance with a division structure of the source electrode 32. The clip 50 may have the bridge portion 56 and may have the through hole 55. The same is applied to following FIGS. 39 and 40.

As illustrated in FIG. 39, a width of the reduced-width portion 59b may be increased and a position thereof may be shifted in the X direction. The clip 50 has the expanded-width portion 59a including the joint portion 51 and the reduced-width portion 59b including the joint portion 52. The reduced-width portion 59b is continuous with the expanded-width portion 59a but shifted in the X direction. With this shift, the coupling portion 53 has a step. A width of the reduced-width portion 59b is greater than a width of the example illustrated in FIG. 38. The joint portion 52 is not drawn straight from the joint portion 51 but is drawn out shifted in the X direction. The clip 50L has the same structure as the clip 50H, but is disposed rotated 180 degrees relative to the clip 50H. Therefore, even when the width of the reduced-width portion 59b is increased, the clips 50H and 50L can be disposed to interlock with each other. Therefore, the size in the X direction can be reduced.

As illustrated in FIG. 40, the reduced-width portion 59b may extend obliquely. The clip 50 has the expanded-width portion 59a including the joint portion 51 and the reduced-width portion 59b including the joint portion 52. The reduced-width portion 59b extends from the expanded-width portion 59a in a direction inclined with respect to the X direction and the Y direction. A width of the reduced-width portion 59b is greater than a width of the example illustrated in FIG. 38. The joint portion 52 is not drawn straight from the joint portion 51 but drawn obliquely. The clip 50L has the same structure as the clip 50H, but is disposed rotated 180 degrees relative to the clip 50H. Therefore, even when the width of the reduced-width portion 59b is increased, the clips 50H and 50L can be disposed to interlock with each other. Therefore, the size in the X direction can be reduced.

### <Summary of Second Embodiment>

With the present embodiment, the semiconductor device 21 includes the semiconductor element 30, the clip 50 which is a metal plate, and the solder 81 which joins the semiconductor element 30 and the clip 50. As described above, the semiconductor element 30 has the signal lines including the source electrode 32 and the gate wiring 36 disposed on one surface of the semiconductor substrate 34 and on the element region 341. The semiconductor element 30 also has the upper element portion 354 of the insulating film 35 that covers the signal line. As illustrated in FIG. 22 and the like, the joint portion 51 of the clip 50 is disposed to avoid the signal lines. Therefore, it is possible to suppress the solder 81 from flowing into a scratch on the upper element portion 354, which occurs during the manufacturing process. Therefore, leakage in the signal line, for example, gate leakage, can be suppressed. It is possible to suppress occurrence of a leakage current in the signal line.

The clip 50 may have the plurality of joint portions 51 to the common semiconductor element 30. Therefore, it is possible to suppress leakage in the signal lines while ensuring a sufficient joint area. In particular, the joint portion 51 for the common semiconductor element 30 may branch into a plurality of portions. By adopting the joint portion 51 having a structure of branching into the plurality of portions, it is easy to ensure a sufficient joint area while avoiding the signal lines. With the branch structure, the facing spaces 54 between the adjacent joint portions 51 function as injection ports for the sealing material when forming the sealing body 90 and as outlet ports for an air. Therefore, it is possible to suppress the sealing body 90 from being left unfilled or suppress air pockets from being formed inside the sealing body 90.

The clip 50 may have the bridge portion 56 that is connected to the adjacent joint portion 51 at a position that is farther away from the one surface 34a of the semiconductor substrate 34 than the joint portion 51. By providing the bridge portion 56, the heat dissipation area or the current carrying area can be increased. As illustrated in FIG. 30, the bridge portion 56 is located above the joint portion 51, so that the solder 81 can be suppressed from being wet and spread over a surface of the bridge portion 56 and flowing onto the upper element portion 354.

The clip 50 may have the plurality of joint portions 51 and the joint portion 52. That is, the clip 50 may have a total of three or more joint portions 51 and 52. The clip 50 is supported at three or more points, and the position of the clip 50 is stabilized. Therefore, it is possible to suppress misalignment, including tilting, of the clip 50. The joint portions 52 may be connected to the wiring of the substrate 40 on which the semiconductor element 30 is mounted. For example, the configuration can be simplified. Since the semiconductor element 30 and the clip 50 are connected to the substrate 40, the positions of the semiconductor element 30, the wiring of the substrate 40, and the clip 50 can be easily determined.

The drain electrode 31 of the semiconductor element 30 may be connected to the metal member as a connection target via the sintered member 82. That is, the sintered member 82 may be disposed directly below the drain electrode 31 of the semiconductor element 30, and the solder 81 may be disposed directly above the source electrode 32 of the semiconductor element 30. By using the sintered member 82, a thermal resistance of the path that mainly contributes to heat dissipation can be reduced. When pressure is applied to form the sintered member 82, there is a risk that the upper element portion 354 of the insulating film 35 may be damaged by the pressure device. However, even when a scratch occurs, it is possible to suppress the solder 81 from flowing into the scratch on the upper element portion 354 by arranging the joint portion 51 to avoid the signal line.

The semiconductor element 30 having the pad 33, the clip 50, a part of the signal terminal 62, and the bonding wires 80 connecting the pad 33 and the signal terminal 62 may be integrally sealed with the gel 91. In such a sealing structure, the through hole 55 may be provided in the coupling portion 53 of the clip 50. The gel 91 located above the clip 50 and the gel 91 located below the clip 50 are continuously connected via the gel 91 disposed in the through hole 55. Even when vibration of a mobile object is transmitted to the gel 91, vibration of the gel 91 is limited by the through hole 55 (clip 50). The gel 91 is fixed by the through hole 55. Therefore, it is possible to suppress the bonding wires 80 from being broken due to the vibration of the gel 91.

The semiconductor element 30 and the clip 50 may be integrally sealed with the sealing body 90 such as the gel 91 or a potting resin. In such a sealing structure, the coupling portion 53 of the clip 50 may be provided with a shape that is inclined with respect to the direction in which the joint portions 51 and 52 are aligned. As illustrated in FIGS. 20 and 27, the inclined portions 531 and 532 are inclined with respect to the Y direction, which is the direction in which the joint portions 51 and 52 are aligned. As illustrated in FIGS. 23, 25, and 26, the tapered portions 534, 535, and 536 are all inclined with respect to the Y direction, which is the direction in which the joint portions 51 and 52 are aligned. Therefore, it is difficult for the coupling portion 53 to hinder the flow of the sealing material along the clip 50 when the sealing material is filled to form the sealing body 90. The sealing material flows along the inclination. This can help improve the fluidity of the sealing material. It is possible to suppress the sealing body 90 from being left unfilled and suppress air pockets from being formed within the sealing body 90.

The configuration described in the present embodiment can be combined with the configuration described in the preceding embodiment.

### (Third Embodiment)

This embodiment is a modification example of a basic aspect of the preceding embodiment(s), and the description of the preceding embodiment(s) can be incorporated.

### <Semiconductor Device>

The semiconductor device 21 of the present embodiment includes at least a resin housing, a substrate having wirings, a plurality of semiconductor elements joined to the wirings and connected in parallel, and a signal terminal. The signal terminal includes a branch terminal. The branch terminal has a single first connection portion connected to an external device, a plurality of second connection portions electrically connected to pads of the semiconductor elements, and a coupling portion connecting the first connection portion and the second connection portions.

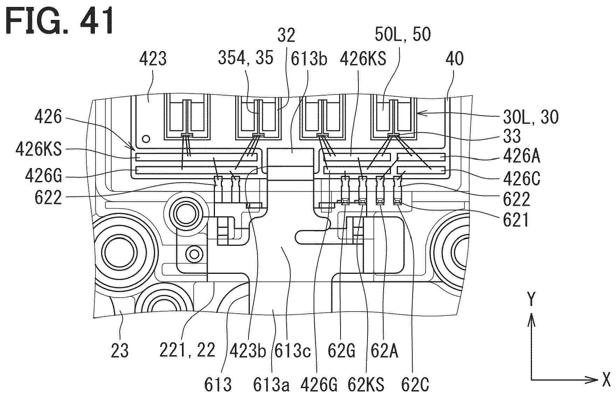

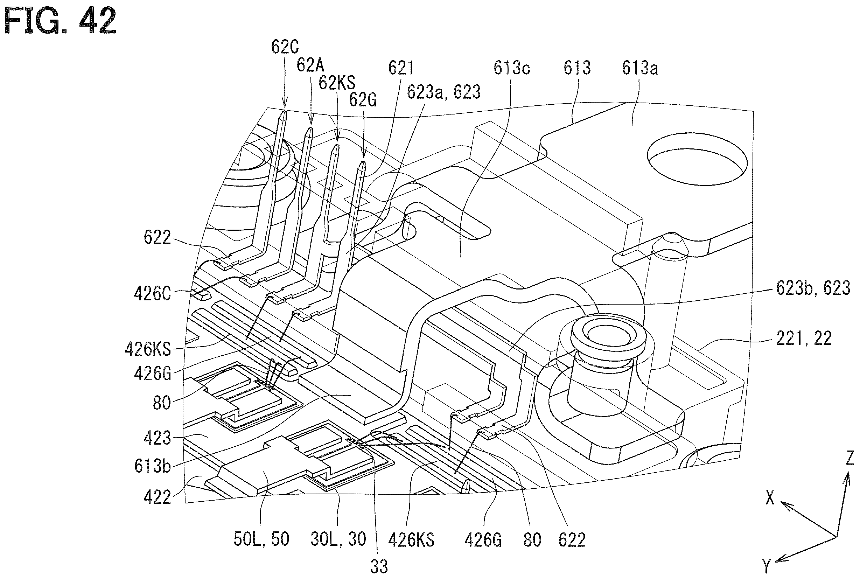

FIG. 41 is a diagram illustrating an example of the semiconductor device 21 and the semiconductor module 20 according to the present embodiment. FIG. 41 illustrates a part of the semiconductor device 21. FIG. 42 is an enlarged perspective view of the periphery of the O terminal 613 of the semiconductor device 21 illustrated in FIG. 41. In FIGS. 41 and 42, the housing 22 is illustrated in a see-through manner. A basic configuration of the semiconductor device 21 and the semiconductor module 20 illustrated in FIGS. 41 and 42 has the same manner as the configuration described in the preceding embodiment. The semiconductor module 20 includes the semiconductor device 21, the housing 22, and the cooler 23. The semiconductor device 21 includes the semiconductor element 30, the substrate 40, the clip 50, and the external connection terminal 60. The semiconductor device 21 may include the snubber circuit 70, in the same manner as the preceding embodiment. The semiconductor device 21 may include the sealing body 90.

The semiconductor device 21 of the present embodiment includes the plurality of semiconductor elements 30H and the plurality of semiconductor elements 30L, as illustrated in FIG. 5. A configuration of the semiconductor element 30 has the same manner as the configuration illustrated in, for example, FIGS. 18 and 19. The semiconductor elements 30H are aligned in the X direction. The drain electrode 31 of the semiconductor element 30H is joined to the P wiring 421 of the substrate 40. The semiconductor elements 30L are aligned in the X direction. The drain electrode 31 of the semiconductor element 30L is joined to the O wiring 423. The semiconductor elements 30H and 30L are aligned in the Y direction.

The pad 33 of the semiconductor element 30H is electrically connected to the corresponding signal terminal 62 via the signal wiring 425. The pad 33 of the semiconductor element 30L is electrically connected to the corresponding signal terminal 62 via the signal wiring 426. The pad 33 is connected to the corresponding signal terminal 62 via the bonding wire 80.

The P terminal 611, the N terminal 612, and the O terminal 613, which are the main terminals 61, and the signal terminals 62 are inserted into the housing 22. The main terminals 61 and the signal terminals 62 are integrally molded with the housing 22. The main terminals 61 and the signal terminals 62 are each held in the housing 22. The connection portions 611a, 612a, and 613a of the P terminal 611, the N terminal 612, and the O terminal 613 to external devices protrude from the housing 22. The connection portions 611b, 612b, and 613b to the wirings of the substrate 40 protrude from the housing 22. In the signal terminal 62, the connection portion 621 to an external device and the connection portion 622 to the pad 33 protrude from the housing 22.

### <Disposition of Output Terminal>

As illustrated in FIG. 41, FIG. 5, and the like, the O terminal 613 is aligned with the semiconductor element 30L in the Y direction. The O terminal 613 is connected to a central region of the O wiring 423 in a direction (X direction) in which the semiconductor elements 30L are aligned. The O terminal 613 is connected to the O wiring 423 in the vicinity of a center in the X direction. The O terminal 613 is joined to the O wiring 423 in the vicinity of a center of a disposition region of the plurality of semiconductor elements 30L in the X direction. The disposition region of the plurality of semiconductor elements 30L is an imaginary rectangular region connecting outer contours of the plurality of semiconductor elements 30L in a plan view in the Z direction. The O terminal 613 is disposed to overlap with a center position between the second semiconductor element 30L and the third semiconductor element 30L. The O terminal 613 is joined to the terminal connection portion 423c of the extension portion 423b of the O wiring 423 that is continuous with the base portion 423a on which the semiconductor element 30L is mounted.

### <Signal Wiring>

The signal wiring 426 corresponding to the semiconductor element 30L is disposed between the semiconductor element 30L and the signal terminal 62 in the Y direction. The signal wiring 426 extends in the X direction. The signal wiring 426 includes a gate wiring 426G, a Kelvin source wiring 426KS, an anode wiring 426A, and a cathode wiring 426C.

The signal wiring 426 includes a wiring that is divided (segmented) into a plurality of portions by the O terminal 613 and the O wiring 423 (extension portion 423b), that is, a divided wiring. In the example illustrated in FIGS. 41 and 42, the gate wiring 426G and the Kelvin source wiring 426KS are the divided wirings. The gate wiring 426G and the Kelvin source wiring 426KS are divided into two by the O terminal 613 and the O wiring 423. The two gate wirings 426G and the two Kelvin source wirings 426KS are respectively disposed to interpose the O terminal 613 and the O wiring 423 in the X direction.

The gate pad 33G is connected to the nearby gate wiring 426G, among the two gate wirings 426G. The gate pad 33G of two semiconductor elements 30L is connected to one of the gate wirings 426G, and the gate pad 33G of the other two semiconductor elements 30L is connected to the other of the gate wirings 426G. The Kelvin source pad 33KS is connected to the nearby Kelvin source wiring 426KS, among the two Kelvin source wirings 426KS. The Kelvin source pad 33KS of the two semiconductor elements 30L is connected to one of the Kelvin source wirings 426KS, and the Kelvin source pad 33KS of the other two semiconductor elements 30L is connected to the other of the Kelvin source wirings 426KS.

In the example illustrated in FIGS. 41 and 42, among the four semiconductor elements 30L, a temperature of only one at the end portion in the X direction is monitored. Therefore, the anode wiring 426A and the cathode wiring 426C are disposed in the vicinity of the semiconductor element 30L of which temperature is to be monitored. The anode wiring 426A and the cathode wiring 426C are disposed on one side of the O terminal 613 in the X direction. The anode wiring 426A and the cathode wiring 426C are disposed to be aligned with the divided wirings. In the example illustrated in FIG. 41, the anode wiring 426A is aligned with one of the Kelvin source wirings 426KS in the X direction. The cathode wiring 426C is aligned with one of the gate wirings 426G in the X direction.

The anode pad 33A of the semiconductor element 30L disposed at the end portion is connected to the anode wiring 426A via the bonding wire 80. The cathode pad 33C is connected to the cathode wiring 426C via the bonding wire 80. The anode pad 33A and the cathode pad 33C of the other three semiconductor elements 30L are not connected to the anode wiring 426A and cathode wiring 426C. In order to ground a temperature-sensitive diode to the source potential, at least one of the anode pad 33A and the cathode pad 33C is connected to the nearby Kelvin source wiring 426KS. In the example illustrated in FIG. 41, the anode pad 33A is connected to the nearby Kelvin source wiring 426KS.

### <Signal Terminal>

The signal terminal 62 corresponding to the semiconductor element 30L is held by the frame body 221 of the housing 22. The signal terminal 62 is held by the wall portion 221b of the frame body 221 as illustrated in FIG. 3. The signal terminals 62 include the gate terminal 62G, the Kelvin source terminal 62KS, the anode terminal 62A, and the cathode terminal 62C. The semiconductor device 21 includes one gate terminal 62G, one Kelvin source terminal 62KS, one anode terminal 62A, and one cathode terminal 62C, as the signal terminal 62 corresponding to the semiconductor element 30L.

The gate terminal 62G is connected to the gate wiring 426G via the bonding wire 80. The Kelvin source terminal 62KS is connected to the Kelvin source wiring 426KS via the bonding wire 80. The anode terminal 62A is connected to the anode wiring 426A via the bonding wire 80. The cathode terminal 62C is connected to the cathode wiring 426C via the bonding wire 80.

The connection portions 621 of the four signal terminals 62 are disposed together on one side in the X direction relative to the O terminal 613. The four connection portions 621 are disposed on a side of the O terminal 613 in which the anode wiring 426A and the cathode wiring 426C are disposed. The signal terminals 62 include a branch terminal in which the connection portion 622 is divided (segmented) into a plurality of portions by the O terminal 613. In the examples illustrated in FIGS. 41 and 42, the gate terminal 62G and the Kelvin source terminal 62KS are the branch terminals.

The gate terminal 62G has the single (one) connection portion 621, two connection portions 622, and a coupling portion 623. In the present embodiment, the connection portion 621 corresponds to a first connection portion, and the connection portion 622 corresponds to a second connection portion. The two connection portions 622 are disposed to interpose the O terminal 613 in a plan view. The two connection portions 622 are disposed substantially line-symmetrically with respect to the center of the O terminal 613 in the X direction. One of the connection portions 622 is connected to one of the gate wirings 426G, and the other of the connection portions 622 is connected to the other of the gate wirings 426G.

The coupling portion 623 electrically connects the single connection portion 621 and the plurality of connection portions 622. The coupling portion 623 is disposed within the frame body 221 of the housing 22. As illustrated in FIG. 42, the coupling portion 623 may include a coupling portion 623a that connects one of the connection portions 622 to the connection portion 621, and a coupling portion 623b that connects the other of the connection portions 622 to the coupling portion 623a. The coupling portion 623a includes a portion extending in the Z direction. The coupling portion 623b includes a portion extending in the X direction.

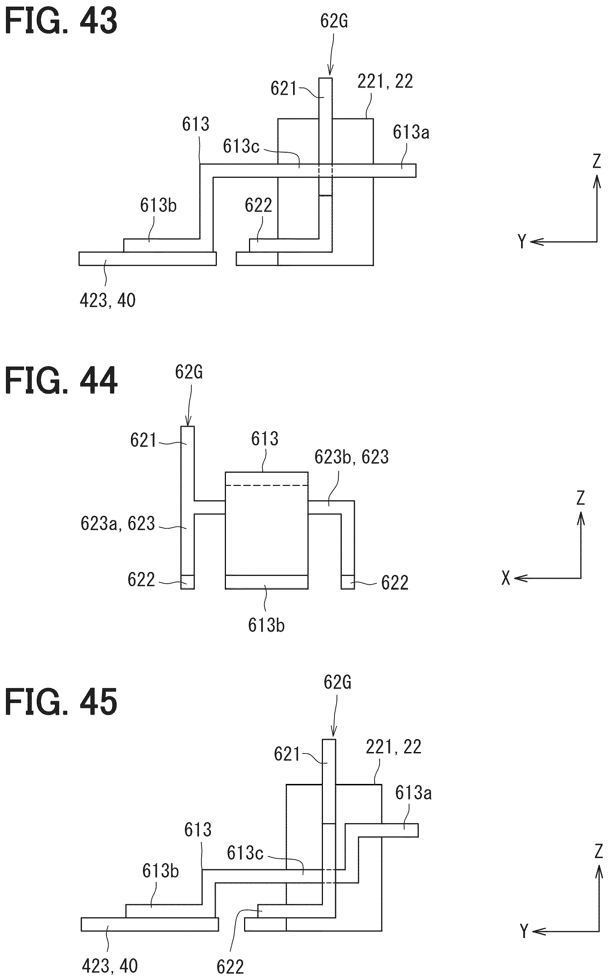

FIGS. 43 and 44 illustrate an example of disposition of the O terminal 613 and the gate terminal 62G which is a branch terminal. FIG. 43 is a plan view seen from the X direction. FIG. 44 is a plan view seen from the Y direction. In FIG. 44, for convenience, the O wiring 423 and the housing 22 are omitted. As illustrated in FIGS. 43 and 44, the coupling portion 623 (coupling portion 623b) that electrically connects the two connection portions 622 may be disposed below the O terminal 613 and may straddle the O terminal 613.

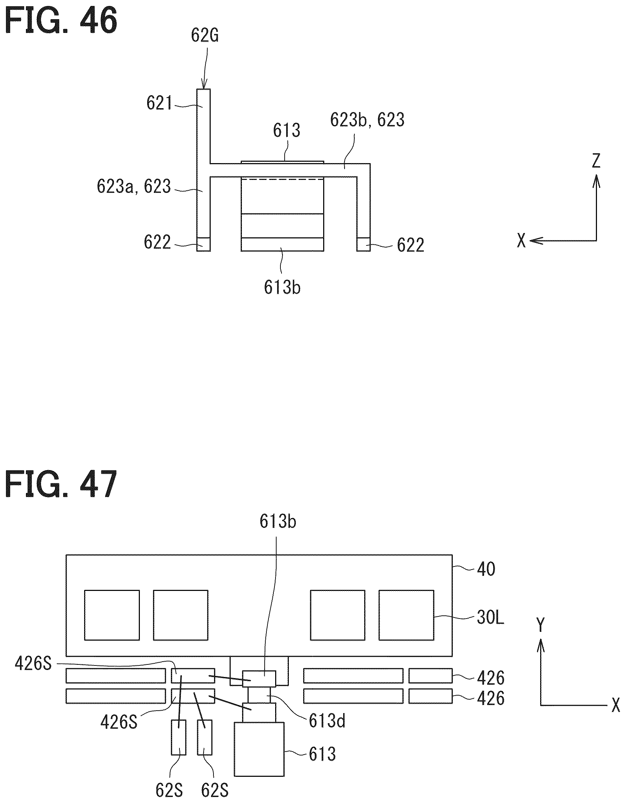

FIGS. 45 and 46 illustrate other examples of the disposition of the O terminal 613 and the gate terminal 62G which is a branch terminal. FIG. 45 corresponds to FIG. 43. FIG. 46 corresponds to FIG. 44. As illustrated in FIGS. 45 and 46, the coupling portion 623 (coupling portion 623b) that electrically connects the two connection portions 622 may be disposed above the O terminal 613 and may straddle the O terminal 613.

The Kelvin source terminal 62KS has a configuration in the same manner as the gate terminal 62G illustrated in FIG. 42. The Kelvin source terminal 62KS has the single connection portion 621, the two connection portions 622, and the coupling portion 623. The coupling portion 623 may include the coupling portion 623a and the coupling portion 623b.

### <Current Sense Integrated Structure>

As illustrated in FIG. 47, a shunt resistor portion 613d for detecting a current may be provided in a part of the O terminal 613. For example, a length, a width, and a thickness of the shunt resistor portion 613d in an extension direction are controlled such that the shunt resistor portion 613d has a predetermined resistance value. The signal wiring 426 includes two sense wirings 426S. The signal terminal 62 includes two sense terminals 62S. One end of the shunt resistor portion 613d is connected to one of the sense terminals 62S via the bonding wire 80 and one of the sense wirings 426S. The other end of the shunt resistor portion 613d is connected to another one of the sense terminals 62S via the bonding wire 80 and another one of the sense wirings 426S. With the above configuration, it is possible to detect a potential difference between both ends of the shunt resistor portion 613d, that is, a current flowing through the shunt resistor portion 613d.

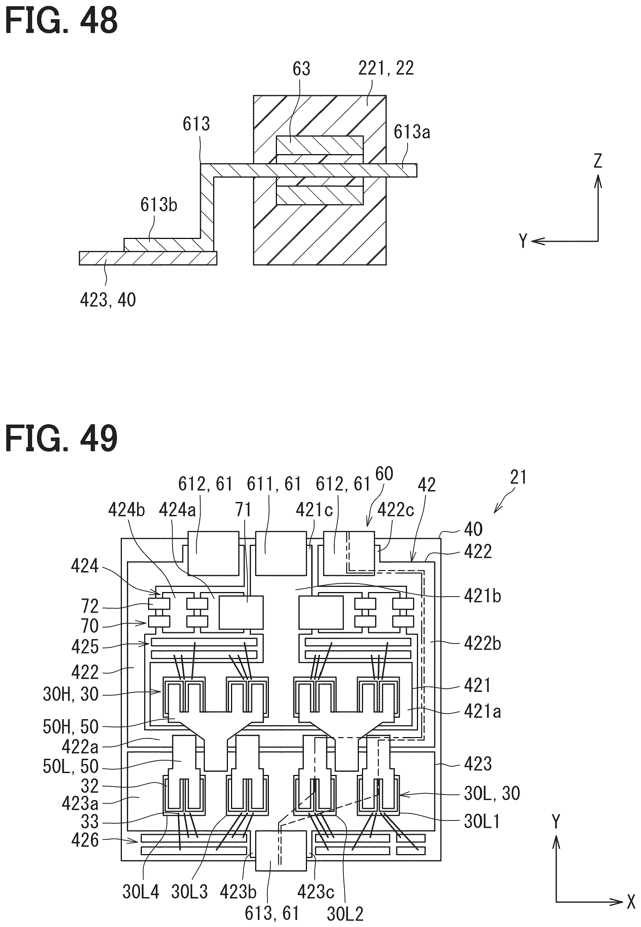

As illustrated in FIG. 48, the semiconductor device 21 may include a core 63 that forms a current sensor. The core 63 is held in the housing 22. The core 63 is inserted into the housing 22. The core 63 is disposed around the coupling portion 613c of the O terminal 613. The current can be detected by measuring a magnitude of a magnetic field generated in the core 63 by the current flowing through the O terminal 613.

### <Summary of Third Embodiment>

The semiconductor device 21 of the present embodiment includes the resin housing 22, the substrate 40, the plurality of semiconductor elements 30 (30L) joined to the wiring of the substrate 40 and connected in parallel, and the signal terminal 62. The signal terminal 62 is inserted into the housing 22. The signal terminal 62 includes the branch terminals. The branch terminals are, for example, the gate terminal 62G and the Kelvin source terminal 62KS. The branch terminal has the single connection portion 621 connected to an external device, a plurality of connection portions 622 individually connected to the pads 33 having the same function of different semiconductor elements 30L, and the coupling portion 623.

In this manner, the plurality of connection portions 622 (second connection portions) and the single connection portion 621 (first connection portion) are electrically connected inside the housing 22. Therefore, with the configuration in which the plurality of semiconductor elements 30L are connected in parallel, contact or breakage of the bonding wires 80 can be suppressed while an increase in the size can be suppressed.

The semiconductor device 21 may include the main terminal 61 (613) that is connected to the wiring on which the semiconductor element 30 (30L) is mounted. The main terminal 61 is aligned with the semiconductor element 30 in the Y direction (second direction) perpendicular to the X direction (first direction) in which the semiconductor elements 30 (30L) are aligned, and is connected to the central region of the wiring in the X direction. In such a configuration, the plurality of connection portions 622 may be disposed to interpose the main terminal 61 in the X direction. Since the main terminal 61 is connected to the central region of the wiring, it is possible to suppress the current from flowing unevenly through some of the semiconductor elements 30. That is, the current imbalance can be suppressed.

When the main terminal 61 is connected to the central region of the wiring, the connection portion 622, which has the same function, must be separated by the main terminal 61. The separated plurality of connection portions 622 are coupled to the single connection portion 621 inside the housing 22 as described above. Therefore, it is possible to suppress the current imbalance and also suppress an increase in the size.

The substrate 40 may have the signal wiring 426 that relays the pad 33 and the signal terminal 62. In a configuration having signal wiring 426, the signal wiring 426 may include a plurality of divided wirings that are provided according to the connection portion 622 and individually connected to the pads 33 that have the same function of different semiconductor elements 30 (30L). The branch terminals are, for example, the gate wiring 426G and the Kelvin source wiring 426KS. The plurality of divided wirings may be located between the semiconductor element 30 and the connection portion 622 in the Y direction and may be disposed to interpose the main terminal 61 (613) in the X direction.

This makes it possible to suppress contact or breaking of the bonding wires 80 in a configuration in which more semiconductor elements 30 are connected in parallel to increase the output of the semiconductor device 21, that is, the semiconductor module 20. Even when signal wiring having the same function is divided, it is electrically connected within the housing 22 via the connection portion 622. Therefore, an increase in size can be suppressed.

In a configuration in which the semiconductor device 21 provides the upper and lower arm circuit 9 and the plurality of semiconductor elements 30H and the plurality of semiconductor elements 30L are disposed to be aligned in the Y direction, the O terminal 613 may be the main terminal 61 that separates the connection portion 622 and the signal wiring 426. The P terminal 611 and the N terminal 612 can be drawn out from one end side in the Y direction, and the O terminal 613 can be drawn out from the other end side. Since the O terminal 613 is connected to the central region of the O wiring 423, it is possible to suppress current imbalance and also suppress an increase in size.

The O terminal 613 may be inserted into the housing 22. The O terminal 613 is held in the housing 22 together with the signal terminal 62. Therefore, the configuration can be simplified. Accuracy of the relative positions of the O terminal 613 and the signal terminal 62 can be improved.

The O terminal 613 may have the shunt resistor portion 613d for current detection. By providing the O terminal 613 with a shunt resistor function, the size can be made smaller than in a configuration in which a current sensor is provided separately.

The semiconductor device 21 may be inserted into the housing 22 and may include the core 63 disposed around the O terminal 613. By providing the core 63 of the current sensor in the housing 22, the size of the device can be made smaller than in a configuration in which the current sensor is provided separately. The accuracy of the relative positions of the O terminal 613 and the core 63 can be improved.

In this example, the branch terminal is applied to the signal terminal 62 corresponding to the semiconductor element 30L, and the divided wiring is applied to the signal wiring 426. However, the branch terminal may be applied to the signal terminal 62 corresponding to the semiconductor element 30H, or the divided wiring may be applied to the signal wiring 425. For example, in a configuration without the snubber circuit 70, the signal terminal 62 corresponding to the semiconductor element 30H may be provided at the wall portion 221a of the frame body 221, and the signal terminal 62 corresponding to the semiconductor element 30H may include the branch terminal.

The configuration described in the present embodiment can be combined with the configuration(s) described in the preceding embodiment(s).

### (Fourth Embodiment)

This embodiment is a modification example of a basic aspect of the preceding embodiment(s), and the description of the preceding embodiment(s) can be incorporated.

### <Semiconductor Device>

FIG. 49 is a plan view illustrating an example of the semiconductor device 21 according to the present embodiment. In FIG. 49, the semiconductor device 21 is illustrated in a simplified form. For convenience, the signal terminal 62 is omitted in FIG. 49. A configuration of the semiconductor device 21 and the semiconductor module 20 has the same manner as the configuration of the preceding embodiment (see, for example, FIGS. 2 to 6). The semiconductor device 21 includes the plurality of semiconductor elements 30, the substrate 40, the clip 50, the external connection terminal 60, and the snubber circuit 70. The semiconductor device 21 may include the sealing body 90 described in the preceding embodiment.

The semiconductor device 21 provides the upper and lower arm circuit 9 for one phase. The plurality of semiconductor elements 30 include the plurality of semiconductor elements 30H that provide the upper arm 9H and the plurality of semiconductor elements 30L that provide the lower arm 9L. The plurality of semiconductor elements 30H are disposed on a common wiring and connected in parallel. The plurality of semiconductor elements 30L are disposed on a common wiring and connected in parallel. The number of the semiconductor elements 30H and the number of the semiconductor elements 30L may be the same or different. In the example illustrated in FIG. 49, the semiconductor device 21 includes four semiconductor elements 30H and four semiconductor elements 30L, respectively. The semiconductor elements 30H are disposed to be aligned in the X direction. The semiconductor elements 30L are also disposed to be aligned in the X direction. The semiconductor elements 30H and 30L are aligned in the Y direction. The semiconductor elements 30H and 30L are disposed at a common interval (pitch).

The external connection terminal 60 has the main terminal 61 and the signal terminal 62 (not illustrated), in the same manner as the preceding embodiment (see FIGS. 3 and 5). The main terminals 61 include the P terminal 611, the N terminal 612, and the O terminal 613. The P terminal 611 and the N terminal 612 are connected to the corresponding conductor 42 at one end portion in the Y direction of the substrate 40, and the O terminal 613 is connected to the corresponding conductor 42 at the other end portion in the Y direction. The semiconductor device 21 has one P terminal 611, one O terminal 613, and two N terminals 612, respectively. Each of the P terminal 611 and the O terminal 613 is connected at a position including substantially a center of the substrate 40 in the X direction. The N terminals 612 are disposed to interpose the P terminal 611 therebetween.

The substrate 40 has the conductor 42 on one surface. The conductor 42 is patterned to have a plurality of wirings. The conductor 42 is patterned in the same manner as in the preceding embodiment (see FIG. 6). The conductor 42 includes the P wiring 421, the N wiring 422, the O wiring 423, the interconnection wiring 424, and the signal wirings 425 and 426. The P wiring 421 has a substantially T shape as a planar shape. The P wiring 421 has the base portion 421a that extends in the X direction and on which the plurality of semiconductor elements 30H are mounted, and the extension portion 421b that extends in the Y direction from the vicinity of a center of the base portion 421a. The terminal connection portion 421c is provided at an end portion of the extension portion 421b.

The N wiring 422 has a substantially C shape (or U shape) as a planar shape. The N wiring 422 has the base portion 422a extending in the X direction and the two extension portions 422b extending substantially in the Y direction from both ends of the base portion 422a. The extension portion 422b is routed to bypass the plurality of semiconductor elements 30H. The extension portion 422b is disposed in the vicinity of an end portion of the substrate 40 in the X direction. The P wiring 421, the interconnection wiring 424, and the signal wiring 425 are disposed between the two extension portions 422b. The terminal connection portions 422c are respectively provided at end portions of the extension portions 422b. The O wiring 423 has a substantially T shape as a planar shape. The O wiring 423 extends in the X direction and has the base portion 423a on which the plurality of semiconductor elements 30L are mounted, and the extension portion 423b that extends in the Y direction from the vicinity of a center of the base portion 423a. The terminal connection portion 423c is provided at an end portion of the extension portion 423b.

The interconnection wiring 424 provides the snubber circuit 70 together with an electronic component such as the capacitor 71. The interconnection wiring 424 electrically bridges the P wiring 421 and the N wiring 422, together with the electronic components of the snubber circuit 70. The interconnection wiring 424 is disposed to interpose the extension portion 421b of the P wiring 421 in the X direction. The interconnection wiring 424 includes the interconnection wirings 424a and 424b. The interconnection wirings 424a and 424b are aligned in the X direction between the extension portion 421b of the P wiring 421 and the extension portion 422b of the N wiring 422.

The signal wiring 425 electrically relays the pad 33 of the semiconductor element 30H and the signal terminal 62. The signal wiring 425 extends in the X direction. The signal wiring 425 is disposed between the extension portion 421b of the P wiring 421 and the extension portion 422b of the N wiring 422 in the X direction. The signal wiring 425 is disposed between the base portion 421a of the P wiring 421 and the interconnection wiring 424 in the Y direction. The signal wiring 426 electrically relays the pad 33 of the semiconductor element 30L and the signal terminal 62. The signal wiring 426 extends in the X direction. The signal wiring 426 is disposed to interpose the extension portion 422b of the O wiring in the X direction. The signal wiring 426 is disposed at one end portion of the substrate 40 in the Y direction.

The clip 50 electrically connects the source electrode 32 of the semiconductor element 30 to the wiring of the substrate 40. The clips 50 include the clip 50H connected to the source electrode 32 of the semiconductor element 30H and the clip 50L connected to the source electrode 32 of the semiconductor element 30L. The semiconductor device 21 includes two clips 50H and four clips 50L. One clip 50H is provided for each pair of adjacent semiconductor elements 30H. The clip 50H has a configuration in the same manner as the configuration of the preceding embodiment (see FIGS. 23 and 24). The clip 50H has a substantially Y shape as a planar shape, with both ends branching into two. The clips 50L are provided individually for the semiconductor elements 30L. The clip 50L has the same configuration as the configuration of the preceding embodiment (see FIGS. 21 to 23). The clip 50L has a substantially I-letter shape as a planar shape, with one end portion branching into two.

The snubber circuit 70 includes the capacitor 71 and the resistor 72. The capacitor 71 bridges the extension portion 421b of the P wiring 421 and the interconnection wiring 424a. A part of the resistor 72 bridges the interconnection wiring 424a and the interconnection wiring 424b. The other part of the resistor 72 bridges the interconnection wiring 424b and the extension portion 422b of the N wiring 422.

### <Heat Reception and Heat Generation>

In FIG. 49, the four semiconductor elements 30L are illustrated as a semiconductor element 30L1, a semiconductor element 30L2, a semiconductor element 30L3, and a semiconductor element 30L4 from one end side in the X direction. The semiconductor element 30L1 is located at an end portion, and has one adjacent semiconductor element 30L. The semiconductor element 30L2 is located in a central region, and has two adjacent semiconductor elements 30L. In the same manner as the semiconductor element 30L2, the semiconductor element 30L3 has two adjacent semiconductor elements 30L. In the same manner as the semiconductor element 30L1, the semiconductor element 30L4 has one adjacent semiconductor element 30L.

The semiconductor element 30L is affected by heat generated by the adjacent semiconductor element 30L. Therefore, the greater the number of adjacent semiconductor elements 30L is, the greater the amount of heat received is. The amount of heat received by the semiconductor elements 30L1 and 30L4 is smaller than the amount of heat received by the semiconductor elements 30L2 and 30L3. The amount of heat received by the semiconductor elements 30L2 and 30L3 is greater than the amount of heat received by the semiconductor elements 30L1 and 30L4.

In the semiconductor device 21 described above, the plurality of semiconductor elements 30L connected in parallel are turned on and off at the same timing. When the semiconductor element 30L is turned on, a current flows through a path of the O terminal 613 → the terminal connection portion 423c of the O wiring 423 → the extension portion 423b → the base portion 423a → the semiconductor element 30L → the clip 50L → the base portion 422a of the N wiring 422 → the extension portion 422b → the terminal connection portion 422c → the N terminal 612.

When the semiconductor element 30L1 is turned on, a current flows through a path indicated by a dashed chain line in FIG. 49. When the semiconductor element 30L2 is turned on, a current flows through a path indicated by a two-dot chain line in FIG. 49. The source electrode 32 of the semiconductor element 30L is connected to the base portion 422a of the N wiring 422 via the clip 50L. The source electrode 32 of the semiconductor element 30L1 is connected to the base portion 422a at a position close to the extension portion 422b in the X direction. The source electrode 32 of the semiconductor element 30L2 is connected to the base portion 422a at a position farther from the extension portion 422b than the semiconductor element 30L1. Therefore, the current path of the semiconductor element 30L1 (dashed chain line) is shorter than the current path of the semiconductor element 30L2 (two-dot chain line). The current path of the semiconductor element 30L2 is longer than the current path of the semiconductor element 30L1.

The two current paths have different lengths at the base portion 422a in which a line width is narrow. The length of the path in the base portion 422a of the semiconductor element 30L2 is more than the length of the path of the semiconductor element 30L1. Therefore, a wiring resistance between the main terminals 612 and 613 is greater in the semiconductor element 30L2 than in the semiconductor element L1. The length of the current path of the semiconductor element 30L2 is more than the length of the current path of the semiconductor element L1. With the semiconductor element 30L1, the current flows more easily than with the semiconductor element L2. With the semiconductor element 30L2, the current flows less easily than with the semiconductor element 30L1. That is, the amount of heat generated by the current flow is greater in the semiconductor element 30L1 than the amount of heat generated by the semiconductor element 30L2.

The semiconductor element 30L4 has the same manner as the semiconductor element 30L1. The semiconductor element 30L3 has the same manner as semiconductor element 30L2.

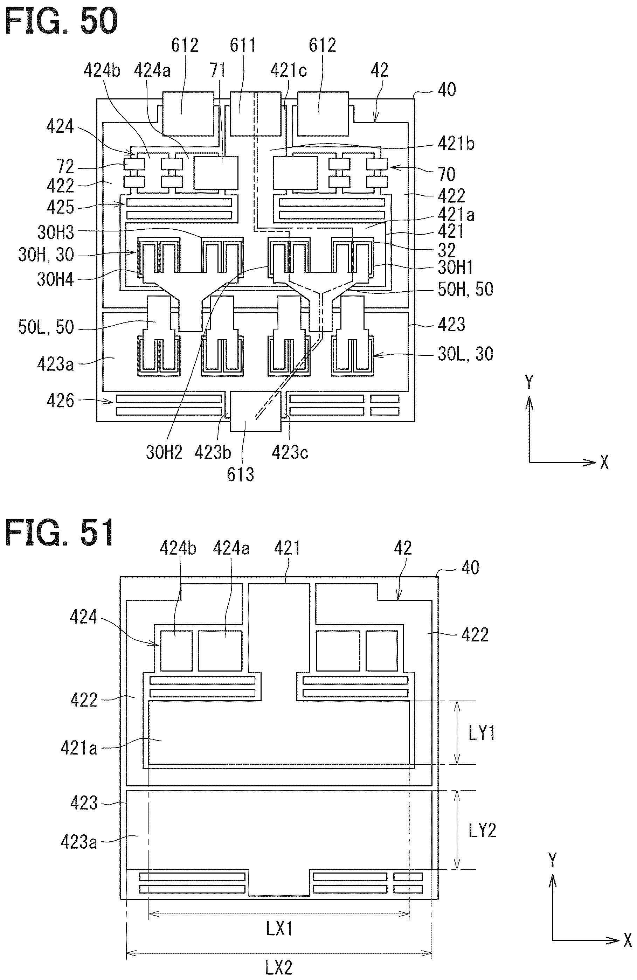

FIG. 50 illustrates a current path on the semiconductor element 30H side. In FIG. 50, the four semiconductor elements 30H are illustrated as a semiconductor element 30H1, a semiconductor element 30H2, a semiconductor element 30H3, and a semiconductor element 30H4 from one end side in the X direction. The semiconductor elements 30H1 and 30H4 are located at end portions, and have one adjacent semiconductor element 30H. The semiconductor elements 30H2 and 30H3 are located in a central region, and have two adjacent semiconductor elements 30L. The semiconductor element 30 is also affected by heat generated by the adjacent semiconductor element 30H. Therefore, the greater the number of adjacent semiconductor elements 30H is, the greater the amount of heat received is. The amount of heat received by the semiconductor elements 30H1 and 30H4 is smaller than the amount of heat received by the semiconductor elements 30H2 and 30H3. The amount of heat received by the semiconductor elements 30H2 and 30H3 is greater than the amount of heat received by the semiconductor elements 30H1 and 30H4.

In the semiconductor device 21 described above, the plurality of semiconductor elements 30H connected in parallel are turned on and off at the same timing. When the semiconductor element 30H is turned on, a current flows through a path of the P terminal 611 → the terminal connection portion 421c of the P wiring 421 → the extension portion 421b → the base portion 421a → the semiconductor element 30H → the clip 50H → the base portion 423a of the O wiring 423 → the extension portion 423b → the terminal connection portion 423c → the O terminal 613.

When the semiconductor element 30H2 is turned on, a current flows through a path indicated by a dashed chain line in FIG. 50. When the semiconductor element 30H1 is turned on, a current flows through a path indicated by a two-dot chain line in FIG. 50. The source electrode 32 of the semiconductor element 30H is connected to the base portion 423a of the O wiring 423 via the clip 50H. The drain electrode 31 of the semiconductor element 30H2 is connected to the base portion 421a at a position close to the coupling portion between the extension portion 421b and the base portion 421a. The drain electrode 31 of the semiconductor element 30H1 is connected to the base portion 421a at a position farther from the coupling portion than the semiconductor element 30H2. The current path (dashed chain line) of the semiconductor element 30H2 is shorter than the current path (two-dot chain line) of the semiconductor element 30H1. The current path of semiconductor element 30H1 is longer than the current path of semiconductor element 30H2.

In the base portion 421a, the current flows through a region between a mounting position of the semiconductor element 30H and an end portion on the P terminal 611 side. This region is small. The two current paths have different lengths in the base portion 421a. The length of the path in the base portion 421a of the semiconductor element 30H1 is more than the length of the path of the semiconductor element 30H2. Therefore, a wiring resistance between the main terminals 611 and 613 is greater in the semiconductor element 30H1 than in the semiconductor element H2. The length of the current path of the semiconductor element 30H1 is more than the length of the current path of the semiconductor element H2. With the semiconductor element 30H2, the current flows more easily than with the semiconductor element H1. With the semiconductor element 30H1, the current flows less easily than with the semiconductor element 30H2. That is, the amount of heat generated by the current flow is greater in the semiconductor element 30H2 than the amount of heat generated by the semiconductor element 30H1.

The semiconductor element 30H4 has the same manner as the semiconductor element 30H1. The semiconductor element 30H3 has the same manner as the semiconductor element 30H2.

As described above, the current is likely to flow through the semiconductor elements 30L1 and 30L4 located at both ends of the semiconductor element 30L, and the current is likely to flow through the semiconductor elements 30H2 and 30H3 located in the central region of the semiconductor element 30H.

### <Clip>

Semiconductor elements having different numbers of adjacent semiconductor elements and/or semiconductor elements having different current path lengths between a main electrode and a main terminal may be electrically connected by a metal plate.

In the example illustrated in FIG. 50, the semiconductor element 30H1 and the semiconductor element 30H2 are electrically connected by the common clip 50H. The semiconductor element 30H3 and the semiconductor element 30H4 are electrically connected by the common clip 50H.

As described above, the semiconductor elements 30H1 and 30H4 have one adjacent semiconductor element 30H. The semiconductor elements 30H2 and 30H3 have two adjacent semiconductor elements 30H. Therefore, the semiconductor elements 30H1 and 30H4 and the semiconductor elements 30H2 and 30H3 receive different amounts of heat.

In FIG. 50, the source electrode 32 of the semiconductor element 30H1 having the one adjacent semiconductor element 30H and the source electrode 32 of the semiconductor element 30H2 having the two adjacent semiconductor elements 30 are connected by the common clip 50H. The source electrode 32 of the semiconductor element 30H3 having the two adjacent semiconductor elements 30H and the source electrode 32 of the semiconductor element 30H1 having the one adjacent semiconductor element 30 are connected by the common clip 50H.

In the semiconductor elements 30H1 and 30H4, a current path length from the P terminal 611 to the drain electrode 31 is long. In the semiconductor elements 30H2 and 30H3, the current path length from the P terminal 611 to the drain electrode 31 is short. The semiconductor elements 30H1 and 30H4 and the semiconductor elements 30H2 and 30H3 have different current path lengths. In the semiconductor elements 30H1 and 30H4 and the semiconductor elements 30H2 and 30H3, the ease with which the current flows differs, that is, the amount of heat generated differs.

In FIG. 50, the source electrode 32 of the semiconductor element 30H1 having a long current path length and the source electrode 32 of the semiconductor element 30H2 having a short current path length are connected by the common clip 50H. The source electrode 32 of the semiconductor element 30H3 having a short current path length and the source electrode 32 of the semiconductor element 30H1 having a long current path length are connected by the common clip 50H.

### <Substrate>

On the substrate 40, the conductors 42 can be in a variety of patterns. An area of a first conductor, which is a mounting portion on which a semiconductor element is mounted, may be different between the semiconductor element 30H, which is an upper arm element, and the semiconductor element 30L, which is a lower arm element. In such a configuration in which the areas of the first conductors are different, a second conductor on which the semiconductor element 30 is not mounted may be disposed near the first conductor with the smaller area.

FIG. 51 illustrates an example of the substrate 40 in the semiconductor device 21. In FIG. 51, a conductor pattern is illustrated in a simplified form. The conductor 42 illustrated in FIG. 51 has the same configuration as the configuration illustrated in the preceding embodiment (see FIG. 6) and the configuration illustrated in FIG. 49. The P wiring 421 has the base portion 421a on which the plurality of semiconductor elements 30H are disposed. The O wiring 423 has the base portion 423a on which the plurality of semiconductor elements 30L are disposed. The base portions 421a and 423a correspond to a first conductor. The interconnection wiring 424 is a conductor on which the semiconductor element 30, which is a heating element, is not mounted. The interconnection wiring 424 corresponds to a second conductor. The interconnection wiring 424 is provided with an electronic component that forms the snubber circuit 70, such as the capacitor 71 or the resistor 72.

The base portion 421a has a smaller area than the base portion 423a. A length LX1 of the base portion 421a in the X direction is less than a length LX2 of the base portion 423a in the X direction. The length LY1 of the base portion 421a in the Y direction is less than the length LY2 of the base portion 423a in the Y direction. The interconnection wiring 424 is disposed closer to the base portion 421a, which has the smaller area, of the base portions 421a and 423a. The base portion 421a is disposed between the interconnection wiring 424 and the base portion 423a in the Y direction.

The semiconductor element 30, which is the heating element as described above, is mounted on the first conductor. Therefore, the first conductor may be formed using a highly thermal-conductive material that has better thermal conductivity than the other portions of the conductor 42 including the second conductor.

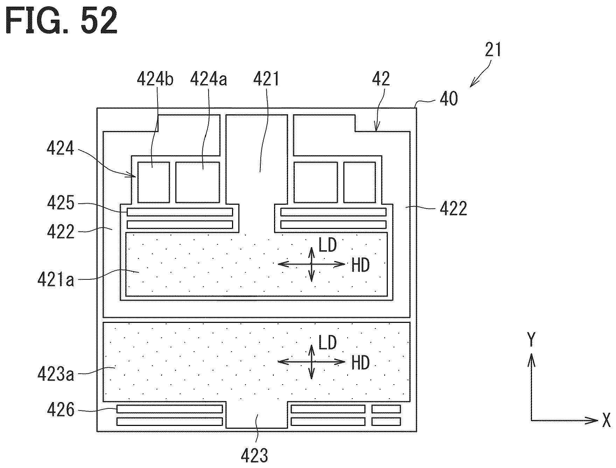

FIG. 52 illustrates another example of the substrate 40. A pattern of the conductor 42 has the same manner as the pattern illustrated in FIG. 51. The base portion 421a of the P wiring 421 is formed of a highly thermal-conductive material. The base portion 423a of the O wiring 423 is also formed using a highly thermal-conductive material. The highly thermal-conductive material is, for example, a copper graphite (CuGr) material. The other wirings including the interconnection wiring 424 are formed using a material with lower thermal conductivity than the highly thermal-conductive material, for example, Cu. In FIG. 52, the base portions 421a and 423a are hatched for distinction. The Cu material and the CuGr material are disposed on the common insulating base material 41.

The highly thermal-conductive material may be an anisotropic highly thermal-conductive material. The highly thermal-conductive material may be disposed such that a direction of high thermal conductivity substantially coincides with a direction in which the plurality of semiconductor elements 30 are aligned. FIG. 52 illustrates a high thermal conductivity (HD) direction and a low thermal conductivity (LD) direction of the highly thermal-conductive material. The highly thermal-conductive material is disposed such that the HD direction is substantially parallel to the X direction and the LD direction is substantially parallel to the Y direction.

### <Temperature Monitoring>

As described above, in a configuration in which the semiconductor device 21 includes the plurality of semiconductor elements 30, a temperature of only one semiconductor element 30 may be output. For example, as illustrated in FIG. 49, a configuration may be adopted in which only a temperature of the semiconductor element 30L1 is output. As illustrated in the preceding embodiment (see FIG. 18), the semiconductor element 30 includes the gate pad 33G, the Kelvin source pad 33KS, the anode pad 33A, and the cathode pad 33C. The anode pad 33A and the cathode pad 33C are connected to a temperature-sensitive diode included in the semiconductor element 30.

The anode pad 33A of the semiconductor element 30L1 is connected to the signal wiring 426 for the anode. The cathode pad 33C of the semiconductor element 30L1 is connected to the signal wiring 426 for the cathode. The anode pad 33A and the cathode pad 33C of the semiconductor element 30L1 are connected to the corresponding signal terminal 62 via signal wiring 426, in the same manner as in the preceding embodiment (see FIGS. 41 and 42). The anode pad 33A and the cathode pad 33C of the other semiconductor element 30 are not connected to the signal terminal 62. For example, the anode pad 33A is connected to the signal wiring 425 and 426 for the Kelvin source.

In FIG. 49, a configuration is provided in which a temperature of the semiconductor element 30L1 located at the end portion in the X direction and at the end portion in the Y direction is output. Alternatively, a temperature of the semiconductor element 30L4 may be output. A temperature of either the semiconductor element 30L2 or 30L3 may be output. Among the plurality of semiconductor elements 30H, the semiconductor elements 30H2 and 30H3 disposed in the central region receive a large amount of heat and allow a current to flow easily. Therefore, the temperature of either the semiconductor element 30H2 or 30H3 may be output. The temperature of either one of the semiconductor elements 30H1 and 30H4 located at the end portion in the X direction may be output.

### <Summary of Fourth Embodiment>

The semiconductor device 21 may include the substrate 40, the plurality of semiconductor elements 30 disposed on one surface of the substrate 40 and connected in parallel to one another, and the main terminal 61 common to the main electrodes of the plurality of semiconductor elements 30. The wiring resistance between the main terminal 61 and the main electrode may vary depending on the number of adjacent semiconductor elements 30, and the wiring resistance may be greater as the number of adjacent semiconductor elements 30 is increased.

As described above, among the plurality of semiconductor elements 30 connected in parallel, the semiconductor element 30 having a large number of adjacent semiconductor elements 30 receives a large amount of heat. In the semiconductor element 30 in which the wiring resistance between the main terminal 61 and the main electrode is large, the amount of heat generated by the current flow is small since the current does not easily flow. When the wiring resistance is increased as the number of adjacent semiconductor elements 30 is increased, heat generation from semiconductor elements 30 with a large number of adjacent semiconductor elements 30 can be suppressed. This allows the total amounts of heat received and generated to be close to each other in the plurality of semiconductor elements 30. Therefore, the thermal variations among the plurality of semiconductor elements 30 can be suppressed. That is, a temperature deviation can be suppressed.

Since the local temperature increase can be suppressed, it is possible to suppress the temperature of some of the semiconductor elements 30 from exceeding an allowable upper limit temperature and the decrease of the output of the semiconductor device 21. Since the disposition of the plurality of semiconductor elements 30 connected in parallel is not limited to a staggered pattern, the degree of freedom in disposition can be improved. Since it is not necessary to arrange in a staggered pattern, an increase in size can be suppressed.

The substrate 40 may have a common wiring to which the main terminals 61 are joined and to which the main electrodes of the plurality of semiconductor elements 30 are connected. This wiring may be routed such that the length from the joint portion of the main terminal 61 to the electrical connection portion of the main electrode increases as the number of adjacent semiconductor elements 30 increases. In this manner, by using common wiring and varying the positions of the connection portions of the main electrodes in the wiring, it is possible to vary the current path length, that is, the wiring resistance. With a simple configuration, the thermal variation can be suppressed.

The semiconductor device 21 may provide the upper and lower arm circuit 9. The semiconductor device 21 may include the plurality of semiconductor elements 30H (second semiconductor elements) disposed to be aligned in the X direction (first direction) and connected in parallel to each other, and the plurality of semiconductor elements 30L (first semiconductor elements) aligned in the X direction and connected in parallel to each other. The semiconductor element 30H may be disposed between the N terminal 612 (main terminal 61) and the semiconductor element 30L in the Y direction (second direction), and the N wiring 422 may be routed to bypass the plurality of semiconductor elements 30H. Therefore, among the plurality of semiconductor elements 30L disposed to be aligned in the X direction, the wiring resistance of the semiconductor elements 30L2 and 30L3, which have a large number of adjacent semiconductor elements 30L, can be increased. The wiring resistance of the semiconductor elements 30L1 and 30L4, which have a small number of adjacent semiconductor elements 30L, can be reduced. Therefore, the thermal variations can be suppressed with a simple configuration.

The semiconductor elements 30H and 30L may be provided in equal numbers. The positions of semiconductor elements 30L1 and 30L4, through which current flows easily, among the plurality of semiconductor elements 30L (first semiconductor elements), and the positions of semiconductor elements 30H2 and 30H3, through which current flows easily, among the plurality of semiconductor elements 30H (second semiconductor elements), may be configured to be offset from each other in the X direction (first direction). Among the plurality of semiconductor elements 30 forming the upper and lower arm circuit 9, the semiconductor elements 30 that generate a large amount of heat when energized are dispersedly disposed. Therefore, it is possible to suppress thermal variations in the plurality of semiconductor elements 30 that form the upper and lower arm circuit 9.

As illustrated in FIG. 49, the semiconductor elements 30L that provide the lower arm 9L may be configured such that the wiring resistance increases as the number of adjacent semiconductor elements 30L increases. Although not illustrated, the semiconductor elements 30H that provide the upper arm 9H may be configured such that the wiring resistance is increased as the number of adjacent semiconductor elements 30H is increased. The semiconductor device 21 is not limited to the configuration that provides the upper and lower arm circuit 9. The present disclosure can also be applied to the semiconductor device 21 that provides one arm. In the plurality of semiconductor elements 30 connected in parallel to provide one arm, the wiring resistance may be increased as the number of adjacent semiconductor elements 30 is increased.

The semiconductor device 21 may include the substrate 40, the plurality of semiconductor elements 30 disposed on one surface of the substrate 40 and connected in parallel, the main terminal 61 that is a common connection target for the main electrodes of the plurality of semiconductor elements 30, and the clip 50 that is a metal plate. The clip 50 may electrically connect the semiconductor elements 30 having different numbers of adjacent semiconductor elements 30 and/or the semiconductor elements 30 having different current path lengths between the main electrodes and the main terminals 61.

For example, as illustrated in FIG. 50, among the plurality of semiconductor elements 30H connected in parallel, the source electrodes 32 of the semiconductor elements 30H1 and 30H2 having different numbers of adjacent semiconductor elements 30H may be connected by the clip 50H. The source electrodes 32 of the adjacent semiconductor elements 30H3 and 30H4 having different numbers of semiconductor elements 30H may be connected by the clip 50H. Among the plurality of semiconductor elements 30H connected in parallel, the source electrodes 32 of the semiconductor elements 30H1 and 30H2 having the different current path lengths may be connected by the clip 50H. The source electrodes 32 of the semiconductor elements 30H3 and 30H4 having the different current path lengths may be connected by the clip 50H.

As described above, the semiconductor element 30 having a large number of adjacent semiconductor elements 30 receives a large amount of heat, and the semiconductor element 30 having a small number of adjacent semiconductor elements 30 receives a small amount of heat. The current does not easily flow through the semiconductor element 30 having a long current path length between the main electrode and the main terminal 61, and the current easily flows through the semiconductor element 30 having a short current path length. Therefore, by connecting the semiconductor elements 30 having the different numbers of adjacent semiconductor elements 30 and therefore different amounts of heat received, with clips 50, heat transfer via the clips 50 can suppress the thermal variations. By connecting the semiconductor elements 30 having different amounts of heat generated due to different current path lengths, with a metal plate, it is possible to suppress the thermal variations. Therefore, the thermal variations among the plurality of semiconductor elements 30 can be suppressed. For example, it is possible to suppress a decrease in output.

The metal plate connecting the source electrodes is not limited to the clip 50. The metal plate may also be a lead. The semiconductor element 30 is not limited to the semiconductor element 30H. Although not illustrated in the drawings, the present disclosure can also be applied to the plurality of semiconductor elements 30L connected in parallel. The semiconductor device 21 is not limited to the configuration that provides the upper and lower arm circuit 9. The present disclosure can also be applied to the semiconductor device 21 that provides one arm. In the plurality of semiconductor elements 30 connected in parallel and providing one of the arms, the source electrodes 32 may be electrically connected by the clip 50.

The semiconductor device 21 may include the substrate 40 and the plurality of semiconductor elements 30 disposed on one surface of the substrate 40, and the semiconductor elements 30 may include the semiconductor element 30H that is an upper arm element and the semiconductor element 30L that is a lower arm element. The conductor 42 of the substrate 40 may include the base portions 421a and 423a (first conductors) on which the semiconductor element 30 is mounted, and the interconnection wiring 424 (second conductor) on which the semiconductor element 30 is not mounted. The interconnection wiring 424 may be disposed near the base portion 421a, which has a smaller area than the base portion 423a.

Since the small-area base portion 421a is disposed near the interconnection wiring 424, heat from the semiconductor element 30H mounted on the small-area base portion 421a can be released to the interconnection wiring 424 side. Even when the area of the base portion 421a is small, by using the interconnection wiring 424, the heat from the semiconductor element 30H can be released. The base portion 423a, which is located apart from the interconnection wiring 424, has a larger area, and therefore functions better as a thermal mass than the base portion 421a, and has a larger heat dissipation area. The heat from the semiconductor element 30L can be released via the base portion 423a. Therefore, it is possible to suppress thermal variations in the plurality of semiconductor elements 30 that form the upper and lower arm circuit 9. For example, it is possible to suppress a decrease in output.

Although the semiconductor element 30, which is a heating element, is not mounted, the interconnection wiring 424 that provides the wiring function is used, and the base portion 421a is made smaller accordingly. Therefore, it is possible to reduce the size of the substrate 40, that is, the semiconductor device 21.

A configuration may be adopted in which the snubber circuit 70 including the capacitor 71 is provided and the capacitor 71 is disposed on the interconnection wiring 424. The wiring that forms the snubber circuit 70, particularly the wiring on which the capacitor 71 is disposed, requires a relatively large area. The second conductor (interconnection wiring 424) can be utilized as a mounting conductor for the capacitor 71, while allowing heat to be released from the semiconductor element 30 mounted on the base portion 421a having a small area.

The base portions 421a and 423a which are the first conductors may be formed using a highly thermal-conductive material that has better thermal conductivity than the material forming the other conductors 42 including the second conductor. By using a highly thermal-conductive material only for the base portions 421a and 423a on which the semiconductor element 30, which is a heating element, is mounted, it is possible to improve heat dissipation while suppressing an increase in costs.

The semiconductor device 21 may include the plurality of semiconductor elements 30H disposed to be aligned in the X direction, and the plurality of semiconductor elements 30L similarly disposed to be aligned in the X direction. The highly thermal-conductive material may be a highly thermal-conductive material having anisotropic thermal conductivity. The highly thermal-conductive material may be provided such that the direction of high thermal conductivity of the highly thermal-conductive material coincides with the X direction, which is a direction in which the semiconductor elements 30H and 30L are aligned. The heat of the semiconductor elements 30H and 30L is mainly conducted in the X direction at the base portions 421a and 423a, and is not easily conducted in the Y direction. Even when the length of the base portions 421a and 423a in the Y direction is shortened, heat dissipation can be ensured. Therefore, the size of the substrate 40, that is, the semiconductor device 21, can be reduced.

In a configuration in which the semiconductor device 21 includes the plurality of semiconductor elements 30, the temperature of only one of the plurality of semiconductor elements 30 may be output. A deterioration of the semiconductor device 21 can be detected with the minimum of temperature monitoring. The deterioration can be detected while reducing costs. For example, as illustrated in FIG. 49, a configuration may be adopted in which only the temperature of the semiconductor element 30L1 is output. The semiconductor element 30L1 is located in the vicinity of the end portion of the substrate 40 in the X direction and in the Y direction. The bonding material 24 (solder) that joins the substrate 40 to the cooler 23 cracks from the outer peripheral portion of the substrate 40 and deteriorates. As described above, the current flows easily through the semiconductor element 30L1. The semiconductor element 30L1 is likely to generate heat. By detecting the temperature of the semiconductor element 30L1, the deterioration of the semiconductor device 21 can be detected more effectively with the minimum of temperature monitoring.

The configuration described in the present embodiment can be combined with the configuration(s) described in the preceding embodiment(s).

### (Fifth Embodiment)

This embodiment is a modification example of a basic aspect of the preceding embodiment(s), and the description of the preceding embodiment(s) can be incorporated.

### <Semiconductor Module>

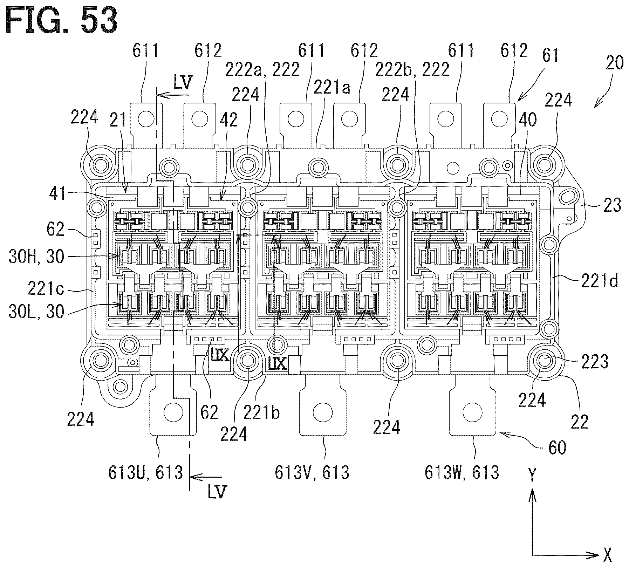

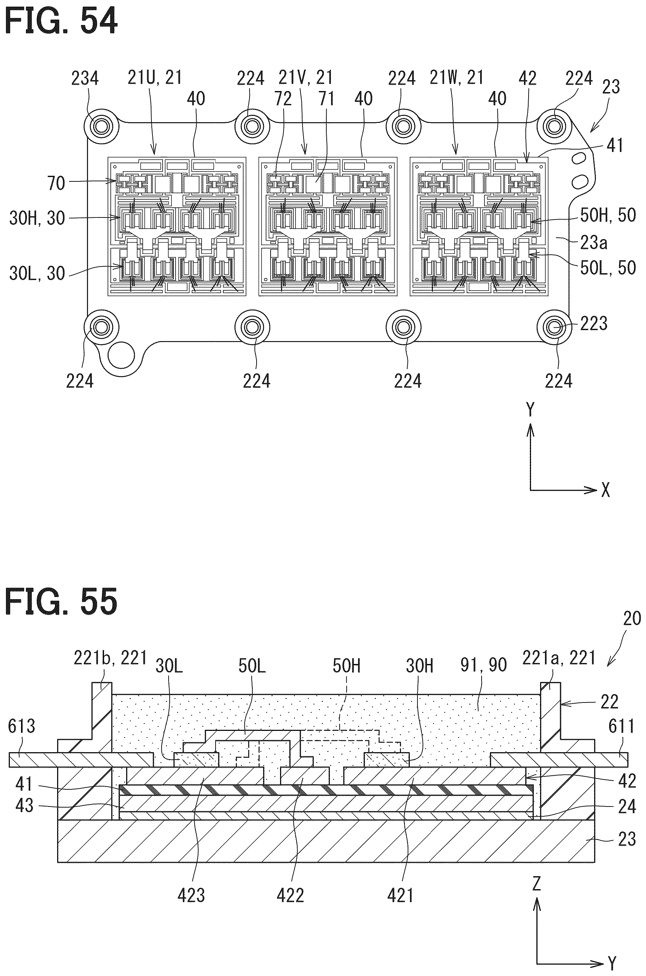

FIG. 53 is a plan view illustrating an example of the semiconductor module 20 according to the present embodiment. FIG. 54 is a plan view illustrating a configuration of the semiconductor module 20 excluding the housing 22, that is, illustrating a state in which the semiconductor device 21 is disposed on the cooler 23. For convenience, the sealing body is not illustrated in FIGS. 53 and 54. FIG. 55 is a cross-sectional view taken along a line LV-LV illustrated in FIG. 53. In FIG. 55, the semiconductor module 20 is illustrated in a simplified form.

As illustrated in FIGS. 53 to 55, a basic configuration of the semiconductor module 20 and the semiconductor device 21 has the same manner as the configuration illustrated in the preceding embodiment (see FIGS. 2 to 6). The semiconductor module 20 includes the semiconductor device 21, the housing 22, and the cooler 23. The semiconductor device 21 and the housing 22 are disposed on one surface 23a of the cooler 23.

The semiconductor device 21 includes the semiconductor element 30, the substrate 40, and the external connection terminal 60, in the same manner as the configuration illustrated in the preceding embodiment. The external connection terminals 60 include the main terminal 61 and the signal terminal 62. The external connection terminal 60 is inserted into the housing 22. The P terminal 611, the N terminal 612, and the O terminal 613, which are the main terminals 61, are joined to the corresponding wirings of the conductor 42, in the same manner as in the preceding embodiment.

The semiconductor device 21 includes the sealing body 90, in the same manner as the configuration illustrated in the preceding embodiment (see FIG. 20). The sealing body 90 seals the other elements of the semiconductor device 21. The sealing body 90 seals a portion of the semiconductor device 21, which is exposed to a housing space. The sealing body 90 is filled up to a predetermined position lower than the upper end of the housing 22. The sealing body 90 may be provided in the semiconductor device 21 or in the semiconductor module 20. As illustrated in FIG. 55, the gel 91 may be provided as the sealing body 90, or a sealing body made of resin may be provided.

The semiconductor device 21 may further include the clip 50. The semiconductor device 21 may further include the snubber circuit 70. As illustrated in FIGS. 53 to 55, the semiconductor device 21 may include the clip 50 and the snubber circuit 70.

The semiconductor device 21 forms a power converter. The semiconductor device 21 may provide one arm. As illustrated in FIGS. 53 to 55, the semiconductor device 21 may provide the upper and lower arm circuit 9 for one phase. The semiconductor module 20 may include three semiconductor devices 21 providing the upper and lower arm circuit 9 for one phase. The three semiconductor devices 21, that is, the three substrates 40, may be disposed to be aligned in the X direction. The substrate 40 may be fixed to the cooler 23 via the bonding material 24 such as solder.

The cooler 23 may have a configuration including the flow path 231 as illustrated in the preceding embodiment (see FIG. 4). The cooler 23 may be a heat dissipation member such as a heat sink. The heat dissipation member may include a heat dissipation fin. The semiconductor module 20 may have fastening holes 233 that penetrate the cooler 23 as illustrated in FIG. 54. The semiconductor module 20 may be provided with a collar 234, which provides the fastening holes 233, integral with the cooler 23. The collar 234 is a cylinder surface pressure buffer member formed of a highly rigid material. The collar 234 is a metal member. The cooler 23 may be provided with a plurality of fastening holes 233. As illustrated in FIG. 54, the collar 234 may be provided at an outer peripheral edge of the one surface 23a having a substantially rectangular planar shape. Some of the collars 234 may be provided at four corners, and the others of the collars 234 may be provided at positions between the substrates 40 in the direction in which the substrates 40 are aligned (X direction).

### <Housing>

The housing 22 includes the frame body 221. The frame body 221 is fixed to the cooler 23. The frame body 221 provides a housing space together with the cooler 23. The frame body 221 has the wall portions 221a, 221b, 221c, and 221d. The P terminal 611 and the N terminal 612 are held on the wall portion 221a. The wall portion 221b holds the O terminals 613 (613U, 613V, and 613W). The semiconductor device 21 is disposed in the housing space. The housing space is filled with the sealing body 90.

The frame body 221 is fixed to the cooler 23. The frame body 221 provides a housing space together with the cooler 23. The frame body 221 has the wall portions 221a, 221b, 221c, and 221d. The P terminal 611 and the N terminal 612 are held on the wall portion 221a. The wall portion 221b holds the O terminals 613 (613U, 613V, and 613W). The semiconductor device 21 is disposed in the housing space. The housing space is filled with the sealing body 90.

The semiconductor module 20 may have a fastening hole 223 that penetrates the housing 22, as illustrated in FIG. 53. The fastening hole 223 is provided corresponding to the fastening hole 233. The housing 22 and the cooler 23, that is, the semiconductor device 21 is fastened and fixed to a case of a power converter (not illustrated), by bolts inserted through, for example, the fastening holes 223 and 233.

The semiconductor module 20 may include a collar 224 integral with the housing 22 that provides the fastening hole 223. The collar 224 is a metal member. The collar 224 is a cylinder surface pressure buffer member formed of a highly rigid material. The collar 224 is inserted into the housing 22. The semiconductor module 20 may include a plurality of fastening holes 223. As illustrated in FIG. 53, the collar 224 may be provided at the frame body 221 having a substantially rectangular loop shape as a planar shape. Some of the collars 224 may be provided at the four corners of the frame body 221, and the others of the collars 224 may be provided at positions between the substrates 40 in a direction in which the substrates 40 are aligned (X direction).

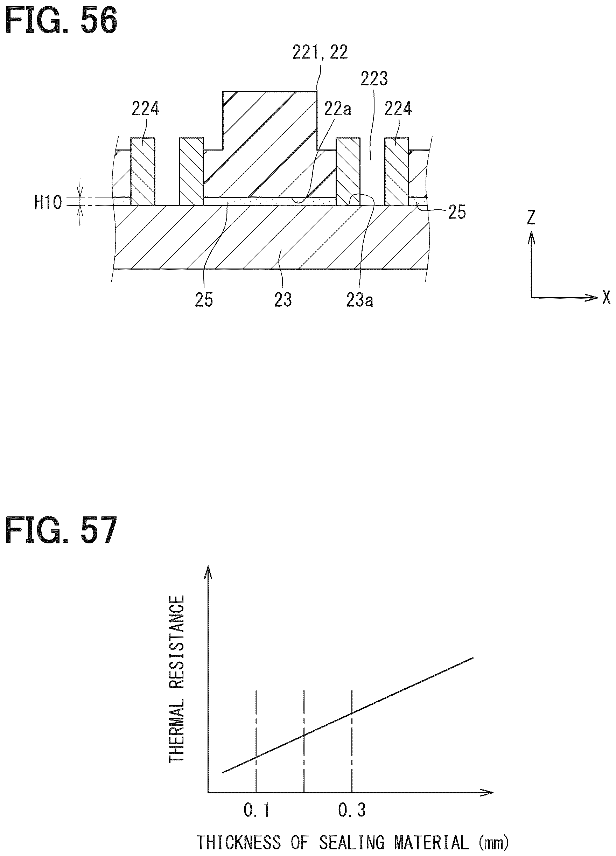

FIG. 56 is a cross-sectional view illustrating a periphery of the collar 224. FIG. 56 illustrates a connection structure between the housing 22 and the cooler 23. In FIG. 56, for convenience, the collar 234 on the cooler 23 side is omitted. As illustrated in FIG. 56, the collar 224 may protrude a predetermined amount from the lower surface 22a of the housing 22 toward the cooler 23 and contact the one surface 23a. That is, the collar 224 may be in contact with the one surface 23a of the cooler 23, and the housing 22 (for example, the frame body 221) may not be in contact with the one surface 23a. The lower surface 22a faces the one surface 23a of the cooler 23.

The collar 224 ensures a gap (space) of a predetermined height H10 between the lower surface 22a of the housing 22 and the one surface 23a of the cooler 23. The sealing material 25 is disposed in this gap. The sealing material 25 is interposed between the lower surface 22a of the housing 22 and the one surface 23a of the cooler 23. The sealing material 25 has an adhesive function. The sealing material 25 fixes the housing 22 to the cooler 23. The sealing material 25 has a sealing function. The sealing material 25 provides a liquid-tight seal between the lower surface 22a and the one surface 23a. The sealing material 25 suppresses the sealing body 90 from leaking from the housing space. A thickness of the sealing material 25 is controlled by the amount of protrusion of the collar 224. The thickness of the sealing material 25 is substantially equal to the height H10.

FIG. 57 is a diagram illustrating a relationship between the sealing material 25 and a thermal resistance. As illustrated in FIG. 57, the thicker the sealing material 25 is, the greater the thermal resistance is. When the film thickness of the sealing material 25 is less than 0.1 mm, the amount of protrusion of the collar 224 is small, and there is a risk that the sealing body 90 will rest on the seating surface. A manufacturing tolerance is ±0.1 mm. From the above, the thickness of the sealing material 25, that is, the amount of protrusion of the collar 224 from the lower surface 22a, may be set within the range of 0.1 mm or more and 0.3 mm or less.

As illustrated in FIG. 53, the housing 22 may include the partition wall 222 in addition to the frame body 221. The partition wall 222 partitions the housing space according to the substrate 40. In the example illustrated in FIG. 53, the housing 22 has two partition walls 222 that divide the housing space into three. The partition walls 222 divide the housing space into equal numbers of the substrates 40 in the X direction, which is a direction in which the substrates 40 are aligned. The partition wall 222 extends in the Y direction perpendicular to a direction in which the substrates 40 are aligned, and both ends thereof are continuous with the wall portions 221a and 221b of the frame body 221.

The partition wall 222 is provided at a position between the adjacent substrates 40 in a direction in which the substrates 40 are aligned. The partition wall 222a is provided between the substrate 40 forming the semiconductor device 21 of the U-phase and the substrate 40 forming the semiconductor device 21 of the V-phase. The partition wall 222b is provided between the substrate 40 forming the semiconductor device 21 of the V-phase and the substrate 40 forming the semiconductor device 21 of the W-phase. The substrates 40, that is, the semiconductor devices 21 for each phase, are disposed individually in the three divided housing spaces.

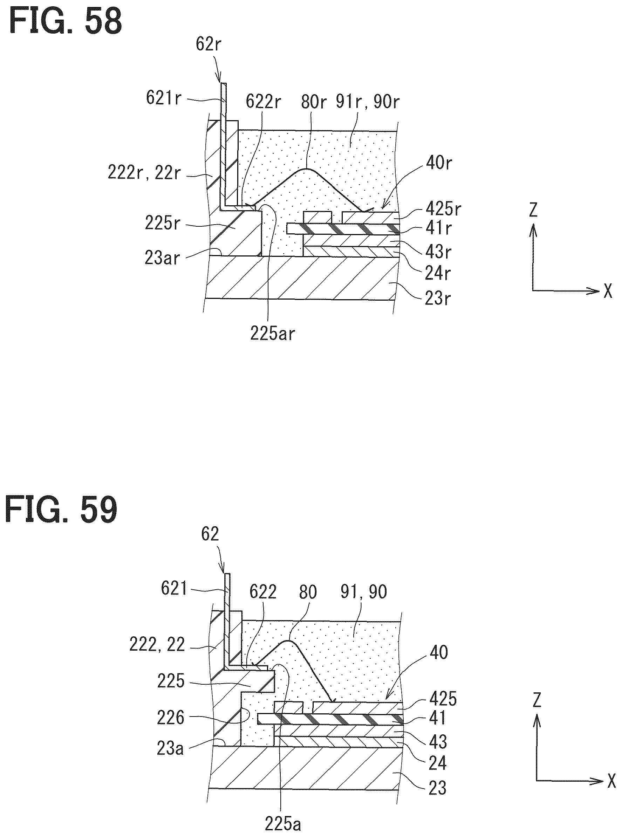

The partition walls 222a and 222b may hold at least some of a plurality of signal terminals 62. As illustrated in FIG. 53, some of the signal terminal 62 may be held by the partition walls 222a and 222b, and the others of the signal terminals may be held by the wall portions 221b and 221c. FIG. 58 illustrates a cross-sectional view of a reference example. FIG. 58 corresponds to FIG. 59. In the reference example, a reference numeral of an element related to the configuration of the present embodiment has r which is added to the end.

In the reference example illustrated in FIG. 58, a partition wall 222r of a housing 22r has a protruding portion 225r. The protruding portion 225r is located at the partition wall 222r below a connection portion 622r of a signal terminal 62r. The protruding portion 225r supports the connection portion 622r. The connection portion 622r is disposed at an upper surface 225ar of the protruding portion 225r. The protruding portion 225r is provided between the connection portion 622r and one surface 23ar of a cooler 23r. In the partition wall 222r, the protruding portion 225r is an expanded-width portion having a large length (width) in the X direction, and a portion above the protruding portion 225r is a reduced-width portion having a narrower width than the protruding portion 225r. A connection portion 621 r of the signal terminal 62r protrudes from an upper surface of the reduced-width portion.

Between the partition wall 222r and the substrate 40r, nothing blocks the sealing body 90r from the one surface 23ar to an upper surface of the sealing body 90r. Therefore, for example, when the sealing body 90r is made of a gel 91r, when vibration of a mobile object is transmitted to the gel 91r, the gel 91 r can vibrate in a wide range from the one surface 23ar to the upper surface of the sealing body 90r. That is, the amount of deformation of the gel 91r is large. Therefore, there is a risk that the bonding wire 80r may break. When the sealing body 90r is made of resin, the resin expands and contracts greatly with temperature changes, which may cause the sealing body 90r to peel off.

FIG. 59 is a cross-sectional view taken along a line LIX-LIX in FIG. 53. FIG. 59 illustrates an example of a structure of the semiconductor module 20 on the periphery of the partition wall 222. As illustrated in FIG. 59, the partition wall 222 may be provided with a recessed portion 226. The partition wall 222 has an inner surface in contact with the sealing body 90 and has an uneven shape at a portion in contact with the sealing body 90. The connection portion 622 of the signal terminal 62 is disposed on an upper surface 225a of the partition wall 222. A protruding portion 225 may be referred to as a support portion that supports the connection portion 622. The bonding wire 80 electrically connects the connection portion 622 and the signal wiring 425.

The recessed portion 226 is provided directly below the protruding portion 225. The recessed portion 226 may be referred to as a trench portion. The recessed portion 226 is provided between the protruding portion 225 and the one surface 23a of the cooler 23. The partition wall 222 is recessed from the lower surface 22a to the protruding portion 225. An upper portion of the protruding portion 225 is also recessed relative to the protruding portion 225. The protruding portion 225 protrudes toward the substrate 40 side. In the example illustrated in FIG. 59, a part of the substrate 40 is embedded directly below the protruding portion 225. The substrate 40 is recessed into a recessed region by the recessed portion 226. In a plan view in the Z direction, the part of the substrate 40 overlaps with the protruding portion 225.

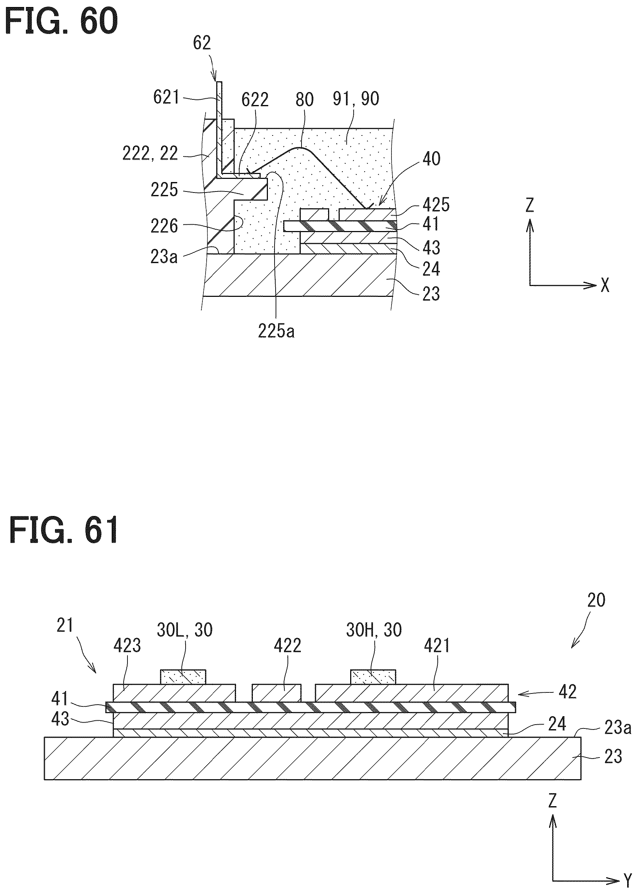

FIG. 60 is a cross-sectional view illustrating another example of the structure on the periphery of the partition wall 222. FIG. 60 corresponds to FIG. 59. In the example illustrated in FIG. 60, the substrate 40 does not overlap with the protruding portion 225 in a plan view. Except for this point, a configuration has the same manner as the configuration illustrated in FIG. 59. The partition wall 222 has the protruding portion 225 and the recessed portion 226.

The recess and protrusion structure described above may be provided in at least one of the partition walls 222a and 222b. The recess and protrusion structure may be provided in at least one of the wall portions 221a, 221b, 221c, and 221d of the frame body 221. It is particularly effective to provide the recess and protrusion structure at the wall portions 221b and 221c that hold the signal terminals 62 and at the partition walls 222a and 222b. In the example illustrated in FIG. 53, the partition walls 222a and 222b and the wall portions 221b, 221c, and 221d are provided with the recess and protrusion structure. In either case, the substrate 40 overlaps with the protruding portion 225.

### <Summary of Fifth Embodiment>

The semiconductor module 20 may include the cooler 23, the housing 22, the substrate 40, the semiconductor element 30, the main terminal 61, the sealing body 90, the sealing material 25, and the metal member having the fastening hole 223. The substrate 40 is disposed in the housing space formed by the housing 22 disposed on the one surface 23a of the cooler 23 and the cooler 23, and the semiconductor element 30 is joined to the conductor 42 of the substrate 40. The main terminal 61 inserted into the housing 22 is joined to the conductor 42. The housing space is filled with the sealing body 90. The sealing material 25 is interposed between the one surface 23a of the cooler 23 and the lower surface 22a of the housing 22. The metal member is integrated into the housing 22. In the above configuration, the metal member may protrude from the housing 22 toward the one surface 23a and contact the one surface 23a to ensure a gap of the predetermined height H10 between the one surface 23a of the cooler 23 and the lower surface 22a of the housing 22.

The sealing material 25 is disposed in a gap of the predetermined height H10 ensured by the metal member. Therefore, it is possible to ensure sealing performance and suppress leakage of the sealing body 90. The metal member is in contact with the cooler 23, but the resin housing 22 is not in contact with the cooler 23. Therefore, when fastening the housing 22 or the like, the housing 22 can be suppressed from pressing strongly against the cooler 23. That is, it is possible to suppress stress generated in the housing 22 due to the pressing from acting on a joint portion between the main terminal 61 inserted into the housing 22 and the conductor 42, that is, on the substrate 40. Therefore, a distortion of the joint portion or the substrate 40 can be suppressed.

As the metal member providing the fastening holes 223, the collar 224 illustrated in FIGS. 53 and 56 may be used. The collar 224 is inserted into the housing 22. With a simple configuration, the distortion of the joint portion or the substrate 40 can be suppressed.

The amount of protrusion of the metal member from the housing 22 may be set within the range of 0.1 mm or more and 0.3 mm or less. That is, thickness of the sealing material 25 may be set within the range of 0.1 mm or more and 0.3 mm or less. Therefore, it is possible to suppress the sealing body 90 from resting on the seating surface, that is, it is possible to suppress a deterioration of the fastening fixation due to resin creep. The thermal resistance can be reduced.

The semiconductor module 20 may include only one substrate 40 or may include a plurality of substrates 40. The plurality of substrates 40 may be disposed to be aligned in a predetermined direction (X direction), and the fastening hole 223 may be provided at a position between adjacent substrates 40 in the alignment direction. Even when the cooler 23 (for example, a cooling plate) warps due to a difference in linear expansion coefficients between the cooler 23 and the substrate 40, by providing a fixing point between the substrates 40 in the alignment direction, stress acting on the substrate 40 or the bonding material 24 due to fastening can be reduced.

The semiconductor element 30 and the signal terminal 62 may be electrically connected via the bonding wire 80, and the bonding wire 80 may be sealed with the gel 91 serving as the sealing body 90 filled in the housing space. In this configuration, the housing 22 may be provided with the partition wall 222 that partitions the housing space according to the disposition of the plurality of substrates 40. Even when vibration of a mobile object is transmitted to the gel 91, the partition wall 222 narrows a range in which the gel 91 can be deformed, so the amount of deformation of the gel 91 can be reduced. Therefore, breakage of the bonding wire 80 can be suppressed.

The semiconductor module 20 may include three substrates 40 that provide the upper and lower arm circuit 9 for one phase together with the semiconductor elements 30. In this configuration, the partition walls 222 (222a, 222b) may be provided between adjacent substrates 40 to divide the housing space into three spaces, and the substrates 40 may be individually disposed in the divided spaces. This makes it possible to suppress breakage of the bonding wire 80 in all of the semiconductor devices 21, in the semiconductor module 20 that provides the inverter 6.

The partition wall 222 may be combined with the configuration in which the gap of the predetermined height H10 is ensured by the metal member described above, or may be used alone without being combined. For example, in a configuration without the collar 224, the partition wall 222 may be provided.

The housing 22 may have the protruding portion 225 as a portion in contact with the sealing body 90, and the recessed portion 226 provided between the protruding portion 225 and the one surface 23a of the cooler 23. When the sealing body 90 is made of resin, peeling-off of the resin at the interface is suppressed by the anchor effect. The protruding portion 225 limits a region in which the resin expands and contracts, thereby suppressing resin peeling-off. When the sealing body 90 is the gel 91, the deformation of the gel 91 due to the transmission of vibration is limited by the protruding portion 225, so the amount of deformation is reduced, and thus breakage of the bonding wire 80 can be suppressed.

In a configuration in which the housing 22 has the protruding portion 225 and the recessed portion 226, a part of the substrate 40 may be disposed to overlap with the protruding portion 225 in a plan view. That is, the substrate 40 may be configured to be located directly below the protruding portion 225. When the sealing body 90 is made of resin, the anchor effect can be enhanced. Since the substrate 40 is located directly below the protruding portion 225, the region in which the resin expands and contracts can be further limited. Therefore, resin peeling-off can be effectively suppressed. For example, peeling of the sealing body 90 from the substrate 40 can be suppressed. When the sealing body 90 is the gel 91, the substrate 40 is located directly below the protruding portion 225, thereby further suppressing deformation of the gel 91. Therefore, breakage of the bonding wire 80 can be effectively suppressed. Since the substrate 40 is inserted directly below the protruding portion 225, the size in the direction perpendicular to the Z direction can be reduced.

In a configuration in which the housing 22 has the protruding portion 225 and the recessed portion 226, the signal terminal 62 may be held in the housing 22, and the connection portion 622 may be disposed on the upper surface 225a of the protruding portion 225. Breaking of the bonding wire 80 connected to the connection portion 622 can be suppressed. Since the upper surface 225a of the protruding portion 225 is used for connecting the bonding wire 80, the anchor effect can suppress resin peeling-off, while also making the device smaller in size. The breakage of the bonding wire 80 connected to the connection portion 622 can be suppressed.

The configuration having the protruding portion 225 and the recessed portion 226 may be combined with the configuration in which the gap of a predetermined height H10 is ensured by the metal member described above, or may be used alone without being combined. The configuration having the protruding portion 225 and the recessed portion 226 may be combined with the partition wall 222 or may be used alone without being combined. For example, in a configuration in which the housing 22 does not have the partition wall 222, the frame body 221 may be provided with the protruding portion 225 and the recessed portion 226.

The configuration described in the present embodiment can be combined with the configuration(s) described in the preceding embodiment(s).

### (Sixth Embodiment)

This embodiment is a modification example of a basic aspect of the preceding embodiment(s), and the description of the preceding embodiment(s) can be incorporated.

### <Semiconductor Module>

FIG. 61 is a cross-sectional view illustrating an example of the semiconductor module 20 according to the present embodiment. The semiconductor module 20 includes the semiconductor device 21, the cooler 23, and the bonding material 24, in the same manner as the configuration illustrated in the preceding embodiment (see FIGS. 2 to 4). The semiconductor device 21 is disposed on the one surface 23a of the cooler 23. The cooler 23 may have a configuration including the flow path 231 as illustrated in the preceding embodiment (see FIG. 4), or may be a heat dissipation member such as a heat sink. The bonding material 24 is interposed between the semiconductor device 21 and the cooler 23. A thermal-conductive member interposed between the semiconductor device 21 and the cooler 23 is not limited to the bonding material 24. TIM or the like may also be used. Although not illustrated, the semiconductor module 20 may include the housing 22.

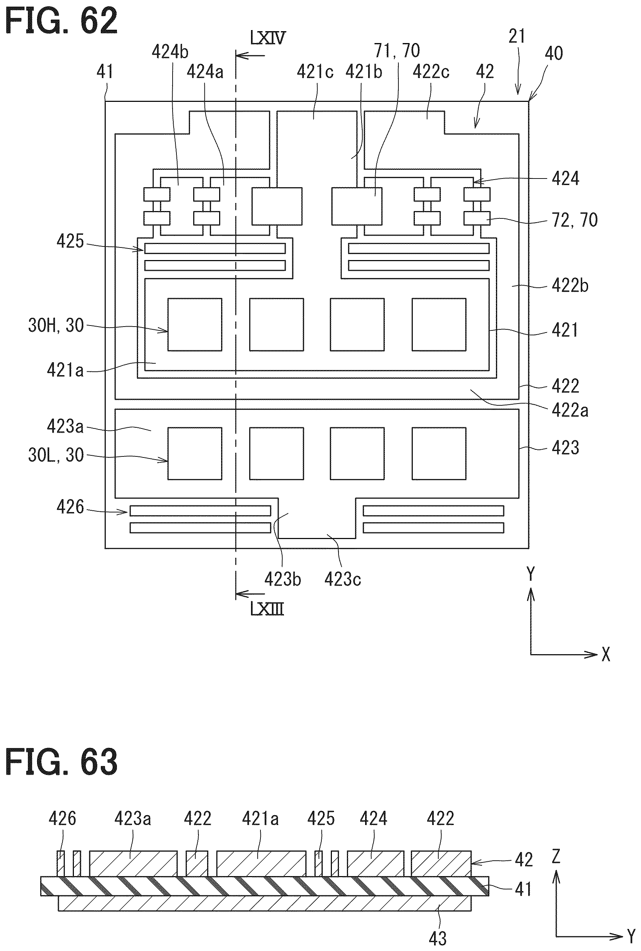

FIG. 62 is a plan view illustrating an example of the semiconductor device 21. FIG. 62 illustrates the substrate 40 and electronic components mounted on the substrate 40. The semiconductor device 21 includes the semiconductor element 30 and the substrate 40, in the same manner as the configuration illustrated in the preceding embodiment (see FIGS. 5 and 6). In FIG. 62, the semiconductor element 30 is illustrated in a simplified form.

As illustrated in FIG. 62, the semiconductor device 21 may include the snubber circuit 70. Although not illustrated, the semiconductor device 21 may include the clip 50. The semiconductor device 21 may include the external connection terminal 60. The semiconductor device 21 may include the sealing body 90, in the same manner as the configuration illustrated in the preceding embodiment (see FIG. 20). The sealing body 90 may be provided in the semiconductor device 21 or in the semiconductor module 20. The sealing body 90 may be the gel 91 or may be a sealing body made of resin.

The semiconductor device 21 forms a power converter. The semiconductor device 21 includes the plurality of semiconductor elements 30. A configuration of the semiconductor element 30 has the same manner as the configuration illustrated in the preceding embodiment (see FIGS. 5 and 18). The semiconductor device 21 includes the plurality of semiconductor elements 30 connected in parallel to one another. The plurality of semiconductor elements 30 connected in parallel provide one arm. The semiconductor device 21 may provide only one arm. As illustrated in FIGS. 61 and 62, the semiconductor device 21 provides the upper and lower arm circuit 9 for one phase. The semiconductor device 21 that provides the upper and lower arm circuit 9 includes the plurality of semiconductor elements 30H that provide the upper arms 9H and the plurality of semiconductor elements 30L that provide the lower arms 9L. The semiconductor element 30H corresponds to an upper arm element, and the semiconductor element 30L corresponds to a lower arm element.

The plurality of semiconductor elements 30H are aligned in the X direction. The plurality of semiconductor elements 30L are aligned in the X direction. The semiconductor elements 30H and 30L are aligned in the Y direction. The number of the semiconductor elements 30H and the number of the semiconductor elements 30L may be the same or different. In the example illustrated in FIG. 62, the semiconductor elements 30H and 30L have a common configuration, and the numbers of semiconductor elements 30H and 30L are the same.

The semiconductor module 20 may include three semiconductor devices 21 providing the upper and lower arm circuit 9 for one phase, in the same manner as the configuration illustrated in the preceding embodiment. The three semiconductor devices 21, that is, the three substrates 40, may be disposed to be aligned in the X direction.

### <Semiconductor Element and Substrate>

FIG. 63 is a cross-sectional view taken along a line LXIII-LXIII in FIG. 62. The substrate 40 includes the insulating base material 41 and conductors 42 and 43, in the same manner as the configuration illustrated in the preceding embodiment (see FIG. 4). The conductor 42 corresponds to a top surface conductor, and the conductor 43 corresponds to a rear surface conductor. The conductor 42 is patterned and has a plurality of wiring patterns. The conductor 43 may be a so-called solid conductor that is not patterned, as illustrated in FIG. 63, for example. The conductor 43 may be patterned.

The conductor 42 includes an element mounting portion as the wiring pattern. The conductor 42 includes at least one element mounting portion. The drain electrodes 31 of the plurality of semiconductor elements 30 arranged in the X direction, are connected to the element mounting portion. As illustrated in FIGS. 62 and 63, the conductor 42 may have, as the element mounting portions, the base portion 421a on which the plurality of semiconductor elements 30H are mounted and the base portion 423a on which the plurality of semiconductor elements 30L are mounted. The base portion 421a corresponds to an upper arm mounting portion, and the base portion 423a corresponds to a lower arm mounting portion.

The base portion 421a extends in the X direction. The plurality of semiconductor elements 30H are disposed on the base portion 421a to be aligned in the X direction. The source electrodes 32 of the plurality of semiconductor elements 30H are joined to the common base portion 421a. Therefore, the plurality of semiconductor elements 30H are connected in parallel to one another. The base portion 423a extends in the X direction. The plurality of semiconductor elements 30L are disposed on the base portion 423a to be aligned in the X direction. The source electrodes 32 of the plurality of semiconductor elements 30L are joined to the common base portion 423a. Therefore, the plurality of semiconductor elements 30L are connected in parallel to one another.

One of the element mounting portions is disposed in a central region of the substrate 40 in the Y direction. The central region is a region of a predetermined range centered on the central position of the substrate 40 in the Y direction. As illustrated in FIGS. 62 and 63, in a configuration including two base portions 421a and 423a, the base portion 421a may be disposed in the central region of the substrate 40. That is, the plurality of semiconductor elements 30H may be mounted in the central region of the substrate 40 in the Y direction. In this configuration, the base portion 423a is disposed outside the central region in the Y direction. The plurality of semiconductor elements 30L are mounted on the substrate 40 outside the central region in the Y direction.

The conductor 42 may be divided into a plurality of wiring patterns in the Y direction. For example, in a portion indicated by a dashed chain line in FIG. 62, the conductor 42 is divided for the N wiring 422, the interconnection wiring 424, the signal wiring 425, the base portion 421a, the N wiring 422, the base portion 423a, and the signal wiring 426. The conductor 42 is laid out to be divided for each of the base portions 421a and 423a which are mounting portions of the semiconductor element 30, the capacitor 71 which is a passive component, and the interconnection wiring 424 and the signal wirings 425 and 426 which are mounting portions of the resistor 72.

As illustrated in FIG. 62, the substrate 40 may have a non-disposition region 411 in which no conductor 42 is disposed, which is disposed to cross the conductors 42 in the X direction. The non-disposition region 411 is a region in which no conductor 42 is disposed on the insulating base material 41, and extends from one end to the other end of the substrate 40 in the X direction. The non-disposition region 411 separates the conductor 42 in the Y direction. The number of non-disposition regions 411 is not particularly limited. The substrate 40 may have only one non-disposition region 411 as illustrated in FIG. 62, or may have a plurality of non-disposition regions 411.

The conductor 42 may have the extension portion 421b and the N wiring 422, as a main wiring portion. The extension portion 421b electrically connects the drain electrode 31 of the semiconductor element 30H and the P terminal 611 via the base portion 421a. The N wiring 422 electrically connects the source electrode 32 of the semiconductor element 30L and the N terminal 612. As illustrated in FIGS. 62 and 63, the N wiring 422, which is a main wiring electrically isolated from the semiconductor element 30H disposed in the central region, may be disposed between the base portion 421a and the base portion 423a. That is, the main wiring may be disposed between the base portions 421a and 423a in the Y direction.

A wiring pattern of the conductor 42 illustrated in FIG. 62 has the same manner as the wiring pattern of the preceding embodiment (see FIGS. 5 and 6). The N wiring 422 has the base portion 422a located between the base portions 421a and 423a, and the extension portion 422b connecting the main terminal 612 and the base portion 422a. The terminal connection portion 422c provided at an end portion of the extension portion 422b is aligned with the terminal connection portion 421c of the P wiring 421 in the X direction. The N wiring 422 has two extension portions 422b respectively extending from both ends of a base portion 422a. The N wiring 422 has a substantially C shape as a planar shape, and the two extension portions 422b interpose the P wiring 421, the interconnection wiring 424, and the signal wiring 425 in the X direction.

A relationship between areas of the base portions 421a and 423a when viewed in a plan view from the Z direction is not particularly limited. For example, the areas may be equal to each other. The area of the element mounting portion disposed in the central region may be smaller than the area of the element mounting portion disposed outside the central region. In the example illustrated in FIG. 62, the area of the base portion 421a disposed in the central region is smaller than the area of the base portion 423a disposed outside the central region.

An interval between the semiconductor elements 30 mounted on the base portions 421a and 423a is not particularly limited. For example, as illustrated in FIG. 62, the interval between semiconductor elements 30H and the interval between semiconductor elements 30L may be substantially equal. The interval between the semiconductor elements 30H may be less than the interval between the semiconductor elements 30L. For example, the interval between the semiconductor elements 30H on the base portion 421a with the smaller area located in the central region may be less than the interval between the semiconductor elements 30L on the base portion 423a with the larger area located outside the central region.

A thickness of the conductor 42 may be substantially equal to a thickness of the conductor 43. As illustrated in FIG. 63, the thickness of the conductor 42 may be greater than the thickness of the conductor 43.

### <Summary of Sixth Embodiment>

The semiconductor module 20 may include the cooler 23, the substrate 40, the bonding material 24, and the plurality of semiconductor elements 30. The substrate 40 is disposed on the one surface 23a of the cooler 23, and the bonding material 24 (thermal-conductive member) is interposed between the conductor 43 (rear surface conductor) of the substrate and the cooler 23. The drain electrodes 31 (first main electrodes) of the plurality of semiconductor elements 30 are joined to the conductors 42 (top surface conductors) of the substrate 40. In the above configuration, one of the element mounting portions, to which the drain electrodes 31 of the plurality of semiconductor elements 30 disposed in the X direction are commonly connected, may be disposed in the central region of the substrate 40 in the Y direction (orthogonal direction).

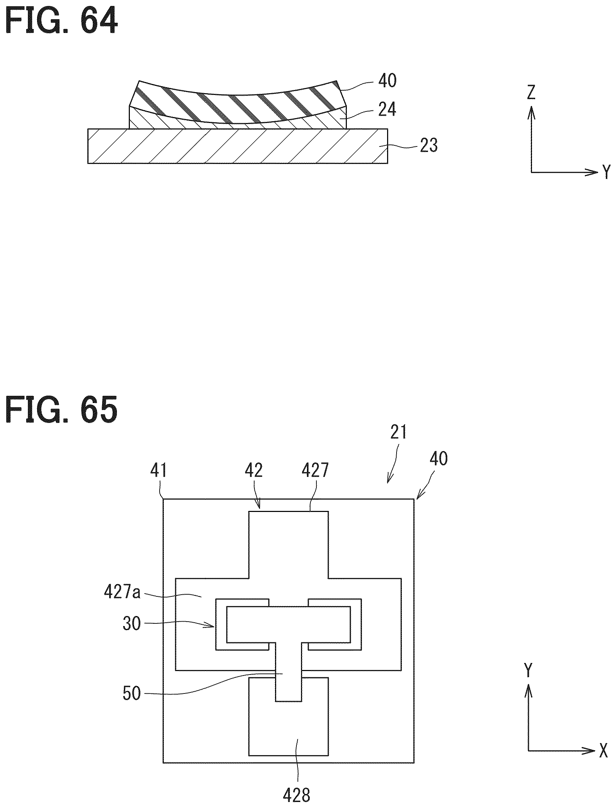

According to the above configuration, due to the difference in expansion and contraction between the patterned conductors 42 and 43, the substrate 40 warps in a protruding shape on the cooler 23 side. The substrate 40 warps due to heat generated during the manufacturing process. The substrate 40 warps in the Y direction with a central region as an apex of a protruding shape. The warpage of the substrate 40 is greater in the Y direction than in the X direction in which the plurality of semiconductor elements 30 are arranged. As illustrated in FIG. 64, the substrate 40 is fixed to the cooler 23 via a thermal-conductive member in a warped state. For example, heat generated during soldering and joining (reflow) causes the substrate 40 to warp in a protruding shape toward the cooler 23, and the substrate 40 is fixed (soldered and joined) to the cooler 23 in this warped state. The thickness of the bonding material 24 is thin in the vicinity of the apex of the protruding shape, that is, directly below the central region. Since the element mounting portion is disposed in the central region, the thermal resistance can be reduced in a configuration in which the plurality of semiconductor elements 30 are connected in parallel. The heat generated by the semiconductor element 30, which is a heating element, can be effectively dissipated to the cooler 23 side.

As illustrated in FIG. 63, the conductor 42 may be divided into a plurality of wiring patterns in the Y direction. By dividing into the plurality of wiring patterns and narrowing a portion to be expanded and contracted, the substrate 40 becomes more likely to warp in the Y direction. Therefore, the thermal resistance between the substrate 40 and the cooler 23 directly below the plurality of semiconductor elements 30 located in the central region can be effectively reduced.

As illustrated in FIG. 62, the substrate 40 may be provided with the non-disposition region 411 that crosses the conductor 42 in the X direction. By providing the non-disposition region 411, the substrate 40 is more likely to warp in the Y direction. Therefore, the thermal resistance between the substrate 40 and the cooler 23 directly below the plurality of semiconductor elements 30 located in the central region can be effectively reduced.

The plurality of semiconductor elements 30 may include the plurality of semiconductor elements 30H (upper arm elements) aligned in the X direction and the plurality of semiconductor elements 30L (lower arm elements) aligned in the X direction. The element mounting portion may include the base portion 421a (upper arm element portion) to which the drain electrodes 31 of the semiconductor elements 30H are commonly connected, and the base portion 423a (lower arm element portion) to which the drain electrodes 31 of the semiconductor elements 30L are commonly connected. In the above configuration, one of the base portions 421a and 423a may be disposed in the central region of the substrate 40 in the Y direction, and the other of the base portions 421a and 423a may be disposed outside the central region. That is, the configuration may be applied to a configuration in which the upper and lower arm circuit 9 is provided.

For example, when the base portion 421a is disposed in the central region as illustrated in FIG. 62, the thermal resistance between the substrate 40 and the cooler 23 directly below the plurality of semiconductor elements 30H can be effectively reduced. Although not illustrated, when the base portion 423a is disposed in the central region, the thermal resistance between the substrate 40 and the cooler 23 directly below the plurality of semiconductor elements 30L can be effectively reduced.

In a configuration that provides the upper and lower arm circuit 9, a main wiring portion that is electrically isolated from the semiconductor element 30 disposed in the central region may be disposed between the base portions 421a and 423a. With the disposition of the main wiring portion, the conductor 42 is divided into more wiring patterns in the Y direction. Therefore, the substrate 40 is likely to warp in the Y direction. The thermal resistance between the substrate 40 and the cooler 23 directly below the plurality of semiconductor elements 30 located in the central region can be effectively reduced.

The area of the base portions 421a and 423a in a plan view in the Z direction may be configured such that the base portion disposed in the central region is smaller than the base portion disposed outside the central region. As described above, the semiconductor element 30 in the central region can reduce the thermal resistance directly below, and therefore can effectively dissipate heat even when the base portion is made small. The semiconductor elements 30 outside the central region have the base portion having a large area, and therefore can dissipate heat effectively even when the thermal resistance directly below is larger than that in the central region. That is, the heat from both the semiconductor elements 30H and 30L that form the upper and lower arm circuit 9 can be effectively dissipated.

In a configuration in which one of the element mounting portions is disposed in the central region of the substrate 40 in the Y direction, the conductor 42 may be thicker than the conductor 43. By making the conductor 42 thicker, the amount of warping of the substrate 40 can be reduced. That is, an increase in thermal resistance due to warping can be suppressed outside the central region. The substrate 40 warps in a protruding shape toward the cooler 23 side in a relationship of a volume of the conductor 43 ≥ a volume of the conductor 42. The conductor 42 is patterned to have a protruding warp toward the cooler 23 side in the relationship of the volume of the conductor 43 ≥ the volume of the conductor 42. Even when the conductor 42 is made thick, as long as the relationship of the volume of the conductor 43 ≥ the volume of the conductor 42 is satisfied, the substrate 40 warps in a protruding shape toward the cooler 23 side.

### <Modification Examples>

As illustrated in FIG. 65, in the semiconductor device 21 that provides one arm, one of the element mounting portions may be disposed in the central region of the substrate 40 in the Y direction. The plurality of semiconductor elements 30 are mounted on the base portion 427a (element mounting portion) of the drain wiring 427. The base portion 427a is disposed in the central region of the substrate 40 in the Y direction perpendicular to a direction (X direction) in which the plurality of semiconductor elements 30 are aligned. The base portion 427a and the source wiring 428 are aligned in the Y direction. The source electrode 32 of the semiconductor element 30 is electrically connected to the source wiring 428 via the clip 50.

The configuration described in the present embodiment can be combined with the configuration(s) described in the preceding embodiment(s).

### (Seventh Embodiment)

This embodiment is a modification example of a basic aspect of the preceding embodiment(s), and the description of the preceding embodiment(s) can be incorporated.

### <Oscillation in Parallel Connection>

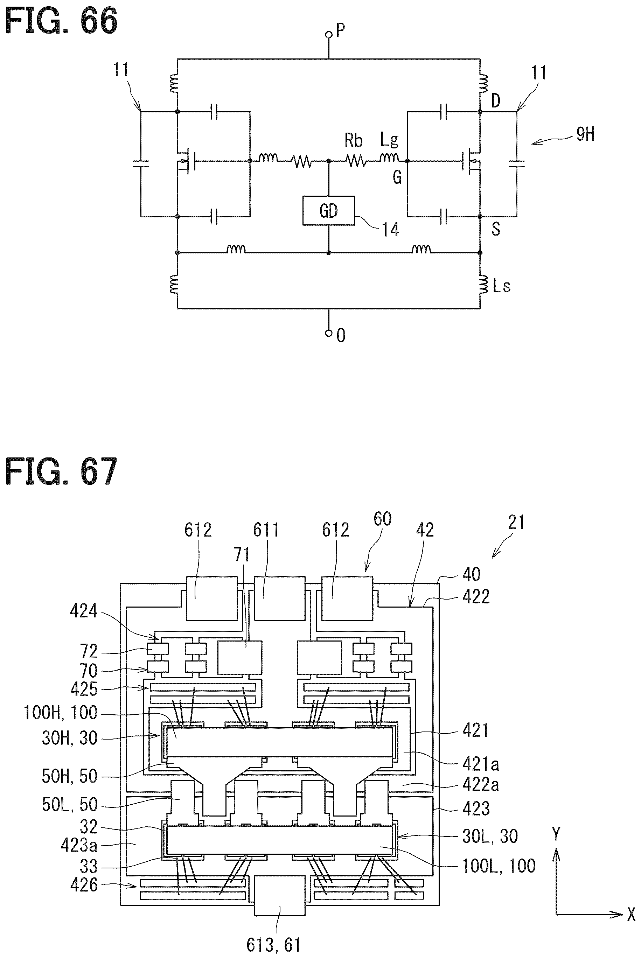

FIG. 66 is an equivalent circuit diagram illustrating an example of the upper arm 9H. In FIG. 66, two MOSFETs 11 are connected in parallel to form the upper arm 9H. The MOSFET 11 has parasitic capacitances between a gate and a source, between the gate and a drain, and between the drain and the source. The gate electrodes of the two MOSFETs 11 are connected to each other. A gate drive signal is input to each gate electrode from the common gate driver (GD) 14. A gate wiring connecting the gate driver 14 and each gate electrode has a resistance Rg and a parasitic inductance Lg. The source electrodes of the two MOSFETs 11 are connected to each other. The wiring connecting the source electrodes has a parasitic inductance Ls.

In a parallel circuit of a plurality of MOSFETs 11, an oscillation circuit is formed by the parasitic capacitance of the MOSFETs 11, the parasitic inductance of the wiring, and the like. Oscillation occurs when the input signal input from the gate driver 14 to the gate electrode and the feedback signal on a path via the parasitic capacitance, parasitic inductance, and the like are in phase and the gain is 0 dB or more, that is, when the feedback signal is amplified. When the resonance condition is met, oscillation occurs.

The parasitic inductance Ls between the source electrodes is large, and the parasitic inductance Lg of the gate wiring is small. In order to suppress the oscillation, it is effective to reduce the parasitic inductance Ls between the source electrodes and/or to increase the gate impedance.

### <Reduction of Parasitic Inductance between Source Electrodes>

FIG. 67 illustrates an example of the semiconductor device 21 according to the present embodiment. A basic configuration of the semiconductor device 21 is the same as the configuration described in the preceding embodiments (see FIGS. 2 to 6 and 18). The semiconductor device 21 includes the plurality of semiconductor elements 30 and the substrate 40. As illustrated in FIG. 67, the semiconductor device 21 may include the clip 50. The semiconductor device 21 may include the external connection terminal 60. The semiconductor device 21 may include the snubber circuit 70.

As described above, the semiconductor element 30 has the source electrode 32 and the pad 33 disposed on the one surface 34a of the semiconductor substrate 34, and the drain electrode 31 disposed on the rear surface 34b. The plurality of semiconductor elements 30 may provide only one arm. As illustrated in FIG. 67, the semiconductor device 21 may provide the upper and lower arm circuit 9 for one phase. The semiconductor device 21 that provides the upper and lower arm circuit 9 includes the plurality of semiconductor elements 30H that provide the upper arms 9H and the plurality of semiconductor elements 30L that provide the lower arms 9L. The plurality of semiconductor elements 30H are aligned in the X direction. The plurality of semiconductor elements 30L are aligned in the X direction. The semiconductor elements 30H and 30L are aligned in the Y direction.

The semiconductor module 20 may include three semiconductor devices 21 providing the upper and lower arm circuit 9 for one phase, in the same manner as the configuration illustrated in the preceding embodiment. The three semiconductor devices 21, that is, the three substrates 40, may be disposed to be aligned in the X direction.

The substrate 40 has the insulating base material 41 and the conductor 42 disposed on the insulating base material 41, in the same manner as the configuration described in the preceding embodiment. The conductor 42 corresponds to a wiring. The substrate 40 may have a conductor 43 on the side opposite the conductor 42. The conductor 42 is patterned. The conductor 42 has the P wiring 421, the N wiring 422, and the O wiring 423 to provide the upper and lower arm circuit 9. As illustrated in FIG. 67, the conductor 42 may have the interconnection wiring 424. The conductor 42 may include the signal wirings 425 and 426.

The plurality of semiconductor elements 30H are mounted on the base portion 421a of the P wiring 421. The drain electrodes 31 of the plurality of semiconductor elements 30H are joined to the base portion 421a. The plurality of semiconductor elements 30H are connected in parallel to one another. The plurality of semiconductor elements 30L are mounted on the base portion 423a of the O wiring 423. The drain electrodes 31 of the plurality of semiconductor elements 30L are joined to the base portion 423a. The plurality of semiconductor elements 30L are connected in parallel to one another. The source electrodes 32 of the plurality of semiconductor elements 30H are electrically connected to the base portion 423a of the O wiring 423 via the clip 50H. The source electrodes 32 of the plurality of semiconductor elements 30L are electrically connected to the base portion 422a of the N wiring 422 via the clip 50L.

As illustrated in FIG. 67, the semiconductor device 21 may include a metal plate 100. The metal plate 100 is a plate formed of a metal material with good electrical conductivity, such as copper. The metal plate 100 may be plate-shaped, for example. The metal plate 100 short-circuits (shorts) the source electrodes 32 of the plurality of semiconductor elements 30 connected in parallel. The metal plate 100 electrically connects the plurality of source electrodes 32 to each other with a low impedance. The metal plate 100 may be joined to the source electrode 32 or may be connected to the source electrode 32 via another metal member. The metal plate 100 bridges the plurality of source electrodes 32. The metal plate 100 may be disposed to be enclosed in a plan view by a wiring on which the plurality of semiconductor elements 30 as the connection targets are mounted.

As illustrated in FIG. 67, the metal plate 100 may include a metal plate 100H and a metal plate 100L. The metal plate 100H short-circuits the source electrodes 32 of the plurality of semiconductor elements 30H. The metal plate 100L short-circuits the source electrodes 32 of the plurality of semiconductor elements 30L. The metal plate 100H is joined to the clip 50H. The metal plate 100L is joined to the clip 50L. Although not illustrated in FIG. 67, the clip 50 may also function as the metal plate 100.

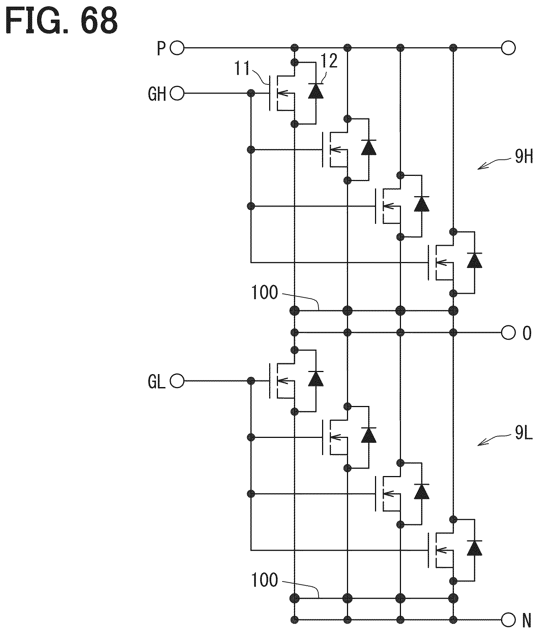

FIG. 68 illustrates an equivalent circuit of the upper and lower arm circuit 9 provided by the semiconductor device 21 illustrated in FIG. 67. A short-circuit portion formed by the metal plate 100H short-circuits the source electrodes 32 of the plurality of MOSFETs 11 that form the upper arm 9H. A short-circuit portion formed by the metal plate 100L short-circuits the source electrodes 32 of the plurality of MOSFETs 11 that form the lower arm 9L.

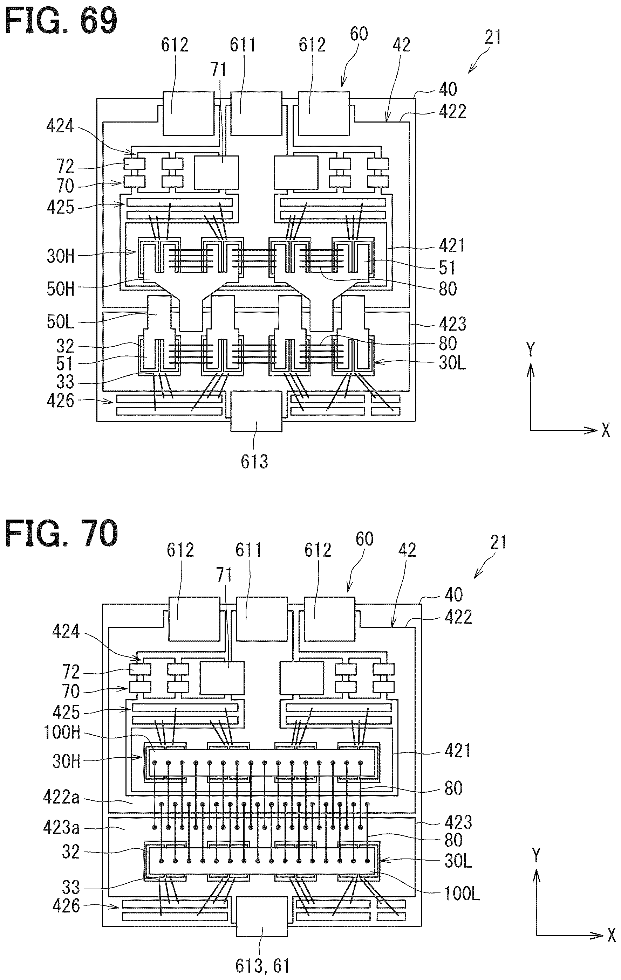

The configuration for short-circuiting the source electrode 32 is not limited to the above example. For example, as illustrated in FIG. 69, instead of the metal plate 100, the bonding wire 80 may be used. The bonding wire 80 electrically connects the joint portions 51 adjacent to each other in the X direction. As illustrated in FIG. 69, the bonding wire 80 may electrically connect adjacent joint portions 51 joined to source electrodes 32 of different semiconductor elements 30H. The bonding wire 80 may electrically connect adjacent joint portions 51 that are joined to the source electrodes 32 of different semiconductor elements 30L. The number of bonding wires 80 connecting the adjacent joint portions 51 is not particularly limited. As illustrated in FIG. 69, a plurality of bonding wires 80 may be connected.

As illustrated in FIG. 70, a configuration without using the clip 50 may be adopted. The metal plate 100H is joined to the source electrode 32 of the semiconductor element 30H. The metal plate 100H bridges the four semiconductor elements 30H. The plurality of bonding wires 80 are connected to the metal plate 100H. The bonding wires 80 extend in the Y direction in a plan view. One end portion of the bonding wire 80 is connected to the metal plate 100H, and the other end portion is connected to the base portion 423a of the O wiring 423. The plurality of bonding wires 80 are aligned in the X direction in a plan view.

In the same manner, the metal plate 100L is joined to the source electrode 32 of the semiconductor element 30L. The metal plate 100L bridges the four semiconductor elements 30L. The plurality of bonding wires 80 are connected to the metal plate 100L. The bonding wires 80 extend in the Y direction in a plan view. One end portion of the bonding wire 80 is connected to the metal plate 100L, and the other end portion is connected to the base portion 422a of the N wiring 422. The plurality of bonding wires 80 are aligned in the X direction in a plan view. The bonding wire 80 connected to the metal plate 100H and the bonding wire 80 connected to the metal plate 100L are disposed alternately in the X direction.

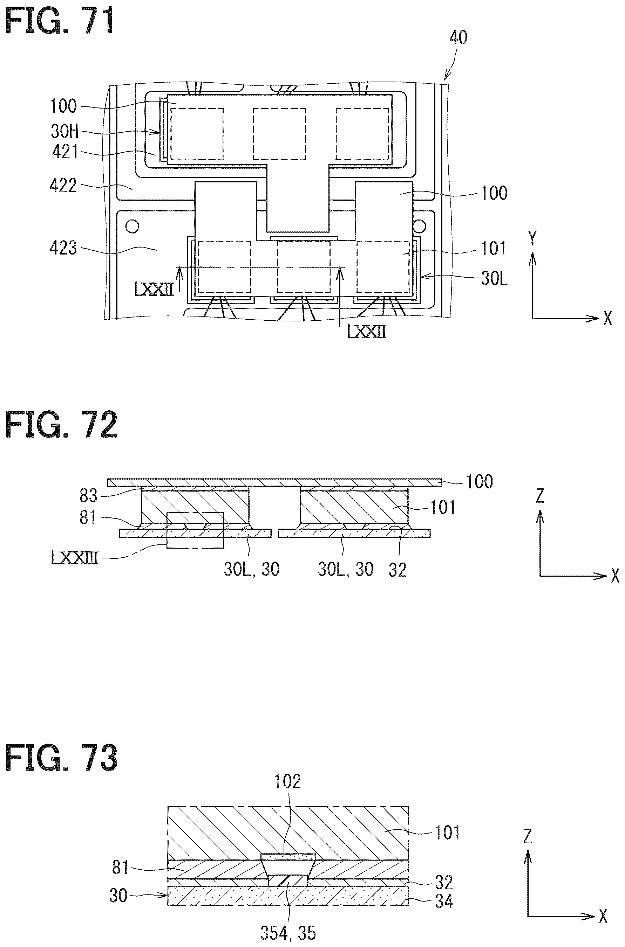

As illustrated in FIGS. 71, 72, and 73, a metal block 101 of a predetermined height may be interposed between the source electrode 32 of the semiconductor element 30 and the metal plate 100. FIG. 71 illustrates the periphery of the semiconductor elements 30H and 30L in the semiconductor device 21. FIG. 72 is a cross-sectional view taken along a line LXXII-LXXII in FIG. 71. FIG. 73 is an enlarged view of a region LXXIII indicated by a dashed chain line in FIG. 72. The metal block 101 may be referred to as a terminal, a conductive spacer, or the like. The metal block 101 is provided individually for each semiconductor element 30. The metal block 101 is connected to the source electrode 32 via a bonding material such as the solder 81. The metal block 101 is connected to the metal plate 100 via a bonding material 83 such as a solder.

As illustrated in FIG. 73, the metal block 101 may have an oxide film 102. The oxide film 102 is provided at a portion which is a surface facing the semiconductor element 30 and is a portion facing the upper element portion 354 of the insulating film 35 (see FIGS. 18 and 19). The metal block 101 may have a base material made of a metal with good electrical conductivity, such as copper, for example, and a plating film formed on the base material. The plating film contains, for example, Ni as a main component. The oxide film 102 is formed by, for example, irradiating the plating film with laser light. The oxide film 102 has low wettability with respect to the solder. The oxide film 102 can suppress the solder 81 from being located above the upper element portion 354.

### <Increase in Gate Impedance>

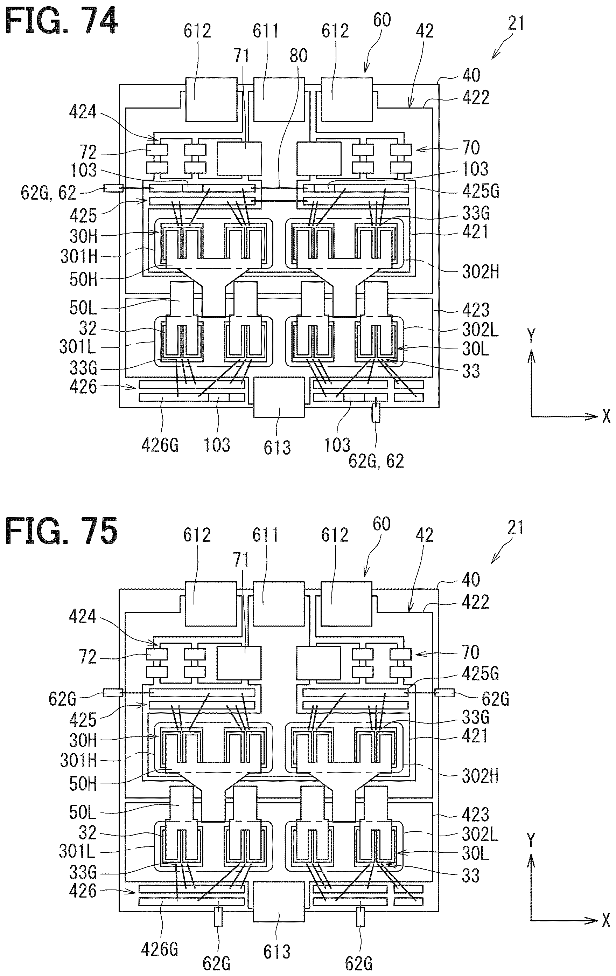

FIG. 74 illustrates another example of the semiconductor device 21. The semiconductor device 21 includes the plurality of semiconductor elements 30 and the substrate 40, in the same manner as the configuration illustrated in FIG. 67. As illustrated in FIG. 74, the semiconductor device 21 may include the clip 50. The semiconductor device 21 may include the external connection terminal 60. The semiconductor device 21 may include the snubber circuit 70.

The semiconductor device 21 may include a passive component 103. The passive components 103 include ferrite beads or balance resistors. The passive component 103 is disposed on a gate electrode of the MOSFET 11, that is, on a gate wiring (signal path) connecting the gate pad 33G of the semiconductor element 30 and the gate driver 14, and increases an impedance of the gate wiring. As illustrated in FIG. 74, in a configuration in which the substrate 40 includes the signal wirings 425 and 426, the passive component 103 may be mounted on the gate wirings 425G and 426G.

In the example illustrated in FIG. 74, the semiconductor device 21 includes the signal terminal 62. For convenience, FIG. 74 illustrates only the gate terminal 62G as the signal terminal 62. Disposition and a connection structure of the signal wirings 425, 426 including the gate wirings 425G and 426G and the signal terminals 62 including the gate terminal 62G have the same manner as the disposition and the configuration described in the preceding embodiment (see FIGS. 5 and 42). The signal wiring 425 divided by the P wiring 421 and having the same function is electrically connected by the bonding wire 80.

The passive component 103 is mounted on the gate wiring 425G to electrically relay a portion electrically connected to the gate terminal 62G and a portion electrically connected to the gate pad 33G. The passive component 103 is mounted on the gate wiring 426G to electrically relay the portion electrically connected to the gate terminal 62G and the portion electrically connected to the gate pad 33G.

The plurality of semiconductor elements 30 connected in parallel are divided into groups of which number is less than the number of elements. The plurality of semiconductor elements 30 connected in parallel are grouped together in such a way that the semiconductor elements 30 disposed in close proximity to each other are grouped together. In the example illustrated in FIG. 74, the semiconductor elements 30H are divided into two groups 301H and 302H. Among the four semiconductor elements 30H aligned in the X direction, the two semiconductor elements 30H on one end side belong to the group 301H, and the two semiconductor elements 30H on the other end side belong to the group 302H. In the same manner, the semiconductor elements 30L are divided into two groups 301L and 302L. Among the four semiconductor elements 30L aligned in the X direction, the two semiconductor elements 30L on one end side belong to the group 301L, and the two semiconductor elements 30L on the other end side belong to the group 302L.

The passive component 103 described above is provided for each group, not for each semiconductor element 30. As illustrated in FIG. 74, the gate pad 33G of the semiconductor element 30H belonging to the group 301H is electrically connected via the bonding wire 80 to the gate wiring 425G located on the group 301H side in the X direction. The passive component 103 is mounted on the gate wiring 425G corresponding to the group 301H. The gate pad 33G of the semiconductor element 30H belonging to the group 302H is electrically connected via the bonding wire 80 to the gate wiring 425G located on the group 302H side in the X direction. The passive component 103 is mounted on the gate wiring 425G corresponding to the group 302H.

In the same manner, the gate pad 33G of the semiconductor element 30L belonging to the group 301L is electrically connected via the bonding wire 80 to the gate wiring 426G located on the group 301L side in the X direction. The passive component 103 is mounted on the gate wiring 426G corresponding to the group 301L. The gate pad 33G of the semiconductor element 30L belonging to the group 302L is electrically connected via the bonding wire 80 to the gate wiring 426G located on the group 302L side in the X direction. The passive component 103 is mounted on the gate wiring 426G corresponding to the group 302L.

In the example illustrated in FIG. 75, the passive component 103 is disposed outside the semiconductor device 21. As described above, the passive component 103 is provided in a signal path between the gate driver 14 and the gate pad 33G. The passive components 103 may be mounted on a circuit substrate (not illustrated) on which the gate driver 14 is formed, for example. The gate terminal 62G is provided for each group. The semiconductor device 21 includes the gate terminal 62G corresponding to the group **301H,** the gate terminal 62G corresponding to the group 302H, the gate terminal 62G corresponding to the group 301L, and the gate terminal 62G corresponding to the group 302L.

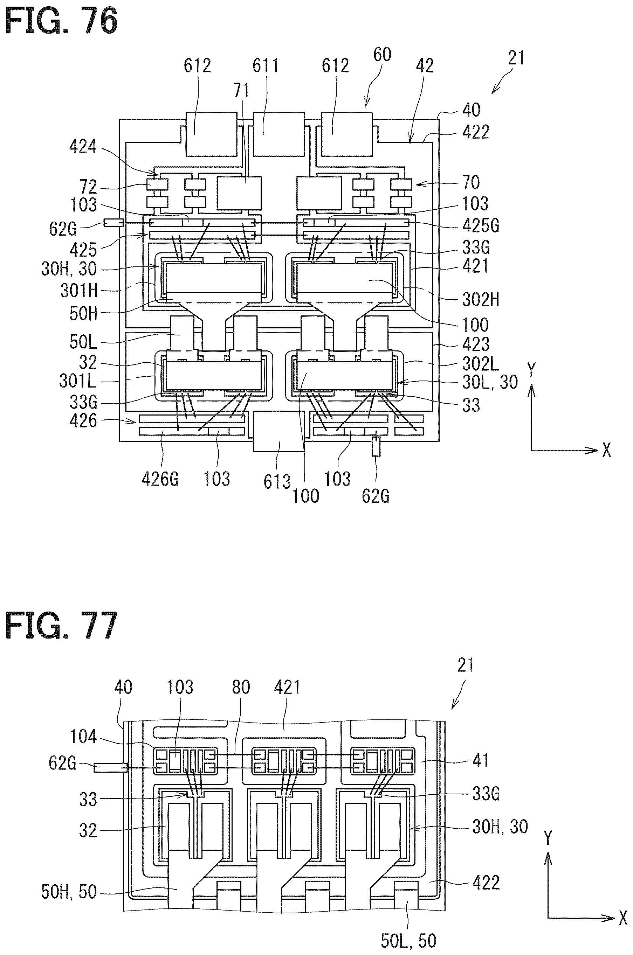

The configuration for reducing the inductance between the source electrodes 32 and the configuration for increasing the impedance of the gate wiring may be combined. For example, as illustrated in FIG. 76, the configuration in which the source electrodes 32 are short-circuited by the metal plate 100 and the configuration in which the passive component 103 is provided for each group may be combined. In FIG. 76, the metal plate 100 is provided for each group. The metal plate 100 short-circuits the source electrodes 32 of the two semiconductor elements 30 that belong to a common group.

Although an example in which the passive components 103 are mounted on the substrate 40 is illustrated, the present disclosure is not limited to this. A printed circuit board may be prepared separately from an insulating substrate serving as the substrate 40, and the passive components 103 may be mounted on the printed circuit board. The insulating base material of the printed circuit board contains a resin. An insulating base material of the insulating substrate does not contain resin and is made of, for example, ceramic. The printed circuit board allows for finer wiring patterns than insulating substrates.

The semiconductor device 21 illustrated in FIG. 77 includes an interposing substrate 104. The interposing substrate 104 is a printed circuit board. The passive component 103 is mounted on the interposing substrate 104. The substrate 40 illustrated in FIG. 77 is an insulating substrate. As illustrated in FIG. 77, the interposing substrate 104 may be mounted on the substrate 40. The interposing substrate 104 is disposed on the insulating base material 41 made of ceramic. The interposing substrate 104 is fixed to the substrate 40 by, for example, adhesive. In the example illustrated in FIG. 77, the semiconductor device 21 includes three semiconductor elements 30H. The interposing substrate 104 is provided for each semiconductor element 30H. The passive component 103 is mounted on each of the interposing substrates 104. The semiconductor elements 30H are aligned in the X direction, and the interposing substrates 104 are also aligned in the X direction. The interposing substrate 104 is disposed to avoid the P wiring 421 and the N wiring 422.

The pad 33 is connected to the corresponding wiring on the interposing substrate 104 via the bonding wire 80. The passive component 103 is provided on a signal path connecting the gate pad 33G of the semiconductor element 30H corresponding to the mounted interposing substrate 104 and the gate terminal 62G. The wirings having the same function of the adjacent interposing substrates 104 are electrically connected via the bonding wire 80. The interposing substrate 104 at one end portion in the X direction is electrically connected to the gate terminal 62G via the bonding wire 80.

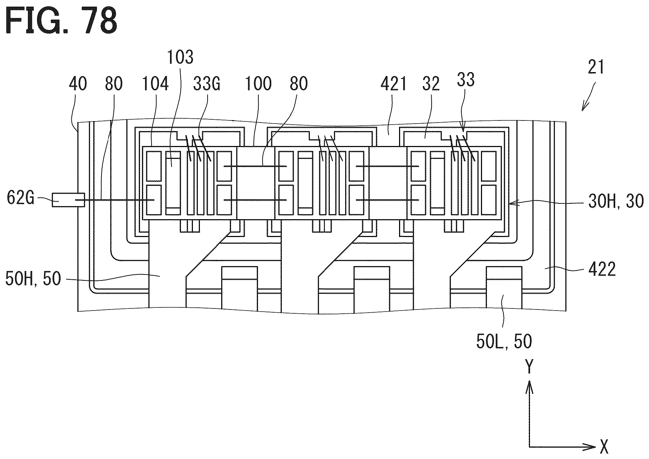

The interposing substrate 104 may be disposed on a metal member joined to the source electrode 32 of the semiconductor element 30. For example, as illustrated in FIG. 78, the interposing substrate 104 may be disposed on the metal plate 100. The metal plate 100 is joined to the clip 50H, in the same manner as the configuration illustrated in FIG. 67. The metal plate 100 extends in the X direction to overlap with the three semiconductor elements 30H in a plan view. The metal plate 100 short-circuits the source electrodes 32 of the three semiconductor elements 30H via the clips 50H. The interposing substrate 104 is adhesively fixed to the metal plate 100.

The interposing substrate 104 is disposed to overlap with the corresponding semiconductor element 30H in a plan view. The pad 33 is connected to the corresponding wiring on the interposing substrate 104 via the bonding wire 80. The wirings having the same function of the adjacent interposing substrates 104 are electrically connected via the bonding wire 80. The interposing substrate 104 at one end portion in the X direction is electrically connected to the gate terminal 62G via the bonding wire 80.

Although an example of the semiconductor element 30H is illustrated in FIGS. 77 and 78, the same structure can also be adopted for the semiconductor element 30L. Although the examples illustrated in FIGS. 77 and 78 illustrate the interposing substrates 104 provided individually for semiconductor elements 30, the present disclosure is not limited to this. In a configuration in which the interposing substrate 104 is mounted on the substrate 40, the interposing substrate 104 may be provided for each of the plurality of semiconductor elements 30. For example, the common interposing substrate 104 may be provided for two semiconductor elements 30, and the passive component 103 provided for each semiconductor element 30 may be mounted on the common interposing substrate 104. The interposing substrate 104 may be provided for each of the above groups. The common passive component 103 is mounted on the interposing substrate 104 within the group.

In a configuration in which the interposing substrate 104 is disposed on the metal plate 100, the interposing substrate 104 may be provided for each of the plurality of semiconductor elements 30. For example, the common interposing substrate 104 may be provided for two semiconductor elements 30, and the passive component 103 provided for each semiconductor element 30 may be mounted on the common interposing substrate 104. The interposing substrate 104 may be provided for each of the above groups. The common passive component 103 is mounted on the interposing substrate 104 within the group. The common interposing substrate 104 may be provided for all the semiconductor elements 30 connected in parallel. In this case, the passive components 103 provided for each semiconductor element 30 may be mounted on a common interposing substrate 104. The passive components 103 provided for each group may be mounted on a common interposing substrate 104.

Although FIG. 78 illustrates an example in which the interposing substrate 104 is disposed on the metal plate 100, the present disclosure is not limited to this. The interposing substrate 104 may be disposed on the clip 50. In a configuration without the clip 50, the interposing substrate 104 may be disposed on the metal plate 100.

### <Summary of Seventh Embodiment>

The semiconductor device 21 may include the substrate 40 having the conductor 42 (wiring), and the plurality of semiconductor elements 30 of which drain electrodes 31 (first main electrodes) are joined to a common wiring and connected in parallel with one another. The source electrodes 32 (second main electrodes) of the plurality of semiconductor elements 30 connected in parallel may be short-circuited by the metal member.

Since the source electrodes 32 are short-circuited by the metal member, the parasitic inductance Ls between the source electrodes 32 is small. Therefore, it is possible to suppress the occurrence of oscillation between the semiconductor elements 30, that is, in the parallel circuit.

The metal member may be the metal plate 100 or the bonding wire 80. By using the metal plate 100, the parasitic inductance Ls between the source electrodes 32 can be further reduced. By using the bonding wire 80, the source electrodes 32 can be short-circuited together in the wire bonding process for electrically connecting the pad 33 and the signal terminal 62. Therefore, the process can be simplified and the parasitic inductance Ls between the source electrodes 32 can be reduced.

The semiconductor device 21 may include the substrate 40 having the conductor 42 (wiring), and the plurality of semiconductor elements 30 of which drain electrodes 31 (first main electrodes) are joined to a common wiring and connected in parallel with one another. In addition to the substrate 40 and the semiconductor element 30, the passive component 103 including a ferrite bead or a balance resistor may be provided at the gate wiring electrically connected to the gate pad 33G. The plurality of semiconductor elements 30 may be grouped together in such a way that the number of semiconductor elements 30 is smaller than the number of semiconductor elements 30 connected in parallel, with the passive components 103 being provided for each group.

Since the gate wiring is provided with a ferrite bead or a balance resistor as the passive component 103, the impedance of the gate wiring can be increased. Therefore, it is possible to suppress the occurrence of oscillation between the semiconductor elements 30, that is, in the parallel circuit. In the plurality of semiconductor elements 30 connected in parallel, the greater the distance between the semiconductor elements 30, the greater the parasitic inductance between the source electrodes 32, making oscillation more likely to occur. That is, oscillation is unlikely to occur between the semiconductor elements 30 that are disposed close to each other. By grouping the semiconductor elements 30 disposed in close proximity to each other such that oscillation is unlikely to occur and providing passive components 103 for each group, it is possible to suppress occurrence of oscillation between groups. Since the passive component 103 is provided for each group, it is possible to reduce the number of passive components 103 and suppress the occurrence of oscillation in the parallel circuit.

The semiconductor device 21 may include the gate terminal 62G as the signal terminal 62. The passive component 103 may be mounted on the substrate 40 to the gate wirings 425G and 426G that electrically connect the gate pad 33G and the gate terminal 62G. This allows the impedance of the gate wiring to be adjusted within the semiconductor device 21. Since the passive components 103 can be mounted using the manufacturing process of the semiconductor device 21, the manufacturing process can be simplified.

As the substrate 40, an insulating substrate may be adopted. The semiconductor device 21 may include the substrate 40 (insulating substrate) having the conductor 42 (wiring), and the plurality of semiconductor elements 30 of which drain electrodes 31 (first main electrodes) are joined to a common wiring and connected in parallel to each other. In addition to the substrate 40 and the semiconductor element 30, the gate terminal 62G and the interposing substrate 104 (printed circuit board) on which the passive component 103 is mounted may be provided. The passive components 103 include ferrite beads or balance resistors, and adjust the impedance of the gate wiring provided at the interposing substrate 104.

Since the ferrite beads or balance resistors that are the passive components 103 are provided at the gate wiring provided at the interposing substrate 104, the impedance of the gate wiring can be increased. Therefore, it is possible to suppress the occurrence of oscillation between the semiconductor elements 30, that is, in the parallel circuit. The printed circuit board allows for finer wiring than insulating substrates such as an AMB substrate. The AMB is an abbreviation for active metal brazing. Since the gate wiring is provided at the interposing substrate 104 on which micromachining can be performed, rather than at the substrate 40, the size of the semiconductor device 21 can be reduced in the configuration that includes the passive components 103.

The interposing substrate 104 may be mounted on the substrate 40, or may be disposed on a metal member joined to the source electrode 32 (second main electrode). When the semiconductor device 21 is disposed on the substrate 40, micromachining can be performed on the wiring as described above, and therefore the size of the semiconductor device 21 can be reduced. When the semiconductor device 21 is disposed on a metal member, it is not necessary to provide a space for the interposing substrate 104 on the substrate 40, and therefore the size of the semiconductor device 21 can be further reduced. The metal member may be the metal plate 100 that short-circuits the source electrode 32, as illustrated in FIG. 78.

The configuration described in the present embodiment can be combined with the configuration(s) described in the preceding embodiment(s).

### (Eighth Embodiment)

This embodiment is a modification example of a basic aspect of the preceding embodiment(s), and the description of the preceding embodiment(s) can be incorporated. In particular, the present embodiment is a modification example of the shape of the clip 50 illustrated in FIG. 33.

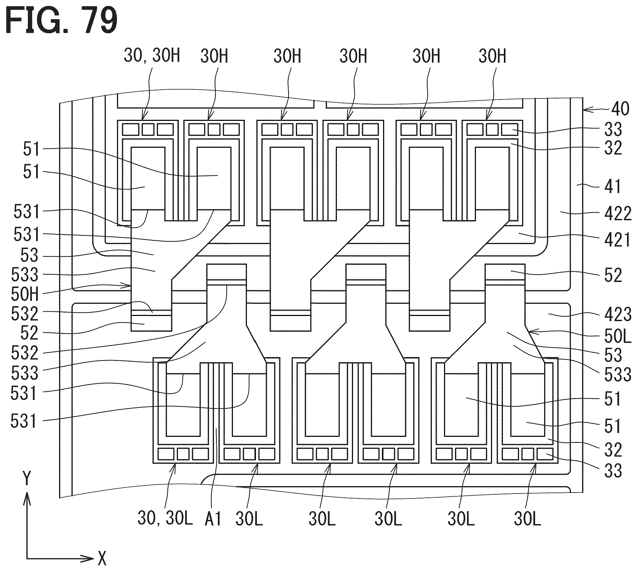

In the present embodiment illustrated in FIG. 79, the clip 50H has a substantially Y shape as a planar shape, in the same manner as in FIG. 33. The clip 50L also has a substantially Y shape as a planar shape. The clip 50H electrically connects the source electrode 32 of the semiconductor element 30H and the O wiring 423. The clip 50L electrically connects the source electrode 32 of the semiconductor element 30L and the O wiring 423.

These clips 50 have the joint portion 51, the joint portion 52, and the coupling portion 53. The joint portion 51 corresponds to a first joint portion, and the joint portion 52 corresponds to a second joint portion. In the present embodiment, one clip 50 includes the plurality of joint portions 51, and one joint portion 52 and one coupling portion 53.

The joint portion 51 of the clip 50H is joined to the source electrode 32 of the semiconductor element 30H with the solder 81. The joint portion 52 of the clip 50H is joined to the O wiring 423 with the solder 81. The joint portion 52 of the clip 50L is joined to the N wiring 422 with the solder 81. The joint portion 51 of the clip 50L is joined to the source electrode 32 with the solder 81.

The coupling portion 53 is continuous with the joint portions 51 and 52. The coupling portion 53 connects the joint portions 51 and 52 to form a continuous integral piece. The coupling portion 53 of the clip 50H connects the plurality of joint portions 51 connected to different semiconductor elements 30H to one joint portion 52. The coupling portion 53 of the clip 50L connects the plurality of joint portions 51 connected to different semiconductor elements 30L to one joint portion 52.

The coupling portion 53 has a substantially Y shape as a planar shape. The coupling portion 53 has the inclined portions 531 and 532 and the intermediate portion 533, in the same manner as the previously described FIGS. 20 and 21. The inclined portion 531 rises obliquely upward from the joint portion 51. The inclined portion 531 has an inclination such that the distance from the joint portion 51 in the Z direction increases with the distance from the joint portion 51 in the Y direction. The inclined portion 532 rises obliquely upward from the joint portion 52. The inclined portion 532 has an inclination such that the distance from the joint portion 52 in the Z increases with the distance from the joint portion 52 in the Y direction. The inclined portions 531 and 532 are inclined with respect to the Y direction, which is a direction in which the joint portions 51 and 52 are aligned. The intermediate portion 533 connects the inclined portions 531 and 532.

The intermediate portion 533 has a substantially Y shape as a planar shape, branching from one joint portion 52 to the plurality of joint portions 51. The inclined portions 531 and 532 are inclined as described above and extend in the Y direction. The coupling portion 53 has a shape in which one joint portion 52 branches into the plurality of joint portions 51. Further, the coupling portion 53 has a branch shape that avoids regions between the plurality of semiconductor elements 30H.

The two semiconductor elements 30H connected by the clip 50H are disposed side by side in the X direction. The region between the two semiconductor elements 30H in the X direction is referred to as an inter-element region A1. The coupling portion 53 branches into a Y shape to avoid the inter-element region A1. The inclined portion 531, which is a portion of the coupling portion 53 that connects to the joint portion 51, has a shape that extends in the Y direction, in a plan view from the Z direction. The inclined portion 532, which is a portion of the coupling portion 53 that connects to the joint portion 52, has a shape that extends in the same direction (Y direction) as the inclined portion 531 in a plan view from the Z direction.

A direction of a current flowing through the inclined portion 531 between the joint portion 51 and the intermediate portion 533 is the Y direction. A direction of a current flowing through the inclined portion 532 between the joint portion 52 and the intermediate portion 533 is the same as the direction of the current flowing through the inclined portion 531 (Y direction). That is, a shape of the intermediate portion 533 is set such that the current direction at the joint portion 51 and the current direction at the joint portion 52 are the same.

The joint portions 51 and 52 are provided to avoid the gate wiring 36 (signal line). In the example illustrated in FIG. 18 described above, the gate wiring 36 is disposed substantially at a center of the element region 341 in the X direction. In contrast to this, in the present embodiment, the gate wiring 36 is disposed near an outer edge of the element region 341. In FIG. 79, the gate wiring 36 is omitted.

For example, the gate wiring 36 is disposed near the outer edge of the element region 341 in the X direction and extends in the Y direction. In this case, the joint portions 51 and 52 are adjacent to the gate wiring 36 in the X direction and extend in the Y direction, thereby avoiding the gate wiring 36. The gate wiring 36 may be disposed near the outer edge of the element region 341 in the Y direction and extend in the X direction.

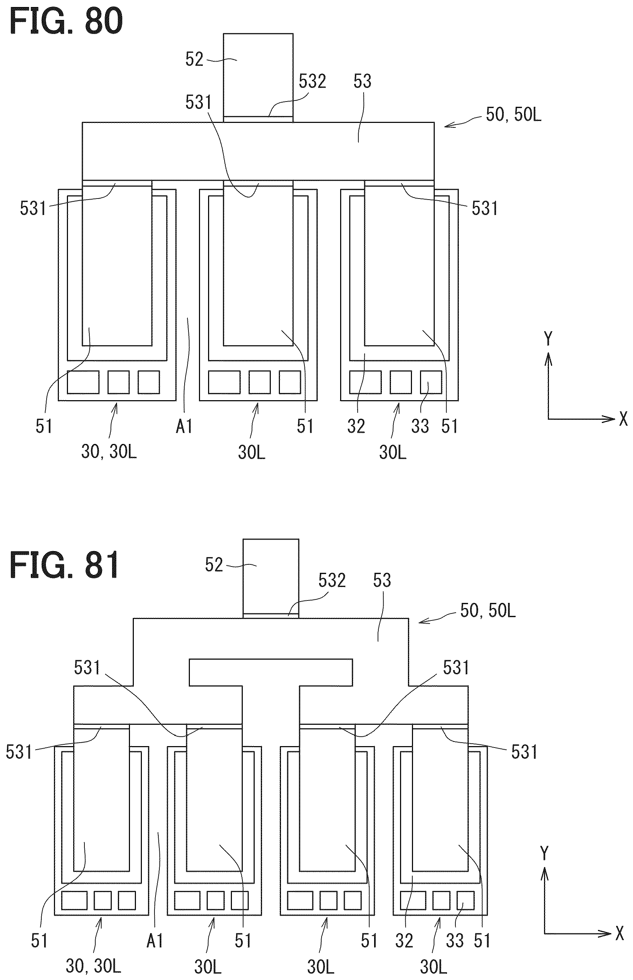

In the example illustrated in FIG. 79, the coupling portion 53 connects two joint portions 51 and one joint portion 52. That is, the clip 50 connects the two semiconductor elements together to the wiring. On the other hand, as illustrated in FIG. 80, the coupling portion 53 may have a shape that connects three or more joint portions 51 to one joint portion 52. That is, the clip 50 may have a shape that connects three or more semiconductor elements together to a wiring.

In the example illustrated in FIG. 80, a plurality of semiconductor elements as connection targets of the clip 50 are aligned in a line in a predetermined direction (X direction). In the same manner as the example illustrated in FIG. 79, the three inclined portions 531 have a shape that extends in the same direction (Y direction) as the inclined portion 532 in a plan view.

The coupling portion 53 illustrated in FIGS. 79 and 80 connects all of the joint portions 51 as the coupling targets together at one portion extending in the X direction. On the other hand, the coupling portion 53 may have a shape illustrated in FIG. 81. The coupling portion 53 illustrated in FIG. 81 connects all of the joint portions 51 as the coupling targets in a plurality of stages. Specifically, the coupling portion 53 has a plurality of portions extending in the X direction that connect the plurality of joint portions 51. These plurality of portions are further coupled by another portion extending in the X direction.

In the example illustrated in FIG. 81, a plurality of semiconductor elements as the connection targets of the clip 50 are aligned in a line in a predetermined direction (X direction). In the same manner as the example illustrated in FIG. 80, the four inclined portions 531 have a shape that extends in the same direction (Y direction) as the inclined portion 532 in a plan view.

### <Summary of Eighth Embodiment>

The clip 50 has the plurality of joint portions 51 (first joint portions) and the joint portion 52 (second joint portion) that is different from the first joint portion. One of the plurality of first joint portions is joined to one of the plurality of semiconductor elements 30. Another of the plurality of first joint portions is joined to another of the plurality of semiconductor elements 30.

This allows the number of second joint portions to be reduced as compared to when one clip 50 is connected to one semiconductor element 30, as illustrated in FIG. 38, for example. Therefore, the area on the semiconductor substrate 34 that is occupied by the second joint portion can be reduced, and the space on the semiconductor substrate 34 can be used effectively.

Further, in the present embodiment, the clip 50 has the coupling portion 53 that connects the plurality of first joint portions and the second joint portion. The coupling portion 53 has a shape in which one second joint portion branches into the plurality of first joint portions. Further, the coupling portion 53 has a branch shape that avoids the inter-element region A1 between the plurality of semiconductor elements 30 in a plan view.

This eliminates the need for a portion of the clip 50 to be located between the two semiconductor elements 30 connected by the clip 50. Therefore, the space occupied by the clip 50 on the semiconductor substrate 34 in the direction in which the two semiconductor elements 30 are arranged, that is, in the example illustrated in FIG. 79, can be reduced in the X direction.

In the present embodiment, the joint portions 51 and 52 are also provided to avoid the gate wiring 36 (signal line). Therefore, it is possible to suppress the solder 81 from flowing into a scratch on the upper element portion 354 that occur during the manufacturing process. Therefore, it is possible to suppress the occurrence of leakage current in the signal line.

The configuration described in the present embodiment can be combined with the configuration(s) described in the preceding embodiment(s).

### (Ninth Embodiment)

This embodiment is a modification example of a basic aspect of the preceding embodiment(s), and the description of the preceding embodiment(s) can be incorporated. In particular, the present embodiment is a modification example of the shape of the clip 50 illustrated in FIG. 35.

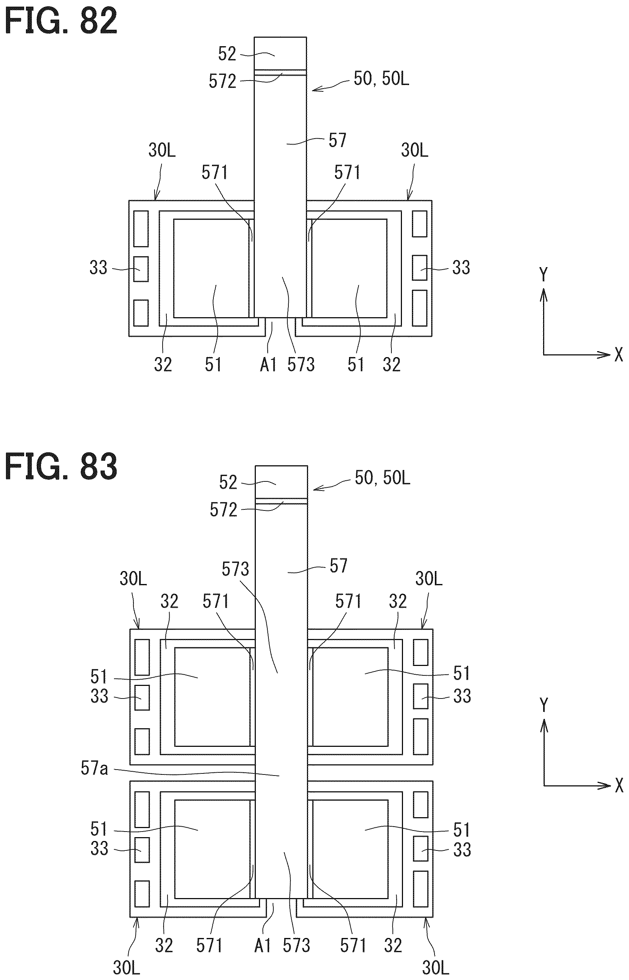

In the present embodiment illustrated in FIG. 82, the clip 50 has a substantially T shape as a planar shape, in the same manner as in FIG. 35. The clip 50 has the joint portion 51, the joint portion 52, the coupling portion 57, and the extension portion 58. The joint portion 51 corresponds to the first joint portion, and the joint portion 52 corresponds to the second joint portion. In the present embodiment, one clip 50 includes the plurality of joint portions 51, and one joint portion 52, one coupling portion 53, and one extension portion 58.

The coupling portion 57 is connected to electrodes of the two semiconductor elements 30, electrically connecting the electrodes together. The coupling portion 57 is continuous with the joint portions 51 and 52 and connects the joint portions 51 and 52 to form a continuous integral piece. The coupling portion 57 connects the plurality of joint portions 51 connected to different semiconductor elements 30 to one joint portion 52.

The extension portion 58 is continuous with the coupling portion 57 and electrically connects the electrodes of the semiconductor element 30 to the wiring of the substrate 40. In FIG. 82, the coupling portion 57 extends in the X direction in a plan view and is disposed to overlap with the source electrode 32. The extension portion 58 extends in the Y direction.

The coupling portion 57 has a substantially T shape as a planar shape. The coupling portion 57 has inclined portions 571 and 572 and an intermediate portion 573. The inclined portion 571 rises obliquely upward from the joint portion 51. The inclined portion 571 has an inclination such that the distance from the joint portion 51 in the Z direction increases with the distance from the joint portion 51 in the X direction. The inclined portion 572 rises obliquely upward from the joint portion 52. The inclined portion 572 has an inclination such that the distance from the joint portion 52 in the Z increases with the distance from the joint portion 52 in the Y direction. The intermediate portion 573 connects the inclined portions 571 and 572.

The intermediate portion 573 has a substantially T shape as a planar shape, branching from one joint portion 52 to the plurality of joint portions 51. The inclined portion 571 has a shape that extends in the X direction in a plan view. The inclined portion 572 has a shape that extends in the Y direction in a plan view. The two semiconductor elements 30L connected by the clip 50L are disposed side by side in the X direction. A region between the two semiconductor elements 30L in the X direction is called the inter-element region A1. The intermediate portion 573 is located in the inter-element region A1 between the plurality of semiconductor elements 30L.

The inclined portion 571, which is a portion of the coupling portion 57 that connects to the joint portion 51, has a shape that extends in the X direction, in a plan view from the Z direction. The inclined portion 572, which is a portion of the coupling portion 57 that connects to the joint portion 52, has a shape that extends in a direction (Y direction) different from that of the inclined portion 571, in a plan view from the Z direction.

A direction of a current flowing through the inclined portion 571 between the joint portion 51 and the intermediate portion 573 is the X direction. A direction of a current flowing through the inclined portion 572 between the joint portion 52 and the intermediate portion 573 is the Y direction, which is different from the direction of the current flowing through the inclined portion 571 (the X direction). That is, a shape of the intermediate portion 573 is set such that the current direction at the joint portion 51 and the current direction at the joint portion 52 are different.

In the same manner as the eighth embodiment, in the present embodiment, the joint portions 51 and 52 are provided to avoid the gate wiring 36 (signal line).

In the example in FIG. 82, two semiconductor elements 30 are connected together by one clip 50. On the other hand, as illustrated in FIG. 83, four semiconductor elements 30 may be connected together by one clip 50. In the example in FIG. 83, one clip 50 has four joint portions 51 and two intermediate portions 573. The two intermediate portions 573 are coupled by an intermediate connection portion 57a.

### <Summary of Ninth Embodiment>

In the same manner as the eighth embodiment described above, in the present embodiment, the clip 50 has a plurality of first joint portions and one second joint portion. Each of the plurality of first joint portions is joined to the different semiconductor element 30. This allows the number of second joint portions to be reduced. Therefore, the area on the semiconductor substrate 34 that is occupied by the second joint portion can be reduced, and the space on the semiconductor substrate 34 can be used effectively.

Further, in the present embodiment, the clip 50 has a coupling portion 57 that connects the plurality of first joint portions and the second joint portion. The coupling portion 57 has a shape in which one second joint portion branches into a plurality of first joint portions. Further, the coupling portion 57 has the intermediate portion 573 located in the inter-element region A1 between the plurality of semiconductor elements 30 in a plan view. The intermediate portion 573 has a shape that branches into a plurality of joint portions 51 from the inter-element region A1.

This allows the clip 50 to have a branch shape by effectively utilizing the space (the inter-element region A1) between the two semiconductor elements 30 connected by the clip 50. Therefore, the clip 50 can be made smaller in size in the direction (Y direction) perpendicular to the direction (X direction) in which the two semiconductor elements 30 are aligned.

The configuration described in the present embodiment can be combined with the configuration(s) described in the preceding embodiment(s). For example, the three clips 50L and the three clips 50H in FIG. 79 may be replaced with the clips 50 illustrated in FIG. 82. One of the three clips 50L and the three clips 50H may be replaced with the clip 50 illustrated in FIG. 82.

### (Other Embodiments)

The disclosure in the descriptions, the drawings, and the like is not limited to the illustrated embodiments. The disclosure encompasses the illustrated embodiments and modifications thereof made by those skilled in the art. For example, the disclosure is not limited to combinations of components and/or elements described in the embodiments. The disclosure may be implemented in various combinations. The disclosure may have an additional portion that can be added to the embodiments. The disclosure encompasses omission of the components and/or the elements of the embodiments. The disclosure encompasses the replacement or combination of the components and/or the elements between one embodiment and another. The disclosed technical scope is not limited to those described in the embodiments. The several technical scopes disclosed are indicated by the description of the claims, and should be construed to include all modifications within the meaning and range equivalent to the description of the claims.

The disclosure in the descriptions, the drawings, and the like is not limited by the description of the claims. The disclosure in the descriptions, the drawings, and the like encompasses the technical ideas described in the claims, and extends to technical ideas that are more diverse and extensive than the technical ideas described in the claims. Accordingly, various technical ideas can be extracted from the disclosure in the descriptions, the drawings, and the like without being restricted by the description of the claims.

When it is mentioned that a certain element or layer is "on", "coupled", "connected", or "bonded", the certain element or layer may be directly on, coupled, connected, or bonded to another element or layer, or an interposed element or an interposed layer may be present. In contrast, when it is mentioned that a certain element is "directly on", "directly coupled", "directly connected", or "directly bonded" to another element or layer, no interposed element or interposed layer is present. Other words used to describe a relationship between elements should be interpreted in the similar manner (for example, "between" and "directly between", "adjacent to" and "directly adjacent to", and the like). When used in the description, the term "and/or" includes any of and all combinations related to one or a plurality of associated listed items.

Spatially relative terms such as "inside", "outside", "rear", "below", "low", "upper", "high", and the like are used herein for ease of description to describe the relationship of one element or feature to another, as illustrated. Spatially relative terms may be intended to encompass different orientations of the device during use or operation in addition to the orientation depicted in the drawings. For example, when the device in the drawings is turned over, elements described as "below" or "directly below" other elements or features would then be oriented "above" the other elements or features. Thus, the term "below" can encompass both an orientation of above and below. The device may have another direction (rotated 90 degrees or at other orientations) and the spatially relative descriptors used herein interpreted accordingly.

The vehicle drive system 1 is not limited to the configuration described above. For example, although an example in which one motor generator 3 is provided is illustrated, the present disclosure is not limited to this. A plurality of motor generators may be provided. Although the power conversion device 4 includes the inverter 6 as the power conversion unit in the example illustrated, the present disclosure is not limited to this. For example, a configuration including a plurality of inverters may be used. The power supply may be configured with at least one inverter and a converter. It may also be possible to provide only a converter.

### (Disclosure of Technical Ideas)

This description discloses a plurality of technical ideas described in a plurality of items listed below. Some items may be written in a multiple dependent form with subsequent items referring to the preceding item as an alternative. Some items may be written in a multiple dependent form referring to another multiple dependent form. These items written in a plurality of dependent form define a plurality of technical ideas.

### <First Technical Idea>

A semiconductor device includes:
at least one semiconductor element (30) including
   a semiconductor substrate (34) having an element region (341),
   a main electrode (32) disposed at a position overlapping with the element region on one surface of the semiconductor substrate,
   a signal line (36) disposed at a position overlapping with the element region on the one surface and being different from the position of the main electrode, and
   an insulating film (354, 35) covering the signal line and interposed by the main electrode in a plan view in a thickness direction of the semiconductor substrate;
a metal plate (50, 50H, 50L) having a joint portion (51) to the main electrode; and
a solder (81) interposed between the main electrode and the joint portion and joining the main electrode and the metal plate, in which the joint portion is disposed to avoid the signal line.

### <Second Technical Idea>

In the semiconductor device as in the first technical idea, the metal plate has a plurality of the joint portions for a same semiconductor element.

### <Third Technical Idea>

In the semiconductor device as in the second technical idea, the joint portions for the same semiconductor element are branched.

### <Fourth Technical Idea>

In the semiconductor device as in the third technical idea, the metal plate has a bridge portion (56) connected to adjacent joint portions at a position farther away from the one surface than the joint portions.

### <Fifth Technical Idea>

In the semiconductor device as in any one of the first through fourth technical ideas, the metal plate has a plurality of first joint portions as the joint portion, and a second joint portion (52) which is different from the plurality of first joint portions.

### <Sixth Technical Idea>

The semiconductor device as in the fifth technical idea further includes a substrate (40) having an insulating base material (41) and a wiring (422, 423) disposed at the insulating base material. The semiconductor element is disposed on a surface of the substrate on which the wiring is disposed, and the second joint portion is connected to the wiring.

### <Seventh Technical Idea>

In the semiconductor device as in any one of the first through sixth technical ideas, the semiconductor element includes a first main electrode as the main electrode and a second main electrode (31) disposed on a rear surface of the semiconductor substrate opposite to the one surface. The semiconductor device further includes: a metal member (421, 423); and a sintered member (82) interposed between the second main electrode and the metal member and joining the second main electrode and the metal member.

### <Eighth Technical Idea>

In the semiconductor device as in the fifth or sixth technical idea, the semiconductor element has a pad (33) disposed on the one surface and electrically connected to the signal line. The semiconductor device further includes: a signal terminal (62); a bonding wire (80) electrically connecting the pad and the signal terminal; and a gel (91) that seals the semiconductor element, the metal plate, a part of the signal terminal, and the bonding wire, in which the metal plate is formed with a through hole (55) at a portion connecting the first joint portions and the second joint portion.

### <Ninth Technical Idea>

The semiconductor device as in the fifth or sixth technical idea further includes a sealing body (90) that seals the semiconductor element and the metal plate, in which the metal plate has an inclined shape at a portion connecting the first joint portions and the second joint portion, the inclined shape being inclined with respect to a direction in which the first joint portions and the second joint portion are aligned.

### <Tenth Technical Idea>

In the semiconductor device as in any one of the fifth, sixth, eighth and ninth technical ideas, the at least one semiconductor element includes a plurality of the semiconductor elements. One of the plurality of first joint portions is joined to one of the plurality of semiconductor elements, and another of the plurality of first joint portions is joined to another of the plurality of semiconductor elements.

### <Eleventh Technical Idea>

In the semiconductor device as in the tenth technical idea, the metal plate has a coupling portion (53) connecting the plurality of first joint portions and the second joint portion, and the coupling portion has a shape that branches from the second joint portion to the plurality of first joint portions and branches to avoid a region between the plurality of semiconductor elements.

### <Twelfth Technical Idea>

In the semiconductor device as in the tenth technical idea, the metal plate has a coupling portion (57) connecting the plurality of first joint portions and the second joint portion, and the coupling portion has a shape that branches from the second joint portion to the plurality of first joint portions and branches from a region between the plurality of semiconductor elements.

## Claims

1. A semiconductor device comprising:
at least one semiconductor element (30) that includes
a semiconductor substrate (34) having an element region (341),
a main electrode (32) disposed at a position overlapping with the element region on one surface of the semiconductor substrate,
a signal line (36) disposed at a position overlapping with the element region on the one surface and being different from the position of the main electrode, and
an insulating film (354, 35) covering the signal line and interposed by the main electrode in a plan view in a thickness direction of the semiconductor substrate;
a metal plate (50, 50H, 50L) having a joint portion (51) to the main electrode; and
a solder (81) interposed between the main electrode and the joint portion and joining the main electrode and the metal plate, wherein
the joint portion is disposed to avoid the signal line.

2. The semiconductor device according to claim 1, wherein
the metal plate has a plurality of the joint portions for a same semiconductor element.

3. The semiconductor device according to claim 2, wherein
the joint portions for the same semiconductor element are branched.

4. The semiconductor device according to claim 3, wherein
the metal plate has a bridge portion (56) connected to the joint portions that are adjacent to each other at a position farther away from the one surface than the joint portions.

5. The semiconductor device according to any one of claims 1 to 4, wherein
the metal plate has a plurality of first joint portions as the joint portion, and a second joint portion (52) which is different from the first joint portions.

6. The semiconductor device according to claim 5, further comprising:
a substrate (40) having an insulating base material (41) and a wiring (422, 423) disposed at the insulating base material, wherein
the semiconductor element is disposed on a surface of the substrate on which the wiring is disposed, and
the second joint portion is connected to the wiring.

7. The semiconductor device according to claim 5, wherein
the semiconductor element includes a first main electrode as the main electrode, and a second main electrode (31) disposed on a rear surface of the semiconductor substrate opposite to the one surface, and
the semiconductor device further comprising:
a metal member (421, 423); and
a sintered member (82) interposed between the second main electrode and the metal member and joining the second main electrode and the metal member.

8. The semiconductor device according to claim 5, wherein
the semiconductor element has a pad (33) disposed on the one surface and electrically connected to the signal line,
the semiconductor device further comprising:
a signal terminal (62);
a bonding wire (80) electrically connecting the pad and the signal terminal; and
a gel (91) that seals the semiconductor element, the metal plate, a part of the signal terminal, and the bonding wire, wherein
the metal plate is formed with a through hole (55) at a portion connecting the plurality of first joint portions and the second joint portion.

9. The semiconductor device according to claim 5, further comprising:
a sealing body (90) that seals the semiconductor element and the metal plate, wherein
the metal plate has an inclined shape at a portion connecting the plurality of first joint portions and the second joint portion, the inclined shape being inclined with respect to a direction in which the plurality of first joint portions and the second joint portion are aligned.

10. The semiconductor device according to claim 5, wherein
the semiconductor element includes a plurality of the semiconductor elements,
one of the plurality of first joint portions is joined to one of the plurality of semiconductor elements, and
another of the plurality of first joint portions is joined to another of the plurality of semiconductor elements.

11. The semiconductor device according to claim 10, wherein
the metal plate has a coupling portion (53) connecting the plurality of first joint portions and the second joint portion, and
the coupling portion has a shape that branches from the second joint portion to the plurality of first joint portions and branches to avoid a region between the plurality of semiconductor elements.

12. The semiconductor device according to claim 10, wherein
the metal plate has a coupling portion (57) connecting the plurality of first joint portions and the second joint portion, and
the coupling portion has a shape that branches from the second joint portion to the plurality of first joint portions and branches from a region between the plurality of semiconductor elements.
